# EUROPEAN PATENT APPLICATION

(11) **EP 4 535 970 A1**
(43) Date of publication of application: **09.04.2025**
(21) Application number: 24204174.7
(22) Date of filing: 02.10.2024
(51) Int. Cl.: H10K 59/126, H10K 59/131, H10K 59/65

(54) **DISPLAY DEVICE**

(30) Priority: 05.10.2023 KR 20230132271
(71) Applicant: Samsung Display Co., Ltd., Gyeonggi-do 17113 (KR)
(72) Inventor: SONG, Heerim, 17113 Yongin-si (KR); YOON, Soil, 17113 Yongin-si (KR); LEE, Cheol-Gon, 17113 Yongin-si (KR)
(74) Representative: Walaski, Jan Filip

(57) **Abstract**

A display device includes a base layer, a circuit layer, and an element layer. The circuit layer includes pixel driving circuits connected to light emitting elements, sensor driving circuits connected to light receiving elements, and read-out wirings connected to the sensor driving circuits. A first pixel driving circuit from among the pixel driving circuits is continuously arranged in a direction parallel to the read-out wirings, and the first pixel driving circuit is connected to a first light emitting element from among the light emitting elements. The circuit layer further includes a first pixel connection electrode connecting the first pixel driving circuit to the first light emitting element, and the first pixel connection electrode does not cross the read-out wirings in a plan view.

## Description

### BACKGROUND

### 1. Field

The disclosure relates to a display device having a biometric information recognition function.

### 2. Description of the Related Art

A display device provides various functions capable of organically communicating with a user, such as providing information to a user by displaying an image or sensing a user's input. Recent display devices also include a function for sensing biometric information of a user.

Biometric information recognition methods include a capacitive method of sensing a change in capacitance formed between electrodes, an optical method of sensing incident light using an optical sensor, and an ultrasonic method of sensing vibration using a piezoelectric material.

The above information disclosed in this Background section is only for enhancement of understanding of the background and therefore the information discussed in this Background section does not necessarily constitute prior art.

### SUMMARY

Embodiments provide a display device having improved biometric information recognition performance.

In one or more embodiments, a display device includes a base layer, a circuit layer on the base layer, and an element layer on the circuit layer and including light emitting elements and light receiving elements.

The circuit layer includes pixel driving circuits connected to the light emitting elements, sensor driving circuits connected to the light receiving elements, and read-out wirings connected to the sensor driving circuits.

From among the pixel driving circuits, a first pixel driving circuit is continuously arranged in a direction parallel to the read-out wirings, and the first pixel driving circuit is connected to a first light emitting element from among the light emitting elements. The circuit layer further includes a first pixel connection electrode connecting the first pixel driving circuit to the first light emitting element, and the first pixel connection electrode does not cross the read-out wirings in a plan view.

In one or more embodiments of the present disclosure, a display device includes a base layer, a circuit layer on the base layer, and an element layer on the circuit layer and including light emitting elements and light receiving elements.

The circuit layer includes pixel driving circuits connected to the light emitting elements, sensor driving circuits connected to the light receiving elements, read-out wirings connected to the sensor driving circuits, and a shielding electrode overlapping the read-out wirings and the sensor driving circuits in a plan view.

A first pixel driving circuit from among the pixel driving circuits is continuously arranged in a direction parallel to the read-out lines, and the first pixel driving circuit is connected to a first light emitting element from among the light emitting elements. The circuit layer further includes a first pixel connection electrode connecting the first pixel driving circuit to the first light emitting element, and the first pixel connection electrode is at a layer different from a layer on which the shielding electrode is located.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:
FIG. 1 is a perspective view of a display device;
FIG. 2A is an exploded perspective view of a display device;
FIG. 2B is a cross-sectional view of a display device;
FIG. 3 is a block diagram of a display device;
FIG. 4A is a circuit diagram illustrating a pixel and a sensor;
FIG. 4B is a waveform diagram illustrating operations of the pixel and the sensor shown in FIG. 4A;
FIG. 5A is a schematic plan view illustrating an arrangement of pixel driving circuits and sensor driving circuits;
FIG. 5B is a plan view illustrating an arrangement of light emitting elements and light receiving elements;
FIG. 5C is a plan view illustrating a connection relationship between light emitting elements and pixel driving circuits and a connection relationship between light receiving elements and sensor driving circuits;
FIGS. 6A and 6B are plan views illustrating a connection relationship between light emitting elements and pixel driving circuits and a connection relationship between light receiving elements and sensor driving circuits;
FIG. 7A is a cross-sectional view illustrating a connection structure of a red light emitting element and a red pixel driving circuit shown in FIG. 5C;
FIG. 7B is a cross-sectional view illustrating a connection structure of a second light receiving element and a second sensor driving circuit shown in FIG. 5C;
FIG. 8 is a plan view of a display panel;
FIGS. 9A, 9B, 9C, 9D, 9E, 9F, 9G, 9H, 9I, 9J, and 9K are plan views illustrating a process of stacking a circuit layer and an element layer;
FIG. 9L is a cross-sectional view taken along the line I - I ' illustrated in FIG. 9 K;
FIGS. 10A and 10B are plan views illustrating a process of stacking a circuit layer and an element layer;
FIGS. 11A and 11B are plan views illustrating a process of stacking a circuit layer and an element layer;
FIGS. 12A, 12B, and 12C are plan views illustrating a process of stacking a circuit layer and an element layer;
FIG. 12D is a cross-sectional view taken along the line II - II' illustrated in FIG. 12C;
FIG. 13A is a plan view illustrating a portion of a display panel;
FIG. 13B is an enlarged plan view illustrating a portion of FIG. 13A;
FIG. 13C is a cross-sectional view taken along the line III-III' illustrated in FIG. 13B; and
FIGS. 14A and 14B are cross-sectional views illustrating a light emitting element and a light receiving element of a display panel.

### DETAILED DESCRIPTION

In this specification, when a component (or an area, a layer, a part, etc.) is referred to as being "on", "connected to", or "coupled to" another component, it means that it may be directly disposed on, connected to or coupled to the other component or a third component may be disposed therebetween.

Identical reference numerals refer to identical elements. In addition, in the drawings, the thicknesses, ratios, and dimensions of the components are exaggerated for effective description of the technical content. The term "and/or" includes all one or more combinations that the associated components may define.

It will be understood that, although the terms first, second, etc. may be used herein to describe various components, these components should not be limited by these terms. The terms are used only for the purpose of distinguishing one component from another component. For example, a first component could be termed a second component, and, similarly, the second component could be termed the first component, without departing from the scope of the present disclosure. Singular expressions include plural expressions unless the context clearly indicates otherwise.

In addition, terms such as "below", "under", "above", "over", and the like are used to describe the relationship between the components illustrated in the drawings. The terms are relative concepts and are described based on the direction illustrated in the drawings.

It should be understood that terms such as "include" and "have" are intended to designate the presence of features, numbers, steps, operations, components, parts, or combinations thereof described in the specification, and do not preclude the possibility of the presence or addition of one or more other features, numbers, steps, operations, components, parts, or combinations thereof in advance.

Unless otherwise defined, all terms (including technical terms and scientific terms) used herein have the same meaning as generally understood by those skilled in the art to which the present disclosure pertains. In addition, terms, such as those defined in commonly used dictionaries, should be interpreted as having a meaning that is consistent with their meaning in the context of the relevant art, and should not be interpreted in an overly ideal or excessively formal meaning unless clearly defined herein.

Hereinafter, embodiments of the present disclosure will be described with reference to the drawings.

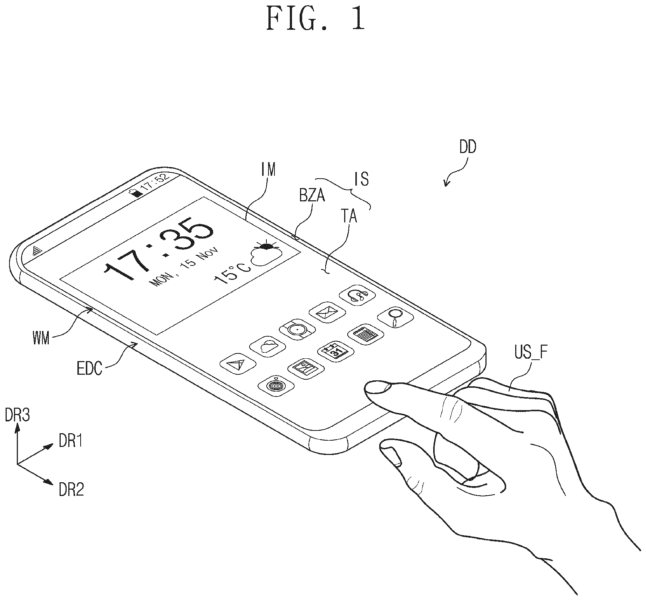

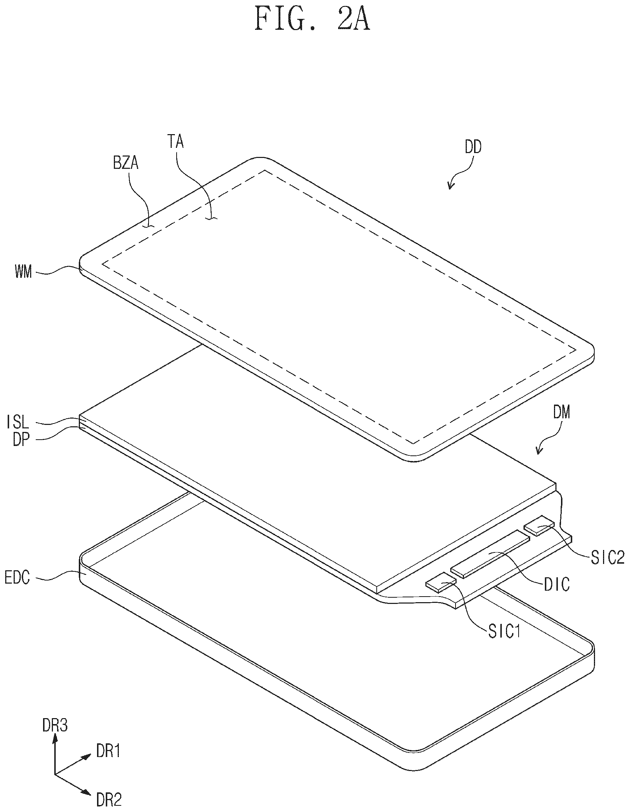

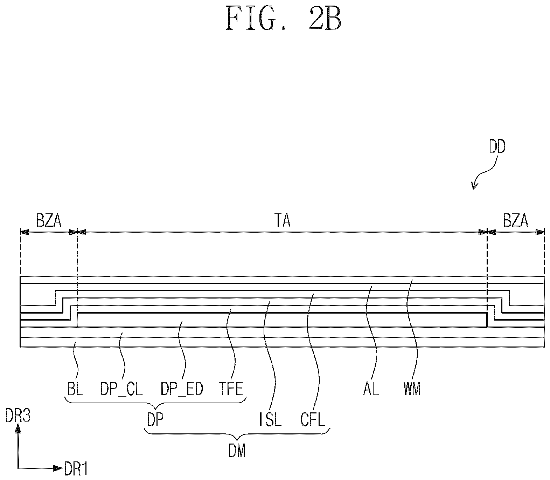

FIG. 1 is a perspective view of a display device, FIG. 2A is an exploded perspective view of a display device, and FIG. 2B is a cross-sectional view of a display device.

Referring to FIGS. 1, 2A, and 2B, a display device DD may have a rectangular shape with short sides parallel to a first direction DR1 and long sides parallel to a second direction DR2 crossing the first direction DR1. However, it is not limited thereto, and the display device DD may have various shapes such as a circular shape or a polygonal shape.

The display device DD may be a device activated according to an electrical signal. The display device DD may include various embodiments. For example, the display device DD may be applied to electronic devices such as a smart watch, a tablet, a notebook, a computer, a smart television, and/or the like.

Hereinafter, a normal direction substantially perpendicular to the plane defined by the first direction DR1 and the second direction DR2 is defined as a third direction DR3. In this specification, the meaning of "in a plan view" may mean a state viewed from the third direction DR3 (e.g., in the third direction DR3). In other words, "a plan view" may refer to a view from the above, and/or may refer to an imaginary view in which all elements are visible or shown as though they are located on the same plane.

An upper surface of the display device DD may be defined (or may be referred to) as a display surface IS and may be parallel to a plane defined by the first direction DR1 and the second direction DR2. An image (or images) IM generated by the display device DD may be provided to a user through the display surface IS.

The display surface IS may be divided into a transmission area TA and a bezel area BZA. The transmission area TA may be an area in which the images IM are displayed. The user views the images IM through the transmission area TA. The transmission area TA is illustrated in a rectangular shape with rounded vertices. However, this is illustrated as an example, and the transmission area TA may have various shapes and is not limited.

The bezel area BZA is adjacent to the transmission area TA. The bezel area BZA may have a suitable color (e.g., a predetermined color). The bezel area BZA may be around (e.g., may surround) the transmission area TA. Accordingly, the shape of the transmission area TA may be substantially defined by the bezel area BZA. However, this is merely illustrative, and the bezel area BZA may be disposed adjacent to only one side of the transmission area TA, or may be omitted.

The display device DD may sense an external input applied from the outside. The external input may include various types of inputs provided from the outside of the display device DD. For example, the external input may include an external input (e.g., hovering) applied close to the display device DD or adjacent to the display device DD (e.g., spaced from the display device DD by a suitable distance (e.g., a predetermined distance)), as well as a contact by a part of the body of the user, such as a hand US_F of the user or a contact by a separate device (e.g., an active pen or a digitizer). In addition, the external input may have various forms such as force, pressure, temperature, light, and/or the like.

The display device DD may sense biometric information (e.g., a fingerprint) of the user applied from the outside. A biometric information sensing area capable of sensing biometric information of the user may be provided on the display surface IS of the display device DD. The biometric information sensing area may be provided in the entire area of the transmission area TA, or may be provided in a partial area of the transmission area TA. FIG. 1 illustrates that the entire transmission area TA is used as a biometric information sensing area, as an example. However, it is not limited thereto.

The display device DD may include a window WM, a display module DM, and a housing EDC. The window WM and the housing EDC are coupled to each other to define an outer appearance of the display device DD.

A front surface of the window WM defines the display surface IS of the display device DD. The window WM may include an optically transparent insulating material. For example, the window WM may include glass or plastic. The window WM may have a multilayer structure or a single-layer structure. For example, the window WM may include a plurality of plastic films bonded with an adhesive or may include a glass substrate and a plastic film bonded with an adhesive.

The display module DM may include a display panel DP and an input sensing layer ISL. The display panel DP may display an image IM according to an electrical signal, and the input sensing layer ISL may sense an external input applied from the outside. The external input may be provided in various forms.

The display panel DP may be a light emitting display panel, but is not particularly limited thereto. For example, the display panel DP may be an organic light emitting display panel, an inorganic light emitting display panel, or a quantum dot light emitting display panel. The light emitting layer of the organic light emitting display panel may include an organic light emitting material, and the light emitting layer of the inorganic light emitting display panel may include an inorganic light emitting material. The light emitting layer of the quantum dot light emitting display panel may include a quantum dot, a quantum rod, and/or the like. Hereinafter, the display panel DP will be described as an organic light emitting display panel. However, it is not limited thereto.

Referring to FIG. 2B, the display panel DP includes a base layer BL, a circuit layer DP_CL, an element layer DP_ED, and an encapsulation layer TFE. The display panel DP may be a flexible display panel. However, it is not limited thereto. For example, the display panel DP may be a foldable display panel that is folded with respect to a folding axis or a rigid display panel.

The base layer BL may include a synthetic resin layer. The synthetic resin layer may be a polyimide-based resin layer, and the material thereof is not particularly limited. In addition, the base layer BL may include a glass substrate, a metal substrate, an organic/inorganic composite material substrate, or any other suitable substrate known to a person of ordinary skill in the art.

The circuit layer DP_CL is disposed on the base layer BL. The circuit layer DP_CL is disposed between the base layer BL and the element layer DP_ED. The circuit layer DP_CL includes at least one insulating layer and a circuit element. Hereinafter, the insulating layer included in the circuit layer DP_CL is referred to as an intermediate insulating layer. The intermediate insulating layer includes at least one intermediate inorganic layer and at least one intermediate organic layer. The circuit element may include a pixel driving circuit included in each of a plurality of pixels for displaying an image, a sensor driving circuit included in each of a plurality of sensors for recognizing external information, and/or the like. The external information may be biometric information. As an example, the sensor may be a fingerprint recognition sensor, a proximity sensor, an iris recognition sensor, a blood pressure measurement sensor, an illuminance sensor, and/or the like. In addition, the sensor may be an optical sensor that optically recognizes biometric information. The circuit layer DP_CL may further include signal lines connected to the pixel driving circuit and/or the sensor driving circuit.

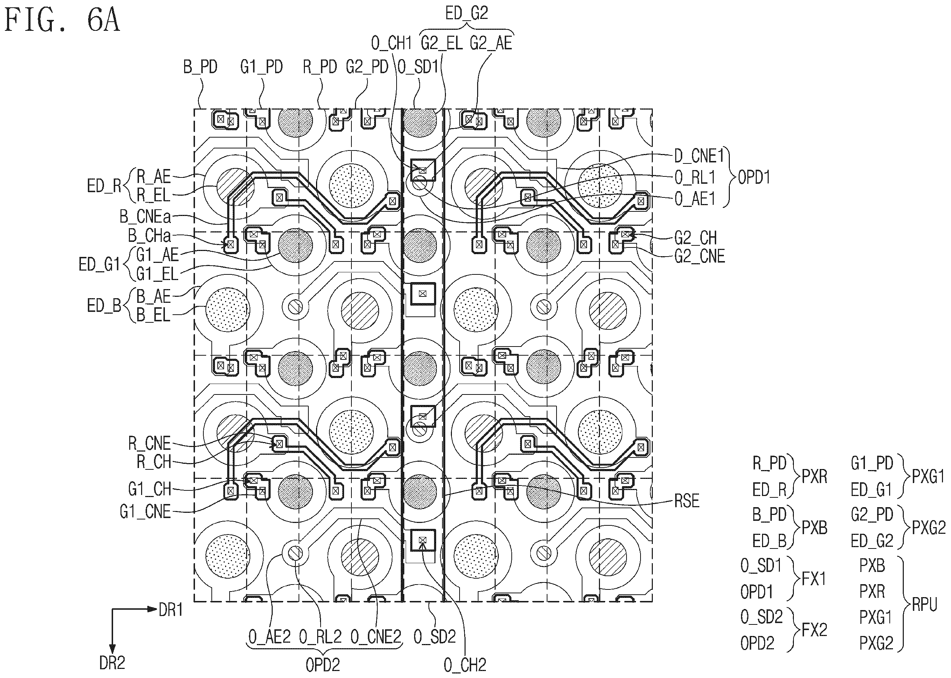

The element layer DP_ED may include a light emitting element included in each of the pixels and a light receiving element included in each of the sensors. As an example, the light receiving element may be a photodiode. The light receiving element may be a sensor that senses light reflected by a user's fingerprint or reacts to the light. The circuit layer DP_CL and the element layer DP_ED will be described in detail with reference to FIGS. 6A to 8K.

The encapsulation layer TFE encapsulates the element layer DP_ED. The encapsulation layer TFE may include at least one organic film and at least one inorganic film. The inorganic film may include an inorganic material and may protect the element layer DP_ED from moisture/oxygen. The inorganic film may include a silicon nitride layer, a silicon oxy nitride layer, a silicon oxide layer, a titanium oxide layer, and/or an aluminum oxide layer, but is not particularly limited thereto. The organic film may include an organic material and may protect the element layer DP_ED from foreign substances such as dust particles.

The input sensing layer ISL may be formed on the display panel DP. The input sensing layer ISL may be directly disposed on the encapsulation layer TFE., the input sensing layer ISL may be formed on the display panel DP by a continuous process. That is, when the input sensing layer ISL is directly disposed on the display panel DP, an adhesive film is not disposed between the input sensing layer ISL and the encapsulation layer TFE. Alternatively, the adhesive film may be disposed between the input sensing layer ISL and the display panel DP. In this case, the input sensing layer ISL may not be manufactured by a continuous process with the display panel DP, and may be manufactured through a separate process from the display panel DP and then be fixed to the upper surface of the display panel DP by the adhesive film.

The input sensing layer ISL may sense an external input (e.g., a user's touch), may change the external input into an input signal (e.g., a predetermined input signal), and may provide the input signal to the display panel DP. The input sensing layer ISL may include a plurality of sensing electrodes for sensing the external input. The sensing electrodes may sense the external input in a capacitive manner, for example. The display panel DP may receive the input signal from the input sensing layer ISL and may generate an image corresponding to the input signal.

The display module DM may further include a color filter layer CFL. As an example, the color filter layer CFL may be disposed on the input sensing layer ISL. However, it is not limited thereto. The color filter layer CFL may be disposed between the display panel DP and the input sensing layer ISL. The color filter layer CFL may include a plurality of color filters and a black matrix.

Details of the structure of the input sensing layer ISL and the color filter layer CFL will be described later.

The display device DD may further include an adhesive layer AL. The window WM may be attached to the color filter layer CFL by the adhesive layer AL. The adhesive layer AL may include an optical clear adhesive, an optically clear adhesive resin, and/or a pressure sensitive adhesive (PSA).

The display module DM may further include a driving chip DIC and sensor chips SIC1 and SIC2 as shown in FIG. 2A, for example. As an example, the driving chip DIC and the sensor chips SIC1 and SIC2 may be mounted on the display panel DP. The driving chip DIC and the sensor chips SIC1 and SIC2 may be disposed adjacent to an end portion (hereinafter, referred to as a first end portion) of the display panel DP. Although FIG. 2A shows a structure in which the driving chip DIC and the sensor chips SIC1 and SIC2 are disposed adjacent to the first end portion of the display panel DP, the structure is not limited thereto. For example, the driving chip DIC may be disposed adjacent to a first end portion of the display panel DP, and the sensor chips SIC1 and SIC2 may be disposed adjacent to a second end portion opposite to the first end portion of the display panel DP.

As an example, the sensor chips SIC1 and SIC2 may include a first sensor chip SIC1 disposed on one side (hereinafter, referred to as a first side) of the driving chip DIC and a second sensor chip SIC2 disposed on a second side different from the first side of the driving chip DIC. Both the sensor chips SIC1 and SIC2 may be disposed on the same side of the driving chip DIC. Alternatively, the first and second sensor chips SIC1 and SIC2 may be integrated into one sensor chip, and the one sensor chip may be disposed adjacent to the driving chip DIC. The number of sensor chips SIC1 and SIC2 and the number of driving chips DIC are not particularly limited.

The housing EDC is coupled to the window WM. The housing EDC is coupled to the window WM to provide an inner space (e.g., a predetermined inner space). The display module DM may be accommodated in the inner space. The housing EDC may include a material having relatively high rigidity. For example, the housing EDC may include glass, plastic, or metal, or may include a plurality of frames and/or plates composed of combinations thereof. The housing EDC may stably protect the components of the display device DD accommodated in the inner space from external impact. A battery module and/or the like may be disposed between the display module DM and the housing EDC to supply power necessary for the overall operation of the display device DD.

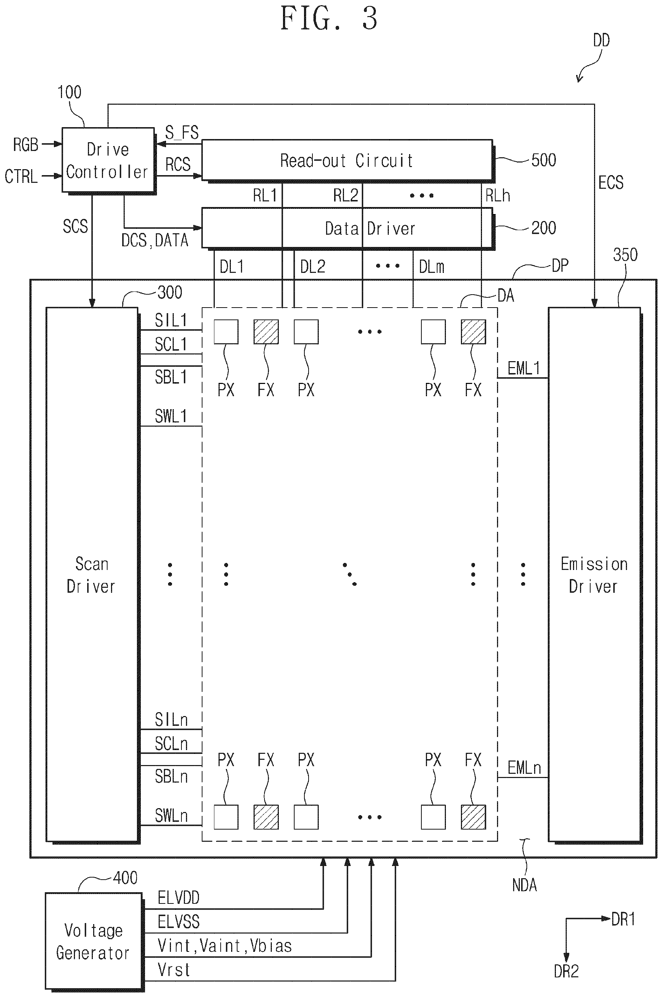

FIG. 3 is a block diagram of a display device.

Referring to FIG. 3, the display device DD includes a display panel DP, a panel driver, and a driving controller (or a drive controller) 100. As an example, the panel driver includes a data driver 200, a scan driver 300, an emission driver 350, a voltage generator 400, and a read-out circuit 500. In FIG. 3, the scan driver 300 and the emission driver 350 are shown as being located in the display panel DP while the data driver 200, the voltage generator 400, and the read-out circuit 500 are shown as being located outside of the display panel DP. However, the arrangement is not limited thereto, and various components of the panel driver may be respectively located in or outside the display panel DP as a person of ordinary skill in the art would appreciate.

The driving controller 100 receives an image signal RGB and a control signal CTRL. The driving controller 100 generates image data DATA obtained by converting a data format of the image signal RGB to be suitable for an interface specification with the data driver 200. The driving controller 100 outputs a first control signal SCS, a second control signal ECS, a third control signal DCS, and a fourth control signal RCS.

The data driver 200 receives the third control signal DCS and the image data DATA from the driving controller 100. The data driver 200 converts the image data DATA into data signals and outputs the data signals to a plurality of data lines DL1 to DLm to be described later. The data signals are analog voltages corresponding to grayscale values (e.g., gray values or gray level values) of the image data DATA. As an example, the data driver 200 may be embedded in the driving chip DIC illustrated in FIG. 2A.

The scan driver 300 receives the first control signal SCS from the driving controller 100. The scan driver 300 may output scan signals to the scan lines in response to the first control signal SCS.

The voltage generator 400 generates voltages required for an operation of the display panel DP. The voltage generator 400 may generate a first driving voltage ELVDD, a second driving voltage ELVSS, a first initialization voltage Vint, a second initialization voltage Vaint, a bias voltage Vbias, and a reset voltage Vrst.

The display panel DP may include a display area DA corresponding to the transmission area TA (e.g., shown in FIG. 1) and a non-display area NDA corresponding to the bezel area BZA (e.g., shown in FIG. 1).

The display panel DP may include a plurality of pixels PX disposed in the display area DA and a plurality of sensors FX disposed in the display area DA. As an example, each of the plurality of sensors FX may be disposed between two pixels PX adjacent to each other (e.g., two pixels PX that are immediately adjacent to each other with only one sensor FX interposed therebetween). The plurality of pixels PX and the plurality of sensors FX may be alternately arranged in the first and second directions DR1 and DR2. However, the arrangement is not limited thereto. That is, two or more pixels PX may be disposed between two sensors FX adjacent to each other in the first direction DR1 from among the plurality of sensors FX, or two or more pixels PX may be disposed between two sensors FX adjacent to each other in the second direction DR2 from among the plurality of sensors FX.

The display panel DP further includes initialization scan lines SIL1 to SILn, compensation scan lines SCL1 to SCLn, write scan lines SWL1 to SWLn, black scan lines SBL1 to SBLn, emission control lines EML1 to EMLn, data lines DL1 to DLm, and read-out lines RL1 to RLh. The initialization scan lines SIL1 to SILn, the compensation scan lines SCL1 to SCLn, the write scan lines SWL1 to SWLn, the black scan lines SBL1 to SBLn, and the emission control lines EML1 to EMLn extend in the first direction DR1. The initialization scan lines SIL1 to SILn, the compensation scan lines SCL1 to SCLn, the write scan lines SWL1 to SWLn, the black scan lines SBL1 to SBLn, and the emission control lines EML1 to EMLn are arranged to be spaced (e.g., spaced apart) from each other in the second direction DR2. The data lines DL1 to DLm and the read-out lines RL1 to RLh extend in the second direction DR2 and are arranged to be spaced (e.g., spaced apart) from each other in the first direction DR1. Here, n, m, and h are natural numbers of 1 or more.

The plurality of pixels PX is electrically connected to the initialization scan lines SIL1 to SILn, the compensation scan lines SCL1 to SCLn, the write scan lines SWL1 to SWLn, the black scan lines SBL1 to SBLn, the emission control lines EML1 to EMLn, and the data lines DL1 to DLm, respectively. For example, each of the plurality of pixels PX may be electrically connected to four scan lines. However, the number of scan lines connected to each pixel PX is not limited thereto, and may be different in other implementations.

The sensors FX are electrically connected to the write scan lines SWL1 to SWLn and the read-out lines RL1 to RLh, respectively. Each of the plurality of sensors FX may be electrically connected to one scan line. However, the arrangement is not limited thereto. The number of scan lines connected to each sensor FX may be varied. The number of the read-out lines RL1 to RLh may be less than or equal to the number of the data lines DL1 to DLm. For example, the number of the read-out lines RL1 to RLh may correspond to 1/2, 1/4, or 1/8 of the number of the data lines DL1 to DLm.

The scan driver 300 may be disposed in the non-display area NDA of the display panel DP. The scan driver 300 receives the first control signal SCS from the driving controller 100. The scan driver 300 outputs initialization scan signals to the initialization scan lines SIL1 to SILn and compensation scan signals to the compensation scan lines SCL1 to SCLn in response to the first control signal SCS. In addition, the scan driver 300 may output write scan signals to the write scan lines SWL1 to SWLn and black scan signals to the black scan lines SBL1 to SBLn in response to the first control signal SCS. Alternatively, the scan driver 300 may include first and second scan drivers. The first scan driver may output the initialization scan signals and the compensation scan signals, and the second scan driver may output the write scan signals and the black scan signals.

The emission driver 350 may be disposed in the non-display area NDA of the display panel DP. The emission driver 350 receives the second control signal ECS from the driving controller 100. The emission driver 350 may output the emission control signals to the emission control lines EML1 to EMLn in response to the second control signal ECS. Alternatively, the scan driver 300 may be connected to the emission control lines EML1 to EMLn. In this case, the emission driver 350 may be omitted, and the scan driver 300 may output the emission control signals to the emission control lines EML1 to EMLn.

The read-out circuit 500 receives the fourth control signal RCS from the driving controller 100. The read-out circuit 500 may receive sensing signals from the read-out lines RL1 to RLh in response to the fourth control signal RCS. The read-out circuit 500 may process the sensing signals received from the read-out lines RL1 to RLh, and may provide the processed sensing signals S_FS to the driving controller 100. The driving controller 100 may recognize biometric information based on the processed sensing signals S_FS. As an example, the read-out circuit 500 may be embedded in the sensor chips SIC1 and SIC2 shown in FIG. 2A.

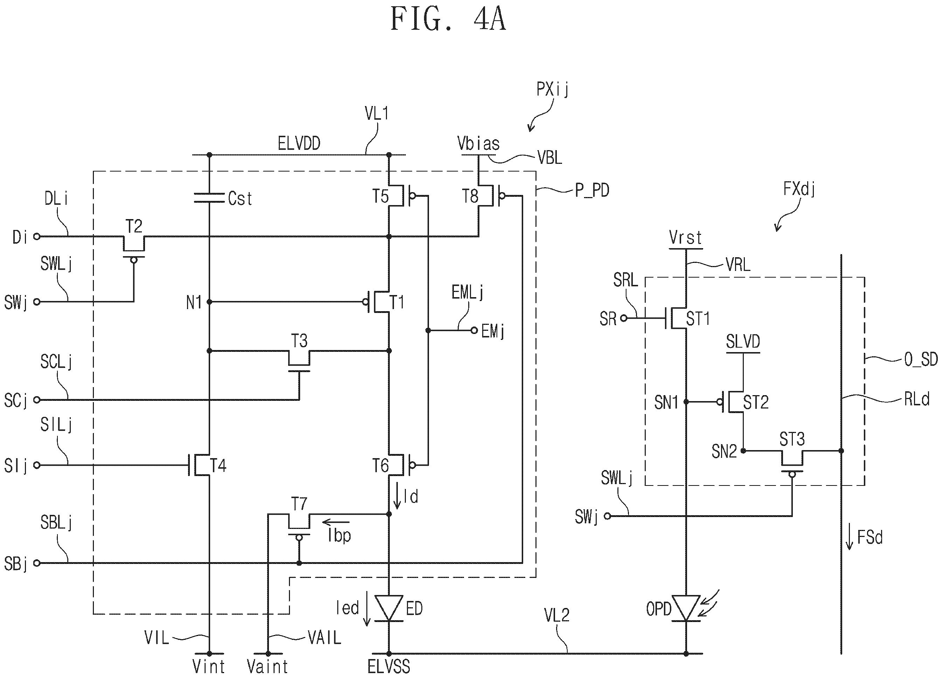

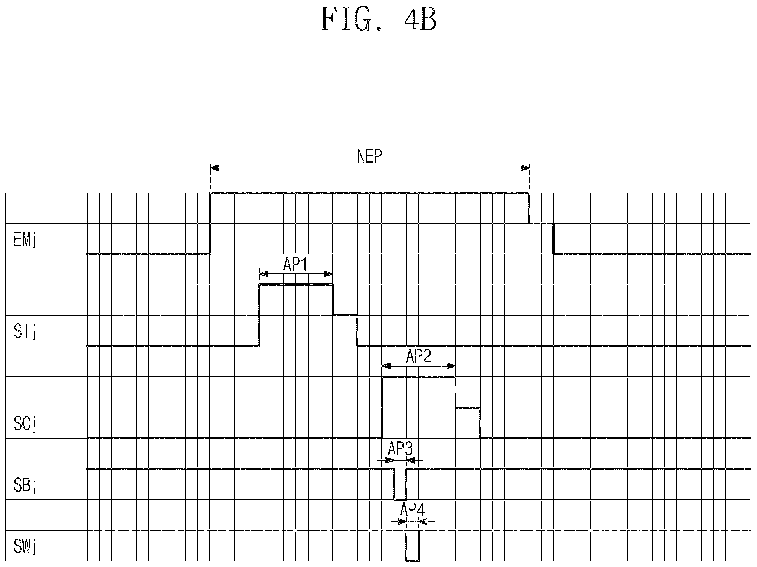

FIG. 4A is a circuit diagram illustrating a pixel and a sensor, and FIG. 4B is a waveform diagram for describing an operation of the pixel and the sensor illustrated in FIG. 4A.

In FIG. 4A, an equivalent circuit diagram of one pixel PXij from among the plurality of pixels PX illustrated in FIG. 3 is illustrated as an example. Because each of the plurality of pixels PX has the same circuit structure or substantially the same circuit structure, a description of the circuit structure of the pixel PXij may be applied (or substantially applied) to the remaining pixels, and a detailed description of the remaining pixels will be omitted. In addition, an equivalent circuit diagram of one sensor FXdj from among the plurality of sensors FX shown in FIG. 3 is shown as an example in FIG. 4A. Because each of the plurality of sensors FX has the same circuit structure or substantially the same circuit structure, a description of the circuit structure of the sensor FXdj may be applied (or substantially applied) to the remaining sensors, and a detailed description of the remaining sensors will be omitted.

Referring to FIG. 4A, the pixel PXij is connected to an i-th data line DLi of the data lines DL1 to DLm, a j-th initialization scan line SILj of the initialization scan lines SIL1 to SILn, a j-th compensation scan line SCLj of the compensation scan lines SCL1 to SCLn, a j-th write scan line SWLj of the write scan lines SWL1 to SWLn, a j-th black scan line SBLj of the black scan lines SBL1 to SBLn, and a j-th emission control line EMLj of the emission control lines EML1 to EMLn.

The pixel PXij includes a light emitting element ED and a pixel driving circuit P_PD. The light emitting element ED may be a light emitting diode. As an example, the light emitting element ED may be an organic light emitting diode including an organic light emitting layer.

The pixel driving circuit P_PD includes first to eighth transistors T1, T2, T3, T4, T5, T6, T7, and T8 and one capacitor Cst. At least one of the first to eighth transistors T1 to T8 may be a transistor having a low-temperature polycrystalline silicon (LTPS) semiconductor layer. Some of the first to eighth transistors T1 to T8 may be P-type transistors, and the others may be N-type transistors. At least one of the first to eighth transistors T1 to T8 may be a transistor having an oxide semiconductor layer. For example, the third and fourth transistors T3 and T4 may be oxide semiconductor transistors, and the first, second, and fifth to eighth transistors T1, T2, and T5~T8 may be LTPS transistors. The third and fourth transistors T3 and T4 may be NMOS transistors.

The configuration of the pixel driving circuit P_PD is not limited to that shown in FIG. 4A. The pixel driving circuit P_PD illustrated in FIG. 4A is only one example, and the configuration of the pixel driving circuit P_PD may be modified and implemented. For example, all of the first, second, and fifth to eighth transistors T1, T2, and T5~T8 may be P-type transistors (e.g., as shown in FIG. 4A) or N-type transistors.

The j-th initialization scan line SILj, the j-th compensation scan line SCLj, the j-th write scan line SWLj, the j-th black scan line SBLj, and the j-th emission control line EMLj may transmit a j-th initialization scan signal SIj, a j-th compensation scan signal SCj, a j-th write scan signal SWj, a j-th black scan signal SBj, and a j-th emission control signal EMj to the pixel PXij, respectively. The i-th data line DLi transmits an i-th data signal Di to the pixel PXij. The i-th data signal Di may have a voltage level corresponding to the image signal RGB (e.g., see FIG. 3) input to the display device DD (e.g., see FIG. 3).

As an example, the pixel PXij may be connected to first and second driving voltage lines VL1 and VL2, first and second initialization voltage lines VIL and VAIL, and a bias voltage line VBL. The first driving voltage line VL1 may transmit the first driving voltage ELVDD to the pixel PXij, and the second driving voltage line VL2 may transmit the second driving voltage ELVSS to the pixel PXij. The first initialization voltage line VIL may transmit the first initialization voltage Vint to the pixel PXij, and the second initialization voltage line VAIL may transmit the second initialization voltage Vaint to the pixel PXij. The bias voltage line VBL may transmit the bias voltage Vbias to the pixel PXij.

The first transistor T1 is connected between the first driving voltage line VL1 receiving the first driving voltage ELVDD and the light emitting element ED. The first transistor T1 includes a first electrode connected to the first driving voltage line VL1 via the fifth transistor T5, a second electrode connected to an anode electrode of the light emitting element ED via the sixth transistor T6, and a third electrode (e.g., a gate electrode) connected to one end (or one terminal) (e.g., a first node N1) of the capacitor Cst. The first transistor T1 may receive the i-th data signal Di transmitted by the i-th data line DLi according to a switching operation of the second transistor T2 to supply a driving current Id to the light emitting element ED.

The second transistor T2 is connected between the i-th data line DLi and the first electrode of the first transistor T1. The second transistor T2 includes a first electrode connected to the i-th data line DLi, a second electrode connected to the first electrode of the first transistor T1, and a third electrode (e.g., a gate electrode) connected to the j-th write scan line SWLj. The second transistor T2 may be turned on in response to the j-th write scan signal SWj received through the j-th write scan line SWLj to transmit the i-th data signal Di transmitted from the i-th data line DLi to the first electrode of the first transistor T1.

The third transistor T3 is connected between the second electrode of the first transistor T1 and the first node N1. The third transistor T3 includes a first electrode connected to the third electrode of the first transistor T1, a second electrode connected to the second electrode of the first transistor T1, and a third electrode (e.g., a gate electrode) connected to the j-th compensation scan line SCLj. The third transistor T3 may be turned on in response to the j-th compensation scan signal SCj received through the j-th compensation scan line SCLj to diode-connect the first transistor T1 by connecting (e.g., electrically connecting) the third electrode and the second electrode of the first transistor T1 to each other.

The fourth transistor T4 is connected between the first initialization voltage line VIL, to which the first initialization voltage Vint is applied, and the first node N1. The fourth transistor T4 includes a first electrode connected to the first initialization voltage line VIL through which the first initialization voltage Vint is transmitted, a second electrode connected to the first node N1, and a third electrode (e.g., a gate electrode) connected to the j-th initialization scan line SILj. The fourth transistor T4 is turned on in response to the j-th initialization scan signal SIj received through the j-th initialization scan line SILj. The turned-on fourth transistor T4 initialize the potential of the third electrode of the first transistor T1 (i.e., the potential of the first node N1) by transmitting the first initialization voltage Vint to the first node N1.

The fifth transistor T5 includes a first electrode connected to the first driving voltage line VL1, a second electrode connected to the first electrode of the first transistor T1, and a third electrode (e.g., a gate electrode) connected to the j-th emission control line EMLj.

The sixth transistor T6 includes a first electrode connected to the second electrode of the first transistor T1, a second electrode connected to the anode electrode of the light emitting element ED, and a third electrode (e.g., a gate electrode) connected to the j-th emission control line EMLj.

The fifth and sixth transistors T5 and T6 are concurrently (e.g., simultaneously) turned on in response to the j-th emission control signal EMj received through the j-th emission control line EMLj. The first driving voltage ELVDD applied through the turned-on fifth transistor T5 may be compensated through the diode-connected first transistor T1 and then transmitted to the light emitting element ED.

The seventh transistor T7 includes a first electrode connected to the second initialization voltage line VAIL through which the second initialization voltage Vaint is transmitted, a second electrode connected to the second electrode of the sixth transistor T6, and a third electrode (e.g., a gate electrode) connected to the j-th black scan line SBLj. The second initialization voltage Vaint may have a voltage level lower than or equal to that of the first initialization voltage Vint.

The eighth transistor T8 includes a first electrode connected to the bias voltage line VBL through which the bias voltage Vbias is transmitted, a second electrode connected to the first electrode of the first transistor T1, and a third electrode (e.g., a gate electrode) connected to the j-th black scan line SBLj.

The seventh and eighth transistors T7 and T8 are concurrently (e.g., simultaneously) turned on in response to the j-th black scan signal SBj received through the j-th black scan line SBLj. The second initialization voltage Vaint applied through the turned-on seventh transistor T7 may be transmitted to the anode electrode of the light emitting element ED. Therefore, the anode electrode of the light emitting element ED may be initialized to the second initialization voltage Vaint. The bias voltage Vbias applied through the turned-on eighth transistor T8 may be transmitted to the first electrode of the first transistor T1. Accordingly, the bias voltage Vbias may be periodically applied to the first electrode of the first transistor T1, and as a result, it is possible to prevent or reduce deterioration of display quality caused by a potential difference between the first and second electrodes of the first transistor T1 increasing to a certain level or more due to a hysteresis phenomenon.

As described above, one end (e.g., one terminal) of the capacitor Cst is connected to the third electrode of the first transistor T1 and an opposite end (e.g., an opposite terminal) of the capacitor Cst is connected to the first driving voltage line VL1. A cathode electrode of the light emitting element ED may be connected to the second driving voltage line VL2 for transmitting the second driving voltage ELVSS. The second driving voltage ELVSS may have a voltage level lower than that of the first driving voltage ELVDD. As an example, the second driving voltage ELVSS may have a voltage level lower than those of the first and second initialization voltages Vint and Vaint.

Referring to FIGS. 4A and 4B, the j-th emission control signal EMj has a high level during a non-emission period NEP. In the non-emission period NEP, the j-th initialization scan signal SIj is activated. When the j-th initialization scan signal SIj of a high level is provided through the j-th initialization scan line SILj during an activation period AP1 (hereinafter, referred to as a first activation period) of the j-th initialization scan signal SIj, the fourth transistor T4 is turned on in response to the j-th initialization scan signal SIj of the high level. The first initialization voltage Vint is transmitted to the third electrode of the first transistor T1 through the turned-on fourth transistor T4, and the first node N1 is initialized by the first initialization voltage Vint. Therefore, the first activation period AP1 may be defined (or referred to) as an initialization period of the pixel PXij.

Next, the j-th compensation scan signal SCj is activated, when the j-th compensation scan signal SCj having a high level is supplied through the j-th compensation scan line SCLj during an activation period AP2 (hereinafter, referred to as a second activation period) of the j-th compensation scan signal SCj, the third transistor T3 is turned on. The first transistor T1 is diode-connected by the turned-on third transistor T3 and is biased in a forward direction. The first activation period AP1 may not overlap the second activation period AP2.

The j-th write scan signal SWj is activated in the second activation period AP2 (e.g., during a portion of the second activation period AP2). The j-th write scan signal SWj has a low level during an activation period AP4 (hereinafter, referred to as a fourth active period). During the fourth activation period AP4, the second transistor T2 is turned on by the j-th write scan signal SWj of the low level. Then, a compensation voltage "Di-Vth" that is reduced by a threshold voltage Vth of the first transistor T1 from the i-th data signal Di supplied from the i-th data line DLi is applied to the third electrode of the first transistor T1. That is, a potential of the third electrode of the first transistor T1 may be the compensation voltage "Di-Vth". The fourth activation period AP4 may overlap the second activation period AP2. A duration of the second activation period AP2 may be greater than a duration of the fourth activation period AP4.

The first driving voltage ELVDD and the compensation voltage "Di-Vth" may be applied to two ends (e.g., two opposite terminals) of the capacitor Cst, and a charge corresponding to a voltage difference between the two ends (e.g., two opposite terminals) may be stored in the capacitor Cst. Here, the second activation period AP2 of the j-th compensation scan signal SCj may be referred to as a compensation period of the pixel PXij.

Meanwhile, the j-th black scan signal SBj is activated within the second activation period AP2 of the j-th compensation scan signal SCj. The j-th black scan signal SBj has a low level during an activation period AP3 (hereinafter, referred to as a third activation period). During the third activation period AP3, the seventh transistor T7 is turned on in response to the j-th black scan signal SBj of the low level applied through the j-th black scan line SBLj. A portion of the driving current Id may be discharged through the seventh transistor T7 as a bypass current Ibp. The third activation period AP3 may overlap the second activation period AP2. The duration of the second activation period AP2 may be greater than the duration of the third activation period AP3. The third activation period AP3 may precede the fourth activation period AP4 and may not overlap the fourth activation period AP4.

When the pixel PXij displays a black image, if the light emitting element ED emits light even though the minimum driving current of the first transistor T1 flows as the driving current Id, the pixel PXij cannot normally display a black image. Accordingly, the seventh transistor T7 in the pixel PXij may distribute a part of the minimum driving current of the first transistor T1 as the bypass current Ibp to a current path other than the current path toward the light emitting element ED. Here, the minimum driving current of the first transistor T1 means (or refers to) a current flowing to the first transistor T1 under a condition in which a gate-source voltage Vgs of the first transistor T1 is less than the threshold voltage Vth and thus the first transistor T1 is turned off. Under the condition in which the first transistor T1 is turned off, the minimum driving current (e.g., a current of 10pA or less) flowing to the first transistor T1 is transmitted to the light emitting element ED to display the black image of a black grayscale. When the pixel PXij displays the black image, the influence of the bypass current Ibp on the minimum driving current is relatively large, whereas when an image such as a normal image or a white image is displayed, the influence of the bypass current Ibp on the driving current Id is relatively little. Therefore, when the black image is displayed, a current (i.e., the light emission current Ied) reduced by a current amount of the bypass current Ibp escaped from the driving current Id through the seventh transistor T7 may be provided to the light emitting element ED to clearly display the black image. Accordingly, the pixel PXij may implement an accurate black grayscale image (i.e., an accurate black gray level image) using the seventh transistor T7, and as a result, a contrast ratio may be improved.

Next, the j-th emission control signal EMj supplied from the j-th emission control line EMLj is changed from a high level to a low level. The fifth and sixth transistors T5 and T6 are turned on by the emission control signal EMj of the low level. Then, the driving current Id corresponding to a voltage difference between the voltage of the third electrode of the first transistor T1 and the first driving voltage ELVDD is generated, and the driving current Id is supplied to the light emitting element ED through the sixth transistor T6 so that the light emission current led flows through the light emitting element ED.

Referring back to FIG. 4A, the sensor FXdj is connected to the d-th read-out line RLd from among the read-out lines RL1 to RLh, the j-th write scan line SWLj, and a reset control line SRL.

The sensor FXdj includes a light receiving element OPD and a sensor driving circuit O_SD. As an example, the light receiving element OPD may be an organic photodiode including an organic material as a photoelectric conversion layer. In FIG. 4A, a structure in which the sensor FXdj includes one light receiving element is illustrated, but is not limited thereto. For example, the sensor FXdj may include a plurality of light receiving elements OPD connected in parallel with each other.

An anode electrode of the light receiving element OPD may be connected to a first sensing node SN1, and a cathode electrode of the light receiving element OPD may be connected to the second driving voltage line VL2 for transmitting the second driving voltage ELVSS. The cathode electrode of the light receiving element OPD may be electrically connected to the cathode electrode of the light emitting element ED. As an example, the cathode electrode of the light receiving element OPD may be integrally formed with the cathode electrode of the light emitting element ED to form a common cathode electrode.

The sensor driving circuit O_SD includes three transistors ST1, ST2, and ST3. The three transistors ST1 to ST3 may be a reset transistor ST1, an amplifying transistor ST2, and an output transistor ST3, respectively. At least one of the reset transistor ST1, the amplifying transistor ST2, or the output transistor ST3 may be an oxide semiconductor transistor. As an example, the reset transistor ST1 may be the oxide semiconductor transistor, and the amplifying transistor ST2 and the output transistor ST3 may be LTPS transistors. However, they are not limited thereto, and at least the reset transistor ST1 and the output transistor ST3 may be oxide semiconductor transistors, and the amplifying transistor ST2 may be the LTPS transistor.

In addition, some of the reset transistor ST1, the amplifying transistor ST2, and the output transistor ST3 may be P-type transistors, and some thereof may be N-type transistors. As an example, the amplifying transistor ST2 and the output transistor ST3 may be PMOS transistors, and the reset transistor ST1 may be an NMOS transistor. However, they are not limited thereto, and all of the reset transistor ST1, the amplifying transistor ST2, and the output transistor ST3 may be N-type transistors or may be P-type transistors, for example.

Some (e.g., the reset transistor ST1) of the reset transistor ST1, the amplifying transistor ST2, and the output transistor ST3 may be transistors of the same type as the third and fourth transistors T3 and T4 of the pixel PXij. The amplifying transistor ST2 and the output transistor ST3 may be transistors of the same type as the first, second, fifth to eighth transistors T1, T2, and T5 to T8 of the pixel PXij.

The circuit configuration of the sensor driving circuit O_SD is not limited to FIG. 4A. The sensor driving circuit O_SD illustrated in FIG. 4A is only one example, and the configuration of the sensor driving circuit O_SD may be modified.

The reset transistor ST1 includes a first electrode that receives the reset voltage Vrst, a second electrode connected to the first sensing node SN1, and a third electrode that receives a reset control signal SR. The reset transistor ST1 may reset the potential of the first sensing node SN1 to the reset voltage Vrst in response to the reset control signal SR. The reset control signal SR may be a signal provided through the reset control line SRL. However, it is not limited thereto. Alternatively, the reset control signal SR may be the j-th compensation scan signal SCj supplied through the j-th compensation scan line SCLj. That is, the reset transistor ST1 may receive the j-th compensation scan signal SCj supplied from the j-th compensation scan line SCLj as the reset control signal SR. As an example, the reset voltage Vrst may have a voltage level lower than that of the second driving voltage ELVSS at least during the activation period of the reset control signal SR. The reset voltage Vrst may be transmitted to the sensor FXdj through the reset voltage line VRL. The reset voltage Vrst may be a DC voltage that is maintained at a voltage level lower than that of the second driving voltage ELVSS.

The reset transistor ST1 may include a plurality of sub-reset transistors connected in series. For example, the reset transistor ST1 may include two sub-reset transistors (hereinafter, referred to as first and second sub-reset transistors). In this case, a third electrode of the first sub-reset transistor and a third electrode of the second sub-reset transistor are connected to the reset control line SRL. In addition, a second electrode of the first sub-reset transistor may be electrically connected to a first electrode of the second sub-reset transistor. In addition, the reset voltage Vrst may be applied to a first electrode of the first sub-reset transistor, and a second electrode of the second sub-reset transistor may be electrically connected to the first sensing node SN1. However, the number of the sub-reset transistors is not limited thereto, and may be variously modified.

The amplifying transistor ST2 includes a first electrode receiving the sensing driving voltage SLVD, a second electrode connected to a second sensing node SN2, and a third electrode connected to the first sensing node SN1. The amplifying transistor ST2 may be turned on in response to the potential of the first sensing node SN1 to apply the sensing driving voltage SLVD to the second sensing node SN2. As an example, the sensing driving voltage SLVD may be one of the first driving voltage ELVDD or the first and second initialization voltages Vint and Vaint. When the sensing driving voltage SLVD is the first driving voltage ELVDD, the first electrode of the amplifying transistor ST2 may be electrically connected to the first driving voltage line VL1. When the sensing driving voltage SLVD is the first initialization voltage Vint, the first electrode of the amplifying transistor ST2 may be electrically connected to the first initialization voltage line VIL, and when the sensing driving voltage SLVD is the second initialization voltage Vaint, the first electrode of the amplifying transistor ST2 may be electrically connected to the second initialization voltage line VAIL.

The output transistor ST3 includes a first electrode connected to the second sensing node SN2, a second electrode connected to the d-th read-out line RLd, and a third electrode receiving an output control signal. The output transistor ST3 may transfer a sensing signal FSd to the d-th read-out line RLd in response to the output control signal. The output control signal may be the j-th write scan signal SWj supplied through the j-th write scan line SWLj. That is, the output transistor ST3 may receive the j-th write scan signal SWj supplied from the j-th write scan line SWLj as the output control signal.

The light receiving element OPD of the sensor FXdj may be exposed to light during an emission period of the light emitting element ED. The light may be light output from the light emitting element ED.

If the user's hand US_F (e.g., see FIG. 1) touches the display surface IS (e.g., see FIG. 1), the light receiving element OPD generates photo-charges corresponding to light reflected by ridges of the fingerprint or valleys between the ridges. The amount of current flowing through the light receiving element OPD varies by the generated photo-charges. When the light receiving element OPD receives light reflected by the ridges of the fingerprint, the current flowing through the light receiving element OPD may be referred to as a first current, and when the light receiving element OPD receives light reflected by the valleys of the fingerprint, the current flowing through the light receiving element OPD may be referred to as a second current. Because the amount of light reflected by the ridges of the fingerprint is different from the amount of light reflected by the valleys of the fingerprint, such a difference in the amount of light appears as a difference between the first and second currents. When the first current flows through the light receiving element OPD, the potential of the first sensing node SN1 may be referred to as a first potential, and when the second current flows through the light receiving element OPD, the potential of the first sensing node SN1 may be referred to as a second potential. As an example, the first current may be greater than the second current, and in this case, the first potential may be lower than the second potential.

The amplifying transistor ST2 may be a source follower amplifier that generates a source-drain current in proportion to the potential of the first sensing node SN1 input to the third electrode.

During the fourth activation period AP4, the j-th write scan signal SWj having a low level is supplied to the output transistor ST3 through the j-th write scan line SWLj. When the output transistor ST3 is turned on in response to the j-th write scan signal SWj of the low level, the sensing signal FSd corresponding to a current flowing through the amplifying transistor ST2 may be output to the d-th read-out line RLd.

Next, when the reset control signal SR of a high level is supplied through the reset control line SRL during a reset period, the reset transistor ST1 is turned on. The reset period may be defined (or referred to) as an activation period (i.e., a high-level period) of the reset control signal SR. Alternatively, when the reset transistor ST1 is formed of a P-type transistor, the reset control signal SR of a low level may be supplied to the reset control line SRL during the reset period. During the reset period, the first sensing node SN1 may be reset to a potential corresponding to the reset voltage Vrst. As an example, the reset voltage Vrst may have a voltage level lower than that of the second driving voltage ELVSS. However, the it is not limited thereto.

Next, when the reset period ends, the light receiving element OPD may generate photo-charges corresponding to the received light, and the generated photo-charges may be accumulated in the first sensing node SN1.

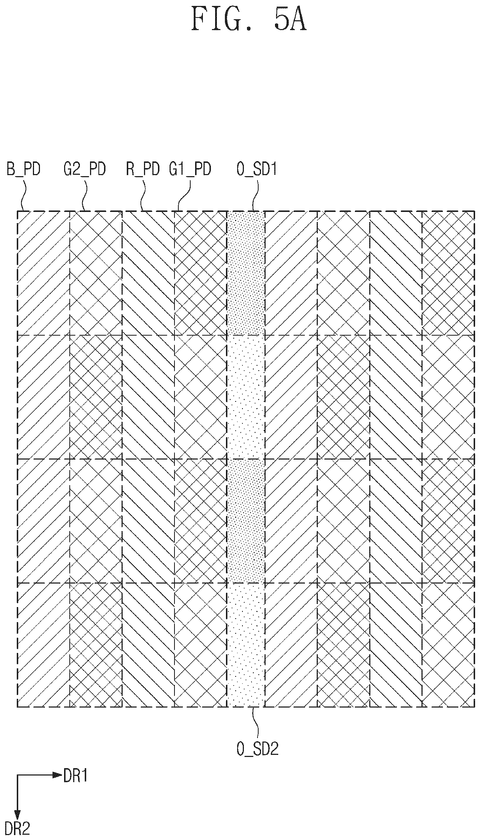

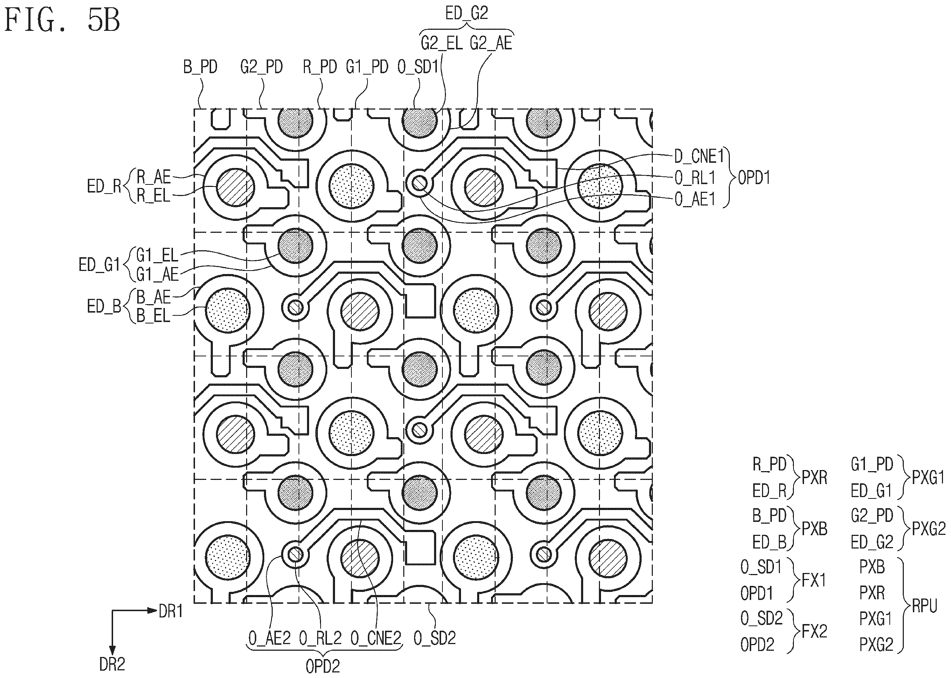

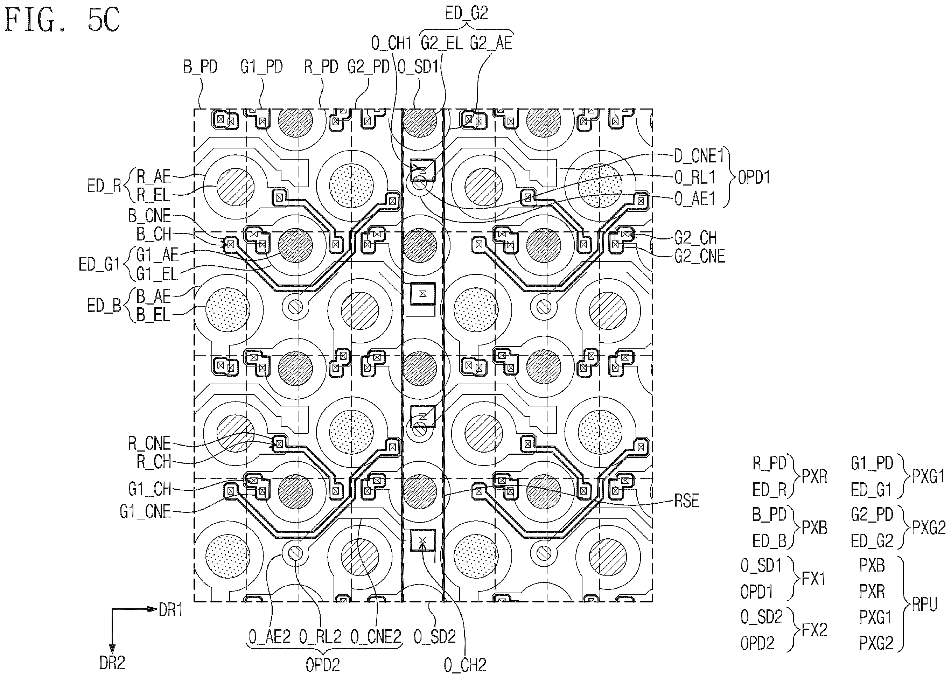

FIG. 5A is a schematic plan view illustrating an arrangement of pixel driving circuits and sensor driving circuits. FIG. 5B is a plan view illustrating an arrangement of light emitting elements and light receiving elements. FIG. 5C is a plan view illustrating a connection relationship between light emitting elements and pixel driving circuits and a connection relationship between light receiving elements and sensor driving circuits.

Referring to FIGS. 5A to 5C, the display panel DP includes a plurality of pixels PXR, PXG1, PXG2, and PXB and a plurality of sensors FX1 and FX2.

The plurality of pixels PXR, PXG1, PXG2, and PXB may be grouped into a plurality of reference pixel units RPU. As an example, each reference pixel unit RPU may include four pixels, i.e., a first pixel PXB (hereinafter, referred to as a blue pixel), a second pixel PXR (hereinafter, referred to as a red pixel), and two third pixels PXG1 and PXG2 (hereinafter, referred to as first and second green pixels). However, the number of pixels included in each reference pixel unit RPU is not limited thereto. Alternatively, each reference pixel unit RPU may include three pixels, i.e., a blue pixel PXB, a red pixel PXR, and a green pixel (one of the first and second green pixels PXG1 and PXG2).

The blue pixel PXB includes a first light emitting element ED_B (hereinafter, referred to as a blue light emitting element) and a blue pixel driving circuit B_PD (or a first pixel driving circuit). The red pixel PXR includes a second light emitting element ED_R (hereinafter, referred to as a red light emitting element) and a red pixel driving circuit R_PD (or a second pixel driving circuit). The first green pixel PXG1 includes a third light emitting element ED_G1 (hereinafter, referred to as a first green light emitting element) and a first green pixel driving circuit G1_PD (hereinafter, referred to as a third pixel driving circuit), and the second green pixel PXG2 includes a fourth light emitting element ED_G2 (hereinafter, referred to as a second green light emitting element) and a second green pixel driving circuit G2_PD (hereinafter, referred to as a fourth pixel driving circuit).

As an example, the blue light emitting element ED_B outputs a first color light (e.g., blue light), and the red light emitting element ED_R outputs a second color light (e.g., red light) different from the first color light. Each of the first and second green light emitting elements ED_G1 and ED_G2 outputs a third color light (for example, green light) different from the first and second color lights. The green light output from the first green light emitting element ED_G1 may have the same wavelength band as the green light output from the second green light emitting element ED_G2.

In the first and second directions DR1 and DR2, the red light emitting elements ED_R and the blue light emitting elements ED_B may be alternately and repeatedly disposed. The first and second green light emitting elements ED_G1 and ED_G2 are alternately and repeatedly disposed in the first direction DR1 and alternately and repeatedly disposed in the second direction DR2. The light emitting elements ED_R, ED_G1, ED_G2, and ED_B may be arranged in the order of the red light emitting element ED_R, the second green light emitting element ED_G2, the blue light emitting element ED_B, and the first green light emitting element ED_G1 in a first row (e.g., an odd-numbered row) parallel to the first direction DR1. The light emitting elements ED_R, ED_G1, ED_G2, and ED_B may be arranged in the order of the blue light emitting element ED_B, the first green light emitting element ED_G1, the red light emitting element ED_R, and the second green light emitting element ED_G2 in a second row (e.g., an even-numbered row) parallel to the first direction DR1.

As an example, the red light emitting element ED_R may have a size larger than that of the first and second green light emitting elements ED_G1 and ED_G2. In addition, the blue light emitting element ED_B may have a size larger than or equal to that of the red light emitting element ED_R. The size of each of the light emitting elements ED_R, ED_G1, ED_G2, and ED_B is not limited thereto, and may be variously modified and applied. For example, the light emitting elements ED_R, ED_G1, ED_G2, and ED_B may have the same size (or substantially the same size).

The first and second green light emitting elements ED_G1 and ED_G2 may have the same shape (or substantially the same shape) as the red and blue light emitting elements ED_R and ED_B. As an example, each of the red and blue light emitting elements ED_R and ED_B and the first and second green light emitting elements ED_G1 and ED_G2 may have a circular shape. Alternatively, each of the red and blue light-emitting elements ED_R, ED_B, and the first and second green light-emitting elements ED_G1, ED_G2 may have a polygonal shape (e.g., a shape of one of an octagon, a square, or a rectangular shape). However, the shapes are not limited thereto, and the red and blue light emitting elements ED_R and ED_B and the first and second green light emitting elements ED_G1 and ED_G2 may have different suitable shapes as a person of ordinary skill in the art would appreciate.

The blue light emitting element ED_B is electrically connected to the blue pixel driving circuit B_PD (or the first pixel driving circuit). Specifically, the blue light emitting element ED_B includes a blue anode electrode B_AE (or a first pixel anode electrode) and a blue light emitting layer B_EL, and the blue anode electrode B_AE is electrically connected to the blue pixel driving circuit B_PD through a blue pixel connection electrode B_CNE (or a first pixel connection electrode). The blue pixel connection electrode B_CNE is connected to the blue anode electrode B_AE and the blue pixel driving circuit B_PD through a blue contact hole B_CH, respectively.

The red light emitting element ED_R is electrically connected to the red pixel driving circuit R_PD (or the second pixel driving circuit). Specifically, the red light emitting element ED_R includes a red anode electrode R_AE (or a second pixel anode electrode) and a red light emitting layer R_EL, and the red anode electrode R_AE is electrically connected to the red pixel driving circuit R_PD through a red pixel connection electrode R_CNE (or a second pixel connection electrode). The red pixel connection electrode R_CNE is connected to the red anode electrode R_AE and the red pixel driving circuit R_PD through a red contact holes R_CH, respectively.

The first green light emitting element ED_G1 is electrically connected to the first green pixel driving circuit G1_PD (or the third pixel driving circuit). In detail, the first green light emitting element ED_G1 includes a first green anode electrode G1_AE (or a third pixel anode electrode) and a first green light emitting layer G1_EL, and the first green anode electrode G1_AE is electrically connected to the first green pixel driving circuit G1_PD through a first green pixel connection electrode G1_CNE (or a third pixel connection electrode). The first green pixel connection electrode G1_CNE is connected to the first green anode electrode G1_AE and the first green pixel driving circuit G1_PD through a first green contact holes G1_CH, respectively. The second green light emitting element ED_G2 is electrically connected to the second green pixel driving circuit G2_PD (or the fourth pixel driving circuit). For example, the second green light emitting element ED_G2 may include a second green anode electrode G2_AE (or a fourth pixel anode electrode) and a second green light emitting layer G2_EL, and the second green anode electrode G2_AE may be electrically connected to the second green pixel driving circuit G2_PD through a second green pixel connection electrode G2_CNE (or a fourth pixel connection electrode). The second green pixel connection electrode G2_CNE is connected to the second green anode electrode G2_AE and the second green pixel driving circuit G2_PD through a second green contact holes G2_CH, respectively.

The first green light emitting layer G1_EL and the second green light emitting layer G2_EL may have the same size and the same shape. However, they are not limited thereto. For example, the first green light emitting layer G1_EL and the second green light emitting layer G2_EL may have the same size (or same area) but different shapes. In addition, the first green anode electrode G1_AE and the second green anode electrode G2_AE may have different sizes (or different areas) and different shapes.

In the first row (e.g., the odd-numbered row), the pixel driving circuits R_PD, G1_PD, G2_PD, and B_PD may be arranged in the order of the blue pixel driving circuit B_PD, the second green pixel driving circuit G2_PD, the red pixel driving circuit R_PD, and the first green pixel driving circuit G1_PD. In the second row (e.g., the even-numbered row), the pixel driving circuits R_PD, G1_PD, G2_PD, and B_PD may be arranged in the order of the blue pixel driving circuit B_PD, the first green pixel driving circuit G1_PD, the red pixel driving circuit R_PD, and the second green pixel driving circuit G2_PD. The order of pixel driving circuits R_PD, G1_PD, G2_PD, and B_PD in the first and second rows may be repeated in the first direction DR1. The first and second rows may be repeated along the second direction DR2.

As an example, the blue pixel driving circuits B_PD are disposed in a first column parallel to the second direction DR2, and the first and second green pixel driving circuits G1_PD and G2_PD are alternately disposed in a second column. The blue pixel driving circuits B_PD may be continuously (or consecutively) arranged in the second direction DR2. The red pixel driving circuits R_PD are arranged in a third column, and the second and first green pixel driving circuits G2_PD and G1_PD are alternately arranged in a fourth column. The red pixel driving circuits R_PD may be continuously arranged in the second direction DR2.

As described above, when the pixel driving circuits of the same color are successively (or sequentially or consecutively or repeatedly) disposed in each column, the data signal applied to each data line may also be fixed as a data signal for one color. Because the data signal applied to one data line is fixed as the data signal for one color, power consumption may be reduced compared to a structure in which data signals for two or more colors are repeatedly applied to one data line.

Each of the sensors FX1 and FX2 includes a light receiving element OPD1 or OPD2 and a sensor driving circuit O_SD1 or O_SD2. As an example, one light receiving element OPD1 or OPD2 may be disposed to correspond to one reference pixel unit RPU. However, the number of light receiving elements disposed corresponding to each reference pixel unit RPU is not limited thereto. For example, two light receiving elements may be correspondingly disposed in each reference pixel unit RPU.

The plurality of light receiving elements OPD1 and OPD2 is arranged in the first and second directions DR1 and DR2 in the display panel DP. When the first direction DR1 is defined (e.g., referred to) as a row direction and the second direction DR2 is defined (e.g., referred to) as a column direction, a light receiving element disposed in a first row (e.g., an odd-numbered row) from among the light receiving elements OPD1 and OPD2 is referred to as a first light receiving element OPD1, and a light receiving element disposed in a second row (e.g., an even-numbered row) from among the light receiving elements OPD1 and OPD2 is referred to as a second light receiving element OPD2.

Each of the first and second light receiving elements OPD1 and OPD2 is disposed between the red and blue light emitting elements ED_R and ED_B in the first direction DR1. The first light receiving element OPD1 is disposed between the first green light emitting elements ED_G1 and the second green light emitting element ED_G2 adjacent to each other in the second direction DR2, and the second light receiving element OPD2 is disposed between the first green light emitting elements ED_G1 and the second green light emitting elements ED_G2 adjacent to each other in the second direction DR2.

The sensor driving circuits O_SD1 or O_SD2 are arranged in the first and second directions DR1 and DR2 in the display panel DP. Each of the sensor driving circuits O_SD1 and O_SD2 may have the same length as the red and blue pixel driving circuits R_PD and B_PD and the first and second green pixel driving circuits G1_PD and G2_PD in the second direction DR2. A sensor driving circuit disposed in the first row (e.g., the odd-numbered row) from among the sensor driving circuits O_SD1 and O_SD2 is referred to as a first sensor driving circuit O_SD1, and a sensor driving circuit disposed in the second row (e.g., the even-numbered row) from among the sensor driving circuits O_SD1 and O_SD2 is referred to as a second sensor driving circuit O_SD2. The first and second sensor driving circuits O_SD1 and O_SD2 are alternately disposed in the second direction DR2 in a fifth column parallel to the second direction DR2. The fifth column may be adjacent to the fourth column, and the first to fifth columns may be repeated in the first direction DR1.

The first light receiving element OPD1 is connected to the first sensor driving circuit O_SD1, and the second light receiving element OPD2 is connected to the second sensor driving circuit O_SD2. As an example, the first light receiving element OPD1 may be disposed at a position overlapping the first sensor driving circuit O_SD1 in a plan view, and the second light receiving element OPD2 may be disposed at a position not overlapping the second sensor driving circuit O_SD2 in a plan view.

The first light receiving element OPD1 includes a first sensor anode electrode O_AE1 (or a first row anode electrode) and a first photoelectric conversion layer O_RL1, and the second light receiving element OPD2 includes a second sensor anode electrode O_AE2 (or a second row anode electrode) and a second photoelectric conversion layer O_RL2. The first sensor anode electrode O_AE1 is provided at a position overlapping the first sensor driving circuit O_SD1. The first sensor anode electrode O_AE1 is directly connected to the first sensor driving circuit O_SD1 through a first sensor contact hole O_CH1. The second sensor anode electrode O_AE2 is provided at a position not overlapping the second sensor driving circuit O_SD2. The second light receiving element OPD2 further includes a sensor connection electrode O_CNE2 extending from the second sensor anode electrode O_AE2 in the first direction DR1 to overlap the second sensor driving circuit O_SD2. That is, the sensor connection electrode O_CNE2 has an integral shape with the second sensor anode electrode O_AE2. The sensor connection electrode O_CNE2 is directly connected to the second sensor driving circuit O_SD2 through a second sensor contact hole O_CH2.

As an example, the first light receiving element OPD1 further includes a dummy connection electrode D_CNE1 extending from the first sensor anode electrode O_AE1 in the first direction DR1. That is, the dummy connection electrode D_CNE1 has an integral shape with the first sensor anode electrode O_AE1. The sum of the area of the first sensor anode electrode O_AE1 and the area of the dummy connection electrode D_CNE1 may be the same as the sum of the area of the second sensor anode electrode O_AE2 and the area of the sensor connection electrode O_CNE2.

As an example, each of the first and second light receiving elements OPD1 and OPD2 may have the same shape as each of the light emitting elements ED_G1, ED_G2, ED_R, and ED_B. For example, each of the first and second light receiving elements OPD1 and OPD2 may have a circular shape. However, the shape of each of the first and second light receiving elements OPD1 and OPD2 is not limited thereto. For example, each of the first and second light receiving elements OPD1 and OPD2 may have a polygonal shape (e.g., a shape such as an octagon, a square, a rectangle, etc.). Alternatively, each of the first and second light receiving elements OPD1 and OPD2 may have a shape different from that of at least one of the light emitting elements ED_G1, ED_G2, ED_R, and ED_B.

Each of the first and second light receiving elements OPD1 and OPD2 may have a size smaller than or equal to that of each of the first and second green light emitting elements ED_G1 and ED_G2. However, the size of each of the first and second light receiving elements OPD1 and OPD2 is not particularly limited, and may be variously modified and applied.

The first and second sensor anode electrodes O_AE1 and O_AE2, the sensor connection electrode O_CNE2, and the dummy connection electrode D_CNE1 may be disposed on the same layer (e.g., at the same layer) as the anode electrodes R_AE, G1_AE, G2_AE, and B_AE. In this case, the first and second sensor anode electrodes O_AE1 and O_AE2, the sensor connection electrode O_CNE 2, and the dummy connection electrode D_CNE 1 may include the same material as the anode electrodes R_AE, G1_AE, G2_AE, and B_AE, and may be provided on the same layer (e.g., at the same layer) through the same process.

The first and second green pixel connection electrodes G1_CNE and G2_CNE, the red pixel connection electrode R_CNE, and the blue pixel connection electrode B_CNE may be disposed on a different layer (e.g., at a different layer) from the anode electrodes R_AE, G1_AE, G2_AE, and B_AE, the first and second sensor anode electrodes O_AE1 and O_AE2, the sensor connection electrode O_CNE2, and the dummy connection electrode D_CNE1.

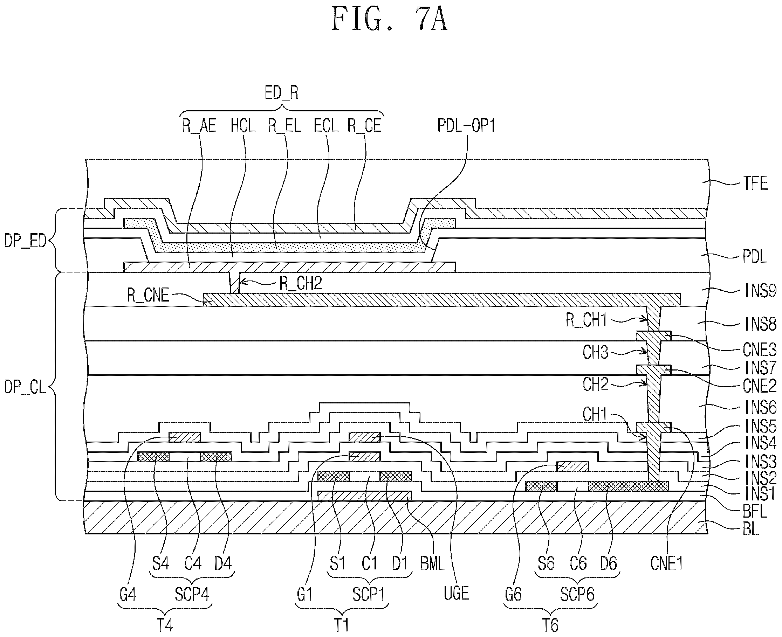

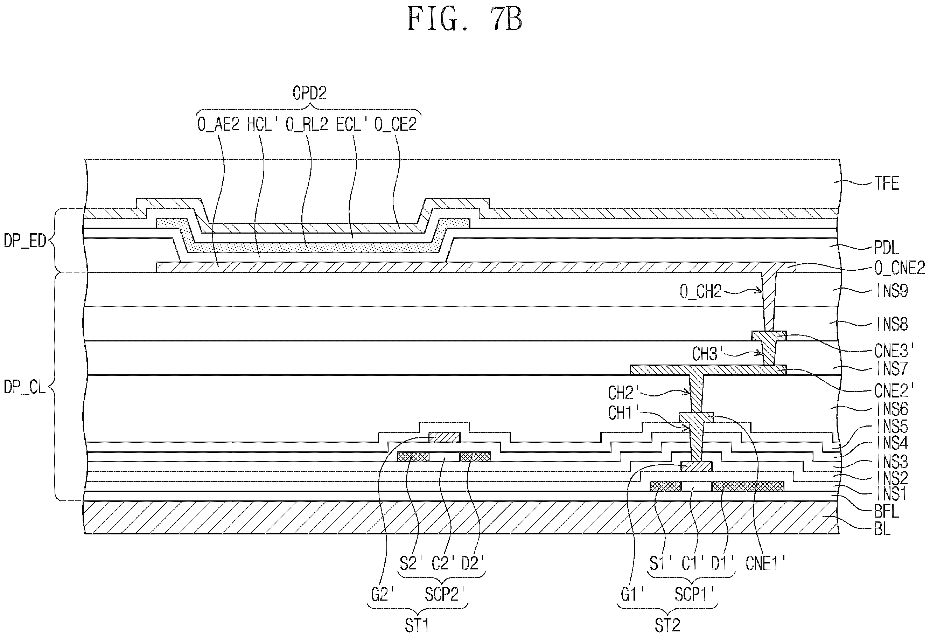

The anode electrodes R_AE, G1_AE, G2_AE, and B_AE, the first and second sensor anode electrodes O_AE1 and O_AE2, the sensor connection electrode O_CNE2, and the dummy connection electrode D_CNE1 may be included in the element layer DP_ED (e.g., see FIGS. 7A and 7B), and the first and second green pixel connection electrodes G1_CNE and G2_CNE, the red pixel connection electrode R_CNE, and the blue pixel connection electrode B_CNE may be included in the circuit layer DP_CL (e.g., see FIGS. 7A and 7B).

The circuit layer DP_CL further includes a shielding electrode RSE overlapping (e.g., partially overlapping) the first and second sensor driving circuits O_PD1 and O_PD2. As an example, the first and second green pixel connection electrodes G1_CNE and G2_CNE, the red pixel connection electrode R_CNE, and the blue pixel connection electrode B_CNE may include the same material as the shielding electrode RSE and may be provided on the same layer (e.g., at the same layer) through the same process.

The blue pixel driving circuit B_PD is disposed at a first side of the blue anode electrode B_AE, and the shielding electrode RSE is disposed at a second side of the blue anode electrode B_AE. In this case, the blue pixel connection electrode B_CNE connecting the blue anode electrode B_AE and the blue pixel driving circuit B_PD is disposed between the blue pixel driving circuit B_PD and the shielding electrode RSE.

As an example, the blue anode electrode B_AE disposed in the first row may be connected to the blue pixel driving circuit B_PD disposed in the second row, and the blue pixel connection electrode B_CNE may be connected to the blue pixel driving circuit B_PD disposed in the second row and the first column through a blue contact hole B_CH. The red anode electrode R_AE disposed in the first row may be connected to the red pixel driving circuit R_PD disposed in the second row, and the red pixel connection electrode R_CNE may be connected to the red pixel driving circuit R_PD disposed in the second row and the third column through a red contact hole R_CH. The red pixel connection electrode R_CNE may be disposed between the red anode electrode R_AE and the shielding electrode RSE.

The blue pixel connection electrode B_CNE and the red pixel connection electrode R_CNE may not overlap (or cross) the first and second sensor driving circuits O_SD1 and O_SD2 in a plan view.

As an example, the blue pixel connection electrode B_CNE may overlap the sensor connection electrode O_CNE2 in a plan view. The blue pixel connection electrode B_CNE may not overlap the red light emitting element ED_R and the first and second green light emitting elements ED_G1 and ED_G2 in a plan view.

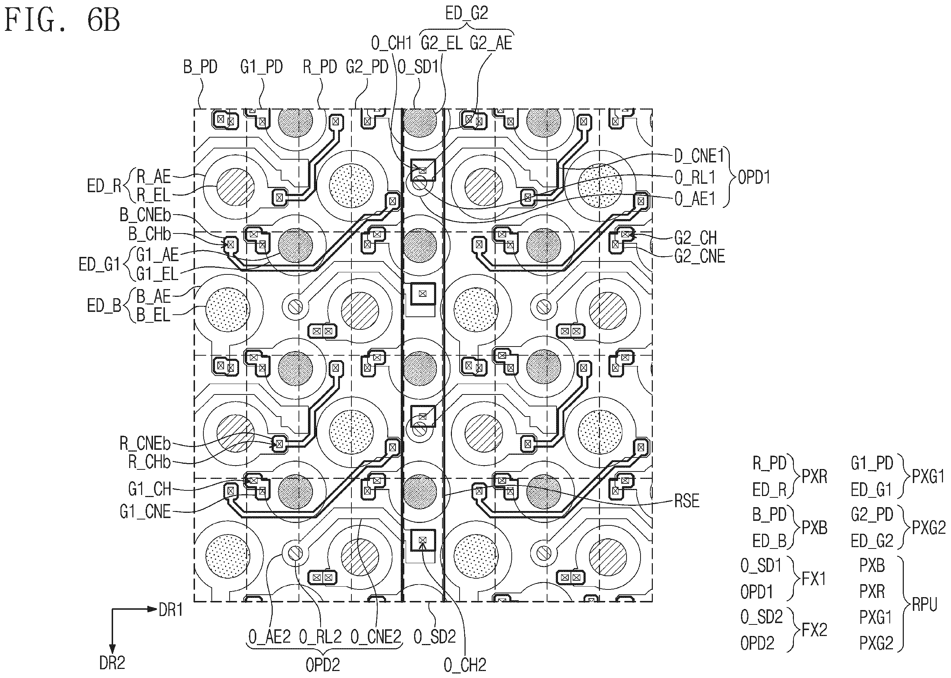

FIGS. 6A and 6B are plan views illustrating a connection relationship between light emitting elements and pixel driving circuits and a connection relationship between light receiving elements and sensor driving circuits.

Referring to FIG. 6A, a blue pixel connection electrode B_CNEa, which connects the blue anode electrode B_AE and the blue pixel driving circuit B_PD, is disposed between the blue pixel driving circuit B_PD and the shielding electrode RSE. The red pixel connection electrode R_CNE, which connects the red pixel driving circuit R_PD and the red anode electrode R_AE may be disposed between the shielding electrode RSE and the red anode electrode R_AE.

The blue pixel connection electrode B_CNEa and the red pixel connection electrode R_CNE may not overlap (or cross) the first and second sensor driving circuits O_SD1 and O_SD2 in a plan view.

The blue anode electrode B_AE disposed in the first row may be connected to the blue pixel driving circuit B_PD disposed in the second row, and the blue pixel connection electrode B_CNEa may be connected to the blue pixel driving circuit B_PD disposed in the second row and the first column through a blue contact hole B_CHa. As an example, the blue pixel connection electrode B_CNEa may overlap with one of the red light emitting element ED_R and the first and second green light emitting elements ED_G1 and ED_G2 in a plan view.

Although FIG. 6A shows a structure in which the blue pixel connection electrode B_CNEa overlaps the red light emitting element ED_R, it is not limited thereto. The blue pixel connection electrode B_CNEa may pass through the center point of the red light emitting element ED_R. Alternatively, even when the blue pixel connection electrode B_CNEa overlaps the first green light emitting element ED_G1, the blue pixel connection electrode B_CNEa may pass through the center point of the first green light emitting element ED_G1. That is, when the blue pixel connection electrode B_CNEa overlaps one of the red light emitting element ED_R and the first and second green light emitting elements ED_G1 and ED_G2, the blue pixel connection electrode B_CNEa passes through the center point of the overlapping light emitting element, thereby preventing or reducing image quality distortion such as a reflective color band from occurring in the corresponding light emitting element.

As an example, the blue pixel connection electrode B_CNEa may overlap the dummy connection electrode D_CNE1 in a plan view and may not overlap the sensor connection electrode O_CNE2 in a plan view.

Referring to FIG. 6B, the red anode electrode R_AE disposed in the first row may be connected to the red pixel driving circuit R_PD disposed in the first row, and the red pixel connection electrode R_CNEb may be connected to the red pixel driving circuit R_PD disposed in the first row and the third column through the red contact hole R_CHb. The red pixel connection electrode R_CNEb may be disposed between the red anode electrode R_AE and the shielding electrode RSE. The blue anode electrode B_AE disposed in the first row may be connected to the blue pixel driving circuit B_PD disposed in the second row, and a blue pixel connection electrode B_CNEb may be connected to the blue pixel driving circuit B_PD disposed in the second row and the first column through a blue contact hole B_CHb. As an example, the blue pixel connection electrode B_CNEb may overlap one of the red light emitting element ED_R and the first and second green light emitting elements ED_G1 and ED_G2 in a plan view.

Although FIG. 6B shows a structure in which the blue pixel connection electrode B_CNEb overlaps the first green light emitting element ED_G1, it is not limited thereto. For example, the blue pixel connection electrode B_CNEb may not overlap the red light emitting element ED_R and the first and second green light emitting elements ED_G1 and ED_G2 in a plan view. In addition, the blue pixel connection electrode B_CNEb may not overlap the dummy connection electrode D_CNE1 and the sensor connection electrode O_CNE2 in a plan view.

When the blue pixel connection electrode B_CNEb does not overlap the dummy connection electrode D_CNE1 and the sensor connection electrode O_CNE2 in a plan view, a coupling capacitance generated between the blue pixel connection electrode B_CNEb and the first and second light-receiving elements OPD1 and OPD2 may be reduced. Therefore, it is possible to prevent or substantially prevent the sensing performance of the first and second light receiving elements OPD1 and OPD2 from being deteriorated by the coupling capacitance.

FIG. 7A is a cross-sectional view illustrating a connection structure of the red light emitting element and the red pixel driving circuit illustrated in FIG. 5C. FIG. 7B is a cross-sectional view illustrating a connection structure of a second light receiving element and a second sensor driving circuit shown in FIG. 5C.

Referring to FIGS. 7A and 7B, the display panel DP may include a base layer BL, a circuit layer DP_CL, and an element layer DP_ED.

The base layer BL may include a synthetic resin layer. The synthetic resin layer may include a thermosetting resin. In particular, the synthetic resin layer may be a polyimide-based resin layer, and the material thereof is not particularly limited. The synthetic resin layer may include at least one of an acrylic resin, a methacrylic resin, polyisoprene resin, a vinyl resin, an epoxy resin, a urethane resin, a cellulose resin, a siloxane resin, a polyamide resin, or a perylene resin. In addition, the base layer BL may include a glass substrate, a metal substrate, an organic/inorganic composite material substrate, and/or the like.

At least one inorganic layer is formed on an upper surface of the base layer BL. The inorganic layer may include at least one of aluminum oxide, titanium oxide, silicon oxide, silicon oxynitride, zirconium oxide, or hafnium oxide. The inorganic layer may be formed in multiple layers.

The circuit layer DP_CL is disposed on the base layer BL. FIG. 7A shows the first, fourth, and sixth transistors T1, T4, and T6 of the red pixel driving circuit R_PD shown in FIG. 5C. Referring to FIG. 7A, a blocking layer BML may be disposed on the base layer BL. The blocking layer BML may overlap the first transistor T1 in a thickness direction of the base layer BL. The blocking layer BML may include a metal and may receive a constant voltage. When the constant voltage is applied to the blocking layer BML, a value of the threshold voltage Vth of the first transistor T1 disposed on the blocking layer BML may be maintained without being changed.

In addition, the blocking layer BML may block incident light from outside that propagates toward the first transistor T1 from under the blocking layer BML. For example, the blocking layer BML may include a reflective metal. The blocking layer BML may be omitted.

A buffer layer BFL may be disposed on the base layer BL and the blocking layer BML, and the buffer layer BFL may include an inorganic layer. The buffer layer BFL may cover the blocking layer BML. A semiconductor layer SCP1 (or a semiconductor pattern area, hereinafter referred to as a first semiconductor layer) of the first transistor T1 and a semiconductor layer SCP6 (or a semiconductor pattern area, hereinafter referred to as a sixth semiconductor layer) of the sixth transistor T6 may be disposed on the buffer layer BFL. Hereinafter, the first and sixth semiconductor layers SCP1 and SCP6 may include polysilicon. However, they are not limited thereto, and the first and sixth semiconductor layers SCP1 and SCP6 may include amorphous silicon.

The first and sixth semiconductor layers SCP1 and SCP6 may be formed through the same process, and a partial region of each of the first and sixth semiconductor layers SCP1 and SCP6 may be doped with an N-type dopant or a P-type dopant. The first and sixth semiconductor layers SCP1 and SCP6 may have a high-doping region and a low-doping region. A conductivity of the high-doping region is greater than a conductivity of the low-doping region. The high-doping regions may substantially correspond to the source and the drain of the first and sixth transistors T1 and T6. The low-doping region may substantially correspond to an active region (or a channel) of the first and sixth transistors T1 and T6.

The high-doping region of the first semiconductor layer SCP1 may include a first source region S1 and a first drain region D1. The low-doping region of the first semiconductor layer SCP1 is defined (or referred to) as a first channel region C1 and is disposed between the first source area S1 and the first drain area D1. The sixth semiconductor layer SCP6 may include a sixth source region S6, a sixth channel region C6, and a sixth drain region D6. The first source region S1 is defined (e.g., may be referred to) as a first electrode of the first transistor T1, and the first drain region D1 is defined (e.g., may be referred to) as a second electrode of the first transistor T1. The sixth source region S6 is defined (e.g., may be referred to) as the first electrode of the sixth transistor T6, and the sixth drain region D6 is defined (e.g., may be referred to) as the second electrode of the sixth transistor T6.

Although the first semiconductor layer SCP1 and the sixth semiconductor layer SCP6 are spaced (e.g., spaced apart) from each other in the cross-section of FIG. 7A, the first semiconductor layer SCP1 and the sixth semiconductor layer SCP6 may have an integral shape in a plan view. In other words, the first semiconductor layer SCP1 and the sixth semiconductor layer SCP6 may be different portions or different regions of one semiconductor pattern (e.g., a continuous semiconductor pattern).

A first insulating layer INS1 covering the first and sixth semiconductor layers SCP1 and SCP6 may be disposed on the buffer layer BFL. The third electrodes (or gate electrodes) of the first and sixth transistors T1 and T6 are disposed on the first insulating layer INS1. The gate electrodes of the first and sixth transistors T1 and T6 may be formed through the same process. Hereinafter, the gate electrode of the first transistor T1 is referred to as a first gate electrode G1, and the gate electrode of the sixth transistor T6 is referred to as a sixth gate electrode G6.

A second insulating layer INS2 may be disposed on the first insulating layer INS1 to cover the first and sixth gate electrodes G1 and G6. An upper gate electrode UGE may be disposed on the second insulating layer INS2. The upper gate electrode UGE may be disposed on the first gate electrode G1 and may overlap the first gate electrode G1 in a plan view (i.e., in a thickness direction of the base layer BL). The upper gate electrode UGE may form the capacitor Cst shown in FIG. 4A together with the first gate electrode G1. In other words, the first gate electrode G1 corresponds to one electrode (or one terminal) of the capacitor Cst, and the upper gate electrode UGE corresponds to an opposite electrode (or an opposite terminal) of the capacitor Cst.

A third insulating layer INS3 may be disposed on the second insulating layer INS2 to cover the upper gate electrode UGE. A semiconductor layer SCP4 (or a semiconductor pattern area, hereinafter, referred to as a fourth semiconductor layer) of the fourth transistor T4 may be disposed on the third insulating layer INS3. The fourth semiconductor layer SCP4 may include an oxide semiconductor including a metal oxide. The oxide semiconductor may include a crystalline or amorphous oxide semiconductor.

The fourth semiconductor layer SCP4 may include a plurality of regions divided according to whether the metal oxide is reduced. The region in which the metal oxide is reduced (hereinafter, referred to as a reduced region) has greater conductivity than the region in which the metal oxide is not reduced (hereinafter, referred to as a non-reduced region). The reduced regions may substantially correspond to the source and the drain of the fourth transistor T4. The non-reduced region may substantially correspond to an active region (or a channel) of the fourth transistor T4.

The reduced regions of the fourth semiconductor layer SCP4 may include a fourth source region S4 and a fourth drain region D4. The fourth channel region C4 may be disposed between the fourth source region S4 and the fourth drain region D4. The fourth source region S4 is defined (or may be referred to) as the first electrode of the fourth transistor T4, and the fourth drain region D4 is defined (or may be referred to) as the second electrode of the fourth transistor T4.

A fourth insulating layer INS4 may be disposed on the third insulating layer INS3 to cover the fourth semiconductor layer SCP4. A third electrode (e.g., a fourth gate electrode G4) of the fourth transistor T4 may be disposed on the fourth insulating layer INS4.

A fifth insulating layer INS5 may be disposed on the fourth insulating layer INS4 to cover the fourth gate electrode G4. The buffer layer BFL and the first to fifth insulating layers INS1 to INS5 may include inorganic layers.

Circuit connection electrodes CNE1, CNE2, and CNE3 and the red pixel connection electrode R_CNE may be disposed between the sixth transistor T6 and the red light emitting element ED_R. The circuit connection electrodes CNE1, CNE2, and CNE3 and the red pixel connection electrode R_CNE may electrically connect the sixth transistor T6 and the red light emitting element ED_R. As an example, the circuit connection electrodes CNE1, CNE2, and CNE3 may include a first circuit connection electrode CNE1, a second circuit connection electrode CNE2 disposed on the first circuit connection electrode CNE1, and a third circuit connection electrode CNE3 disposed on the second circuit connection electrode CNE2.

The first circuit connection electrode CNE1 may be disposed on the fifth insulating layer INS5 and may be connected to the sixth drain region D6 through the first contact hole CH1 defined in the first to fifth insulating layers INS1 to INS5. A sixth insulating layer INS6 may be disposed on the fifth insulating layer INS5 to cover the first circuit connection electrode CNE1. The second circuit connection electrode CNE2 may be disposed on the sixth insulating layer INS6. The second circuit connection electrode CNE2 may be connected to the first circuit connection electrode CNE1 through a second contact hole CH2 defined in the sixth insulating layer INS6. A seventh insulating layer INS7 may be disposed on the sixth insulating layer INS6 to cover the second circuit connection electrode CNE2.

The third circuit connection electrode CNE3 may be disposed on the seventh insulating layer INS7. The third circuit connection electrode CNE3 may be connected to the second circuit connection electrode CNE2 through a third contact hole CH3 defined in the seventh insulating layer INS7.

An eighth insulating layer INS8 may be disposed on the seventh insulating layer INS7 to cover the third circuit connection electrode CNE3. The red pixel connection electrode R_CNE may be disposed on the eighth insulating layer INS8. The red pixel connection electrode R_CNE may overlap the circuit connection electrodes CNE1, CNE2, and CNE3 and the red anode electrode R_AE in a plan view (i.e., in a thickness direction of the base layer BL).

The red pixel connection electrode R_CNE is connected to the third circuit connection electrode CNE3 through a first red contact hole R_CH1 defined in the eighth insulating layer INS8. A ninth insulating layer INS9 may be disposed on the eighth insulating layer INS8 and the red pixel connection electrode R_CNE. The sixth to ninth insulating layers INS6 to INS9 may include an inorganic layer and/or an organic layer. Each of the sixth to ninth insulating layers INS6 to INS9 may include an organic layer.

The red light emitting element ED_R is disposed on the ninth insulating layer INS9. The red light emitting element ED_R may include the red anode electrode R_AE, a red cathode electrode R_CE, and a red light emitting layer R_EL. The red cathode electrode R_CE is disposed on the red anode electrode R_AE, and the red light-emitting layer R_EL is disposed between the red anode electrode R_AE and the red cathode electrodes R_CE. As an example, a hole control layer HCL may be further disposed between the red anode electrode R_AE and the red light emitting layer R_EL, and an electron control layer ECL may be further disposed between the red cathode electrode R_CE and the red light emitting layer R_EL.

The red anode electrode R_AE may be disposed on the ninth insulating layer INS9 and may be connected to the red pixel connection electrode R_CNE through a second red contact hole R_CH2 defined in the ninth insulating layer INS9.

A pixel defining layer PDL may be disposed on the ninth insulating layer INS9 to expose a portion (e.g., a predetermined portion) of the red anode electrode R_AE. A pixel opening PDL-OP1 for exposing a portion (e.g., a predetermined portion) of the red anode electrode R_AE may be defined in the pixel defining layer PDL.

The red light emitting layer R_EL may include an organic material and/or an inorganic material. The red light emitting layer R_EL may generate red light.

The hole control layer HCL and the electron control layer ECL may be commonly disposed in the pixels PX (e.g., see FIG. 3). In addition, the red cathode electrode R_CE may be integrally formed with the cathode electrode of the adjacent light emitting element to form a common cathode electrode.

The layers from the buffer layer BFL to the ninth insulating layer INS9 may be defined (or referred to) as the circuit layer DP_CL. The layer on which the red light emitting element ED_R is disposed may be defined (or referred to) as the element layer DP_ED.

The encapsulation layer TFE may be disposed on the element layer DP_ED. The encapsulation layer TFE may include an inorganic layer, an organic layer, and an inorganic layer, which are sequentially stacked. The inorganic layers may include an inorganic material and may protect the pixels PX from moisture/oxygen. The organic layer may include an organic material and may protect the pixels PX from foreign substances such as dust particles.

Referring to FIG. 7B, a semiconductor layer SCP1' (hereinafter, referred to as a first sensing semiconductor layer) of the amplifying transistor ST2 may be formed through the same process as the first semiconductor layer SCP1 of FIG. 7A, and a semiconductor layer SCP2' (hereinafter, referred to as a second sensing semiconductor layer) of the reset transistor ST1 may be formed through the same process as the fourth semiconductor layer SCP4 of FIG. 7A. The first sensing semiconductor layer SCP1' may include a first source region S1', a first drain region D1', and a first channel region C1'. The second sensing semiconductor layer SCP2' may include a second source region S2', a second drain region D2', and a second channel region C2'. The first source region S1' is defined (or may be referred to) as a first electrode of the amplifying transistor ST2, and the first drain region D1' is defined (or may be referred to) as a second electrode of the amplifying transistor ST2. The second source region S2' is defined (or may be referred to) as a first electrode of the reset transistor ST1, and the second drain region D2' is defined (or may be referred to) as a second electrode of the reset transistor ST1.

The stack structure of the amplifying transistor ST2 may be substantially the same as the stack structure of the first transistor T1 shown in FIG. 7A. The stack structure of the reset transistor ST1 may be substantially the same as the stack structure of the fourth transistor T4 shown in FIG. 7A. The stack structure of the output transistor ST3 may be substantially the same as the stack structure of the amplifying transistor ST2.

The circuit connection electrodes CNE1', CNE2', and CNE3' may include a fourth circuit connection electrode CNE1', a fifth circuit connection electrode CNE2', and a sixth circuit connection electrode CNE3'. The fourth circuit connection electrode CNE1' may be disposed on the same layer (e.g., at the same layer) as the first circuit connection electrode CNE1 illustrated in FIG. 7A, and may be connected to the third electrode (i.e., a first gate electrode G1') of the amplifying transistor ST2 through a fourth contact hole CH1'. Hereinafter, the first gate electrode G1' is defined (or may be referred to) as a first sensor gate electrode G1' to be distinguished from the above-described first gate electrode G1.

The fifth circuit connection electrode CNE2' may be disposed on the same layer (e.g., at the same layer) as the second circuit connection electrode CNE2 shown in FIG. 7A, and may be connected to the fourth circuit connection electrode CNE1' through a fifth contact hole CH2' defined in the sixth insulating layer INS6. The sixth circuit connection electrode CNE3' may be disposed on the same layer (e.g., at the same layer) as the third circuit connection electrode CNE3 shown in FIG. 7A, and may be connected to the fifth circuit connection electrode CNE2' through a sixth contact hole CH3'.

The second sensor anode electrode O_AE2 and the sensor connection electrode O_CNE2 are disposed on the ninth insulating layer INS9. The sensor connection electrode O_CNE2 may extend from the second sensor anode electrode O_AE2, and may overlap the fourth to sixth circuit connection electrodes CNE1', CNE2', and CNE3' in a plan view (i.e., in a thickness direction of the base layer BL). The sensor connection electrode O_CNE2 may be connected to the sixth circuit connection electrode CNE3' through the second sensor contact hole O_CH2 defined in the eighth insulating layer INS8 and the ninth insulating layer INS9.

The second light receiving element OPD2 may include a second sensor anode electrode O_AE2, a second sensor cathode electrode O_CE2, and a second photoelectric conversion layer O_RL2. The second sensor anode electrode O_AE2 is formed through the same process as the red anode electrode R_AE shown in FIG. 7A. The second sensor cathode electrode O_CE2 may have an integral shape with the red cathode electrode R_CE shown in FIG. 7A. That is, the second sensor cathode electrode O_CE2 of FIG. 7B and the red cathode electrode R_CE of FIG. 7A may be different regions of the common cathode electrode. The common cathode electrode may be deposited through an open mask to have an integral shape.

A hole control layer HCL' may be disposed between the second sensor anode electrode O_AE2 and the second photoelectric conversion layer O_RL2, and an electron control layer ECL' may be disposed between the second sensor cathode electrode O_CE2 and the second photoelectric conversion layer O_RL2. The hole control layer HCL' and the electron control layer ECL' may be extended from the hole control layer HCL and the electron control layer ECL of FIG. 7A, respectively.

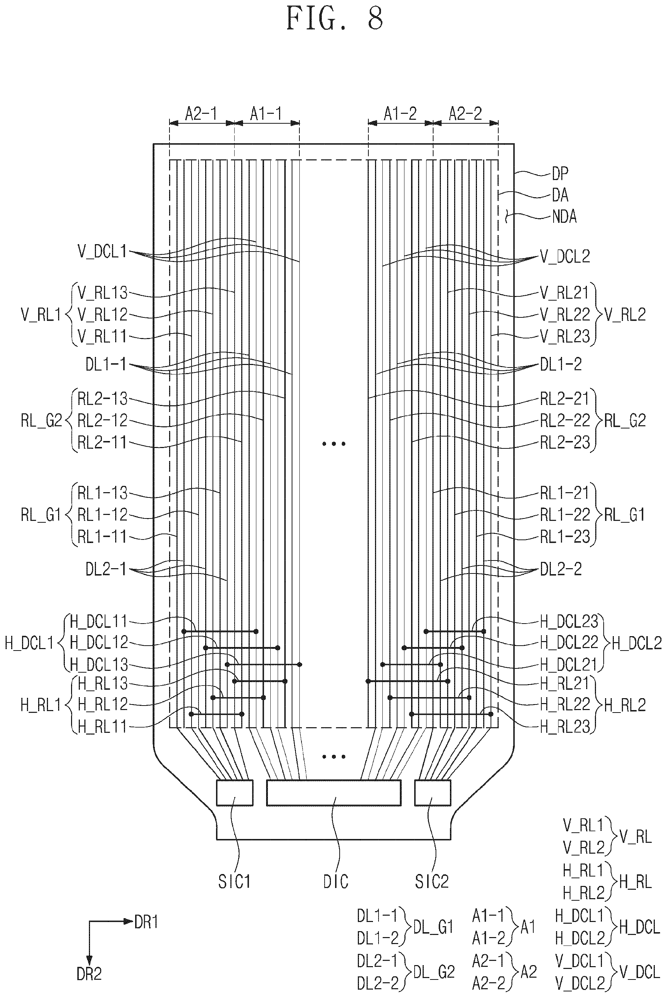

FIG. 8 is a plan view of a display panel.

Referring to FIG. 8, the display panel DP includes a display area DA and a non-display area NDA. A plurality of pixels PX (e.g., see FIG. 3) and a plurality of sensors FX (e.g., see FIG. 3) are disposed in the display area DA. A driving chip DIC and sensor chips SIC1 and SIC2 are mounted in the non-display area NDA.

The data lines DL1 to DLm (e.g., refer to FIG. 3) are connected to the plurality of pixels PX in the display area DA, and are connected to the driving chip DIC in the non-display area NDA. The read-out lines RL1 to RLh (e.g., see FIG. 3) are connected to the plurality of sensors FX in the display area DA and are connected to the sensor chips SIC1 and SIC2 in the non-display area NDA.

The data lines DL1 to DLm may be divided into a first group and a second group. The first group includes a plurality of first data lines DL_G1, and the second group includes a plurality of second data lines DL_G2. The first data lines DL_G1 are arranged in the first direction DR1, and the second data lines DL_G2 are arranged in the first direction DR1. The first data lines DL_G1 are spaced (e.g., spaced apart) from the second data lines DL_G2 in the first direction DR1.

The first data lines DL_G1 are connected to the pixel driving circuit P_PD of a first group of pixels from among the pixels PX, and the second data lines DL_G2 are connected to the pixel driving circuit P_PD of a second group of pixels from among the pixels PX. The first group of pixels and the first data lines DL_G1 are disposed in a first area A1, and the second group of pixels and the second data lines DL_G2 are disposed in a second area A2. The first area A1 includes a first-first area A1-1 defined (or located) at a first side with respect to a center line of the display panel DP parallel to the second direction DR2 and a first-second area A1-2 defined (or located) at a second side with respect to the center line. The second area A2 includes a second-first area A2-1 disposed between the first-first area A1-1 and the non-display area NDA and a second-second area A2-2 disposed between the first-second area A1-2 and the non-display area NDA.

The plurality of first data lines DL_G1 includes first-first data lines DL1-1 disposed in the first-first area A1-1 and first-second data lines DL1-2 disposed in the first-second area A1-2. The plurality of second data lines DL_G2 includes second-first data lines DL2-1 disposed in the second-first area A2-1 and second-second data lines DL2-2 disposed in the second-second area A2-2.

The first-first data lines DL1-1 and the first-second data lines DL1-2 may be connected to the driving chip DIC. Although FIG. 8 by way of example illustrates that the first-first data lines DL1-1 and the first-second data lines DL1-2 are connected to the same driving chip DIC, the arrangement is not limited thereto. For example, the first-first data lines DL1-1 and the first-second data lines DL1-2 may be connected to different driving chips, respectively.

The display panel DP further includes data connection lines connecting the second data lines DL_G2 to the driving chip DIC. The data connection lines include a plurality of vertical data connection lines V_DCL extending along the first data lines DL_G1 and a plurality of horizontal data connection lines H_DCL extending along the first direction DR1.

The horizontal data connection lines H_DCL include first horizontal data connection lines H_DCL1 (that is, H_DCL11 to H_DCL13) and second horizontal data connection lines H_DCL2 (that is, H_DCL21 to H_DCL23). The first horizontal data connection lines H_DCL11 to H_DCL13 are connected to second-first data lines DL2-1, and the second horizontal data connection lines H_DCL21 to H_DCL23 are connected to second-second data lines DL2-2. The plurality of vertical data connection lines V_DCL may include first vertical data connection lines V_DCL1 and second vertical data connection lines V_DCL2. The first vertical data connection lines V_DCL1 are connected to the first horizontal data connection lines H_DCL11 to H_DCL13, and the second vertical data connection lines V_DCL2 are connected to the second horizontal data connection lines H_DCL21 to H_DCL23.

Accordingly, the first vertical data connection lines V_DCL1 are electrically connected to the second-first data lines DL2-1 by the first horizontal data connection lines H_DCL11 to H_DCL13. The second vertical data connection lines V_DCL2 are electrically connected to the second-second data lines DL2-2 through the second horizontal data connection lines H_DCL21 to H_DCL23.

The first vertical data connection lines V_DCL1 and the first-first data lines DL1-1 are alternately and repeatedly arranged in the first-first area A1-1. The second vertical data connection lines V_DCL2 and the first-second data lines DL1-2 are alternately and repeatedly arranged in the first-second area A1-2.

A portion of the vertical data connection lines V_DCL and the plurality of horizontal data connection lines H_DCL may be disposed in the display area DA. That is, a portion of the data connection lines for connecting the second data lines DL_G2 and the driving chip DIC is disposed in the display area DA. Accordingly, the area of the area occupied by the data connection lines in the non-display area NDA may be reduced, and as a result, the area of the dead space of the display panel DP may be reduced.

The read-out lines RL1 to RLh may be divided into a first group and a second group. The first group includes a plurality of first read-out lines RL_G1, and the second group includes a plurality of second read-out lines RL_G2. The plurality of first read-out lines RL_G1 is arranged in the first direction DR1, and the plurality of second read-out lines RL_G2 is arranged in the first direction DR1. The first read-out lines RL_G1 are spaced (e.g., spaced apart) from the second read-out lines RL_G2 in the first direction DR1.

The plurality of first read-out lines RL_G1 is connected to sensor driving circuits O_SD of sensors belonging to a first group from among the plurality of sensors FX, and the plurality of second read-out lines RL_G2 is connected to sensor driving circuits O_SD of sensors belonging to a second group from among the plurality of sensors FX. The first group of sensors and the first read-out lines RL_G1 are disposed in the second area A2, and the second group of sensors and the second read-out lines RL_G2 are disposed in the first area A1.

The plurality of first read-out lines RL_G1 includes first-first read-out lines RL1-11 to RL1-13 and first-second read-out lines RL1-21 to RL1-23. The first-first read-out lines RL1-11 to RL1-13 may be disposed in the second-first area A2-1 and may be connected to the first sensor chip SIC1. The first-second read-out lines RL1-21 to RL1-23 may be disposed in the second-second area A2-2 and may be connected to the second sensor chip SIC2.

The plurality of second read-out lines RL_G2 may include second-first read-out lines RL2-11 to RL2-13 and second-second read-out lines RL2-21 to RL2-23. The second-first read-out lines RL2-11 to RL2-13 may be disposed in the first-first area A1-1 and may be electrically connected to the first sensor chip SIC1. The second-second read-out lines RL2-21 to RL2-23 may be disposed in the first-second area A1-2 and may be electrically connected to the second sensor chip SIC2. The plurality of second read-out lines RL_G2 may be disposed between the first-first read-out lines RL1-11 to RL1-13 and first-second read-out lines RL1-21 to RL1-23.

The display panel DP further includes connection lines electrically connected to the second read-out lines RL_G2. The connection lines include a plurality of vertical connection lines V_RL extending along the first read-out lines RL_G1 and a plurality of horizontal connection lines H_RL extending in the first direction DR1. The vertical connection lines V_RL may include first vertical connection lines V_RL1 (that is, V_RL11 to V_RL13) electrically connected to the first sensor chip SIC1 and second vertical connection lines V_RL2 (that is, V_RL11 to V_RL13) electrically connected to the second sensor chip SIC2.

The first vertical connection lines V_RL1 and the first-first read-out lines RL1-11 to RL1-13 may be alternately and repeatedly arranged one by one in the first direction DR1. The second vertical connection lines V_RL2 and the first-second read-out lines RL1-21 to RL1-23 may be alternately and repeatedly arranged one by one in the first direction DR1.

The horizontal connection lines H_RL may electrically connect the vertical connection lines V_RL to the second read-out lines RL_G2. The horizontal connection lines H_RL include first horizontal connection lines H_RL1 connecting the first vertical connection lines V_RL1 to the second-first read-out lines RL2-11 to RL2-13, respectively, and second horizontal connection lines H_RL2 connecting the second vertical connection lines V_RL2 to the second-second read-out lines RL2-21 to RL2-23, respectively.

A portion of the vertical connection lines V_RL and the plurality of horizontal connection lines H_RL may be disposed in the display area DA. That is, a portion of the connection lines for connecting the second read-out lines RL_G2 and the first and second sensor chips SIC1 and SIC2 are disposed in the display area DA. Accordingly, the area occupied by the connection lines in the non-display area NDA may be reduced, and as a result, the area of a dead space of the display panel DP may be reduced.

Even if the first or second sensor chip SIC1 or SIC2 were disposed adjacent to the driving chip DIC, when the second read-out lines RL_G2 are connected to the first or second sensor chip SIC1 or SIC2 through the connection lines and the second data lines DL_G2 are connected to the driving chip DIC through the data connection lines, the read-out lines and the data lines might not cross each other in the non-display area NDA. Accordingly, the coupling capacitance between the read-out lines and the data lines may be reduced, and as a result, the sensing accuracy of the sensor FX may be improved.

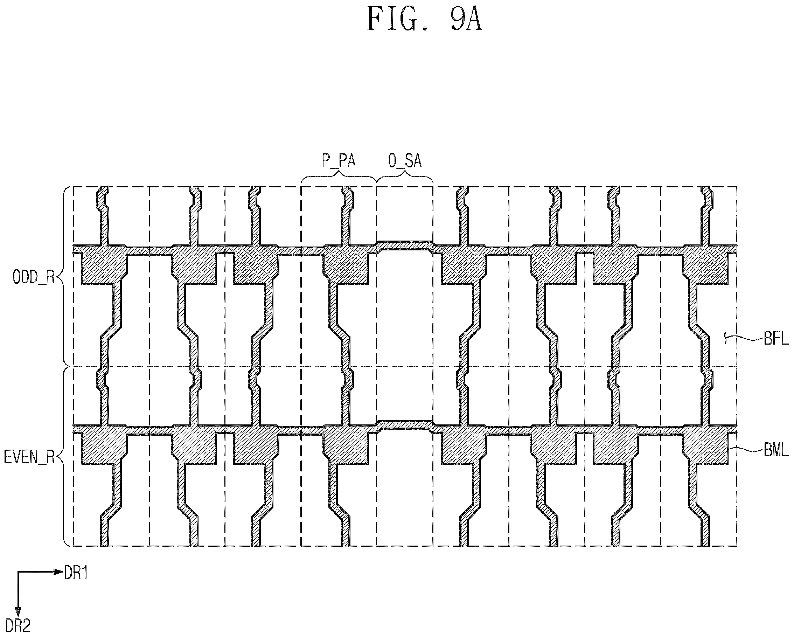

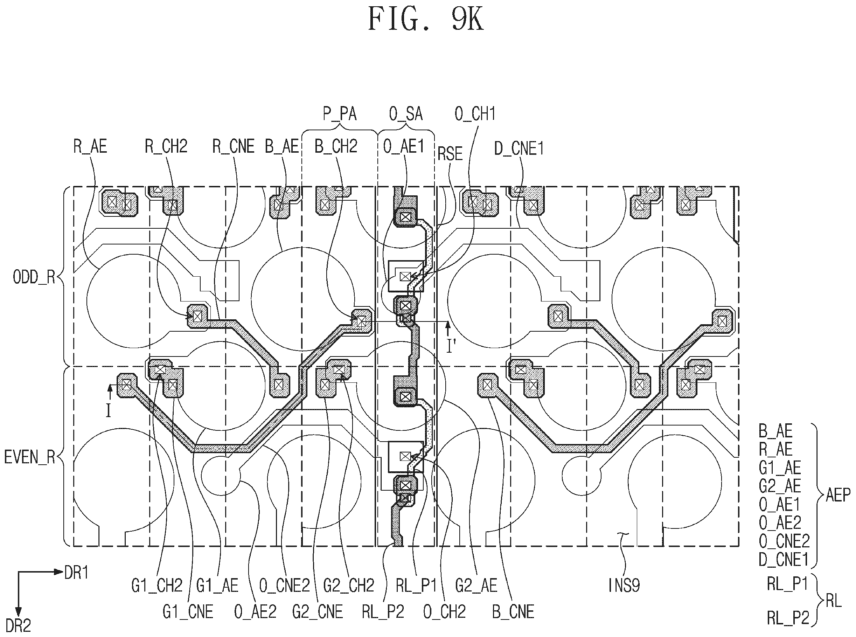

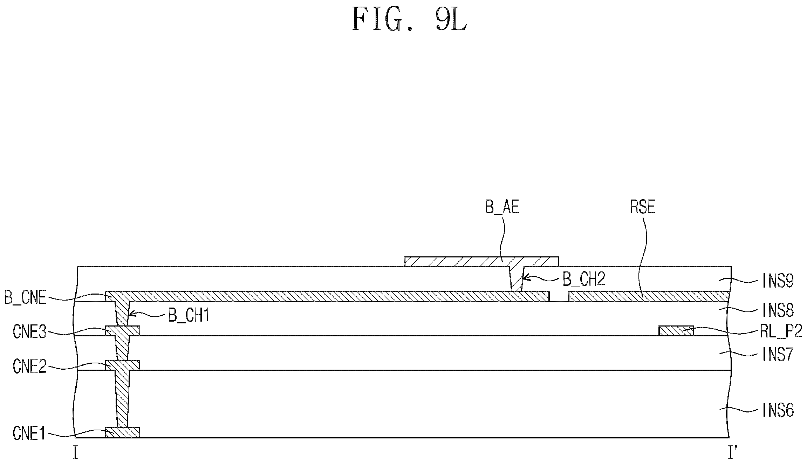

FIGS. 9A to 9K are plan views illustrating a stacked structure of a circuit layer and an element layer. FIG. 9L is a cross-sectional view taken along the line I - I ' illustrated in FIG. 9K.

Referring to FIGS. 9A to 9K, each of the conductive patterns and the semiconductor patterns may have a structure in which the conductive patterns and the semiconductor patterns are repeatedly arranged according to a rule (e.g., according to a predetermined rule) in a plan view. In FIGS. 9A to 9K, some of the pixel driving circuits P_PD (e.g., see FIG. 4A) and some of the sensor driving circuits O_SD (e.g., see FIG. 4A) disposed in the first row ODD_R, and some of the pixel driving circuits P_PD and some of the sensor driving circuits O_SD disposed in the second row EVEN_R are illustrated. The first row ODD_R and the second row EVEN_R are adjacent to each other in the second direction DR2. In the first row ODD_R, eight first circuit areas P_PA (or pixel circuit areas) corresponding to eight pixel driving circuits P_PD adjacent to each other in the first direction DR1 and a second circuit area O_SA (or a sensor circuit area) corresponding to one sensor driving circuit O_SD are defined. In the second row EVEN_R, the eight first circuit areas P_PA corresponding to eight pixel driving circuits P_PD adjacent to each other in the first direction DR1 and the second circuit area O_SA corresponding to one sensor driving circuit O_SD are defined. In FIGS. 9A to 9K, a boundary between the first and second circuit areas P_PA and O_SA is illustrated by a dotted line.

Referring to FIG. 9A, the blocking layer BML may be formed on the buffer layer BFL. The blocking layer BML may be a conductive pattern having a light blocking function. The blocking layer BML may be disposed under at least one of the transistors T1 to T8 (e.g., see FIG. 4A) provided in each of the first circuit areas P_PA to block light incident on the transistors T1 to T8 from the outside.

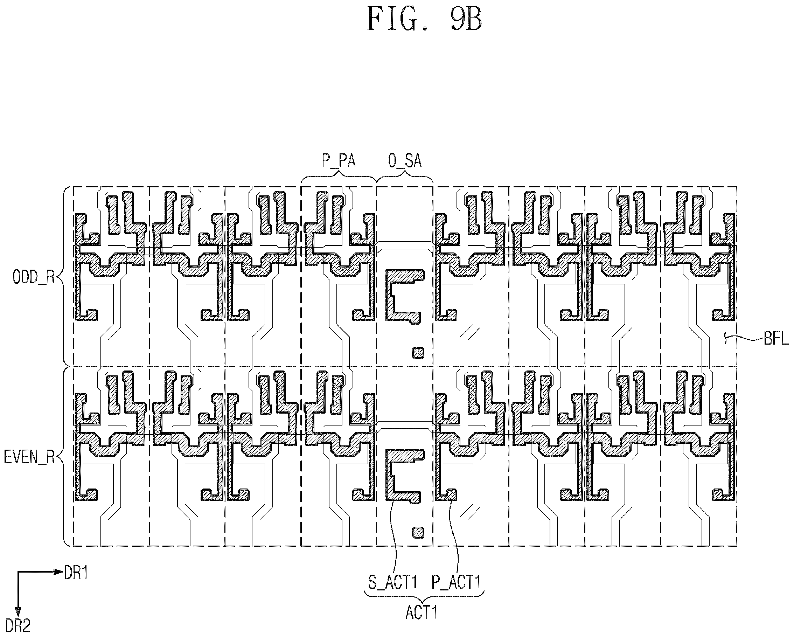

Referring to FIGS. 9A and 9B, a first semiconductor pattern layer ACT1 may be disposed on the blocking layer BML and the buffer layer BFL. The first semiconductor pattern layer ACT1 may overlap the blocking layer BML on the buffer layer BFL. The first semiconductor pattern layer ACT1 may include a silicon semiconductor. For example, the silicon semiconductor may include amorphous silicon, polycrystalline silicon, and/or the like. For example, the first semiconductor pattern layer ACT1 may include low-temperature polysilicon (LTPS).

The first semiconductor pattern layer ACT1 includes a first semiconductor pattern P_ACT1 disposed in each of the first circuit areas P_PA and a second semiconductor pattern S_ACT1 disposed in each of the second circuit areas O_SA.

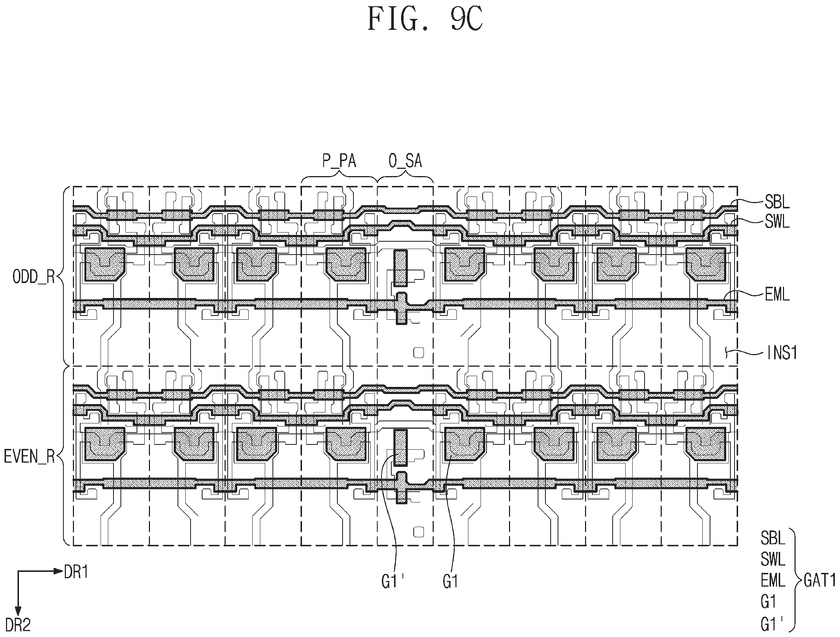

Referring to FIG. 9C, a first gate pattern layer GAT1 may be disposed on the first insulating layer INS1. The first gate pattern layer GAT1 may include a metal, an alloy, a conductive metal oxide, a transparent conductive material, and/or the like. For example, the first gate pattern layer GAT1 may include silver (Ag), an alloy containing silver, molybdenum (Mo), an alloy containing molybdenum, aluminum (Al), an alloy containing aluminum, aluminum nitride (AIN), tungsten (W), tungsten nitride (WN), copper (Cu), indium tin oxide (ITO), indium zinc oxide (IZO), and/or the like, but is not particularly limited thereto.

The first gate pattern layer GAT1 may include a first gate wiring SBL, a second gate wiring EML, a third gate wiring SWL, a first gate electrode G1, and a first sensor gate electrode G1'.

Each of the first to third gate wirings SBL, EML, and SWL may extend in the first direction DR1. The first gate wiring SBL corresponds to the j-th black scan line SBLj of FIG. 4A. For example, the j-th black scan signal SBj (e.g., see FIG. 4A) may be provided to the first gate wiring SBL. The first gate wiring SBL may constitute the seventh transistor T7 of FIG. 4A together with the first semiconductor pattern P_ACT1.

The second gate wiring EML corresponds to the j-th emission control line EMLj of FIG. 4A. For example, the j-th emission control signal EMj (e.g., refer to FIG. 4A) may be provided to the second gate wiring EML. The second gate wiring EML may constitute the fifth and sixth transistors T5 and T6 of FIG. 4A together with the first semiconductor pattern P_ACT1.

The third gate wiring SWL corresponds to the j-th write scan line SWLj of FIG. 4A. For example, the j-th write scan signal SWj (e.g., see FIG. 4A) may be provided to the third gate wiring SWL. The third gate wiring SWL may constitute the second transistor T2 of FIG. 4A together with the first semiconductor pattern P_ACT1, and may constitute the output transistor ST3 of FIG. 4A together with the second semiconductor pattern S_ACT1.

The first gate electrode G1 and the first sensor gate electrode G1' may be disposed in an island shape. The first gate electrode G1 may constitute the first transistor T1 of FIG. 4A together with the first semiconductor pattern P_ACT1. The first gate electrode G1 may correspond to the first gate electrode G1 of the first transistor T1 shown in FIG. 7A. The first sensor gate electrode G1' may constitute the amplifying transistor ST2 of FIG. 4A together with the second semiconductor pattern S_ACT1.

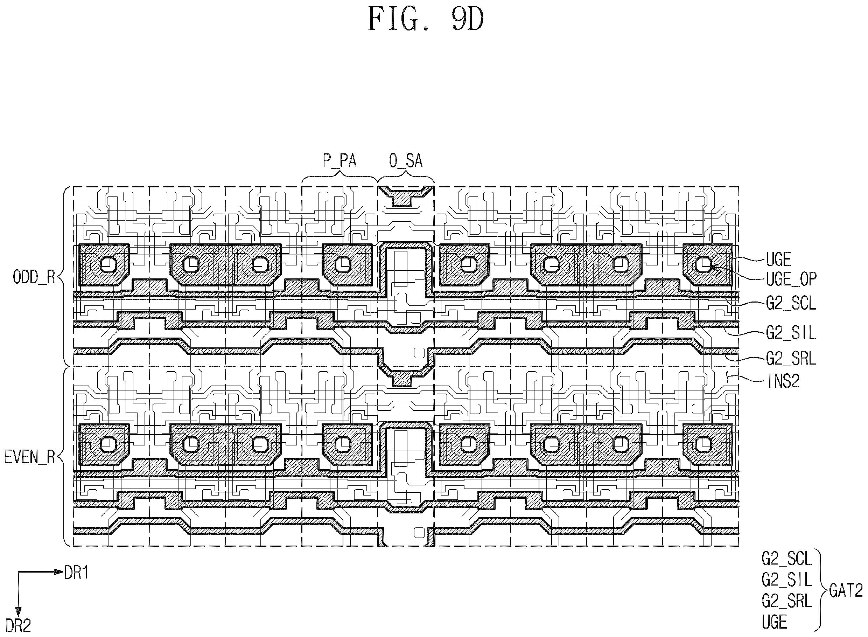

Referring to FIGS. 9C and 9D, the second insulating layer INS2 may cover the first gate pattern layer GAT1 and may be disposed on the first insulating layer INS1. A second gate pattern layer GAT2 may be disposed on the second insulating layer INS2. The second gate pattern layer GAT2 may include a metal, an alloy, a conductive metal oxide, a transparent conductive material, and/or the like.

The second gate pattern layer GAT2 may include a fourth gate wiring G2_SRL, a fifth gate wiring G2_SCL, a sixth gate wiring G2_SIL, and an upper gate electrode UGE.

The fourth to sixth gate wirings G2_SRL, G2_SCL and G2_SIL may extend in the first direction DR1. The fourth gate wiring G2_SRL corresponds to (or includes) the reset control line SRL (e.g., see FIG. 4A). The fifth gate wiring G2_SCL may correspond to (or may include) the j-th compensation scan line SCLj (e.g., see FIG. 4A). The sixth gate wiring G2_SIL may correspond to (or may include) the j-th initialization scan line SILj (e.g., see FIG. 4A).

The upper gate electrode UGE may overlap the first gate electrode G1 and may be disposed in an island shape. For example, the upper gate electrode UGE may constitute the capacitor Cst (e.g., see FIG. 4A) together with the first gate electrode G1. The upper gate electrode UGE may correspond to the upper gate electrode UGE shown in FIG. 7A. An opening UGE_OP penetrating the upper gate electrode UGE may be formed in the upper gate electrode UGE, and the first gate electrode G1 may be partially exposed through the opening UGE_OP.

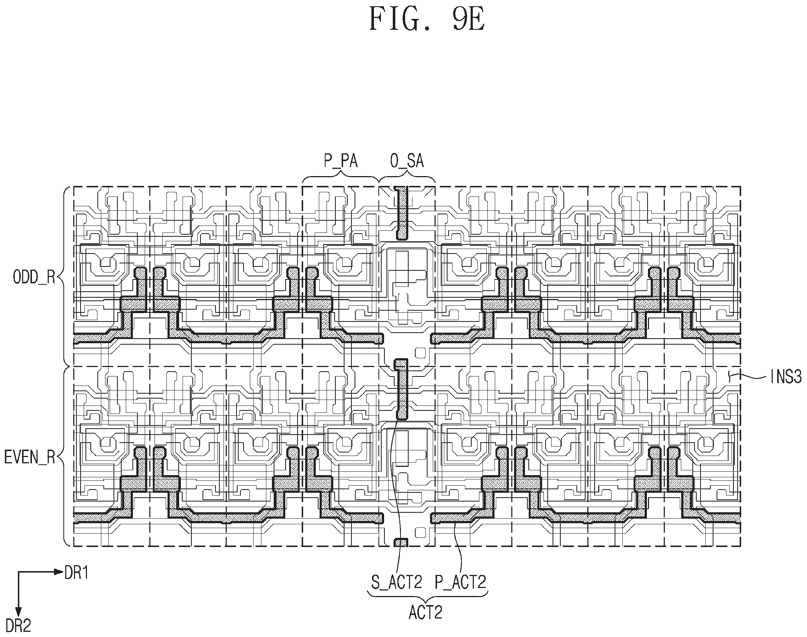

Referring to FIGS. 9D and 9E, the third insulating layer INS3 may cover the second gate pattern layer GAT2 and may be disposed on the second insulating layer INS2. A second semiconductor pattern layer ACT2 may be disposed on the third insulating layer INS3. The second semiconductor pattern layer ACT2 may include an oxide semiconductor. The second semiconductor pattern layer ACT2 may be disposed on a different layer (e.g., may be located at a different layer) from the first semiconductor pattern layer ACT1 and may not overlap the first semiconductor pattern layer ACT1.

The second semiconductor pattern layer ACT2 includes a third semiconductor pattern P_ACT2 disposed in each of the first circuit areas P_PA and a fourth semiconductor pattern S_ACT2 disposed in each of the second circuit areas O_SA.

Referring to FIGS. 9E to 9G, the fourth insulating layer INS4 may cover the second semiconductor pattern layer ACT2 and may be disposed on the third insulating layer INS3. A third gate pattern layer GAT3 may be disposed on the fourth insulating layer INS4. The third gate pattern layer GAT3 may include a metal, an alloy, a conductive metal oxide, a transparent conductive material, and/ or the like.

The third gate pattern layer GAT3 may include a seventh gate wiring G3_SRL, an eighth gate wiring G3_SCL, a ninth gate wiring G3_SIL, a second-first horizontal initialization voltage line H_VAIL1, a second-second horizontal initialization voltage line H_VAIL2, and a first horizontal reset voltage line G3_VRL. The second-first horizontal initialization voltage line H_VAIL1 and the second-second horizontal initialization voltage line H_VAIL2 may be referred to as a second horizontal initialization voltage line.

The seventh to ninth gate wirings G3_SRL, G3_SCL and G3_SIL may extend in the first direction DR1. The seventh gate wiring G3_SRL may overlap the fourth semiconductor pattern S_ACT2. The seventh gate wiring G3_SRL may form the reset transistor ST1 of FIG. 4A together with the fourth semiconductor pattern S_ACT2. The seventh gate wiring G3_SRL may be electrically connected to the fourth gate wiring G2_SRL shown in FIG. 9D.

The eighth gate wiring G3_SCL may overlap the fifth gate wiring G2_SCL and the third semiconductor pattern P_ACT2. The eighth gate wiring G3_SCL may contact the fifth gate wiring G2_SCL through a contact portion. Therefore, the j-th compensation scan signal SCj applied to the fifth gate wiring G2_SCL may be provided to the eighth gate wiring G3_SCL. The fifth gate wiring G2_SCL, the third semiconductor pattern P_ACT2, and the eighth gate wiring G3_SCL may constitute the third transistor T3 of FIG. 4A.

The ninth gate wiring G3_SIL may overlap the sixth gate wiring G2_SIL and the third semiconductor pattern P_ACT2. The ninth gate wiring G3_SIL may be electrically connected to the sixth gate wiring G2_SIL. The j-th initialization scan signal SIj may be provided to the ninth gate wiring G3_SIL through the sixth gate wiring G2_SIL. The sixth gate wiring G2_SIL, the third semiconductor pattern P_ACT2, and the ninth gate wiring G3_SIL may constitute the fourth transistor T4 of FIG. 4A.

The second-first horizontal initialization voltage line H_VAIL1 and the second-second horizontal initialization voltage line H_VAIL2 may be included in the second initialization voltage line VAIL (e.g., see FIG. 4A). The second-first horizontal initialization voltage line H_VAIL1 is connected to a first color pixel (e.g., a red pixel) from among the plurality of pixels PX shown in FIG. 3, and the second-second horizontal initialization voltage line H_VAIL2 is connected to a second or third color pixel (a blue or green pixel) different from the first color pixel from among the plurality of pixels PX.

The second-first horizontal initialization voltage line H_VAIL1 applies the second-first horizontal initialization voltage to the first color pixel as the second initialization voltage Vaint (e.g., see FIG. 4A), and the second-second horizontal initialization voltage line H_VAIL2 applies the second-second initialization voltage to the second or third color pixel as the second initialization voltage Vaint. The second-second initialization voltage may have a voltage level different from that of the second-first initialization voltage.

The first horizontal reset voltage line G3_VRL may be included in the reset voltage line VRL of FIG. 4A. The reset voltage Vrst (e.g., see FIG. 4A) may be provided to the first horizontal reset voltage line G3_VRL. The first horizontal reset voltage line G3_VRL may be electrically connected to the reset transistor ST1. The reset transistor ST1 may receive the reset voltage Vrst through the first horizontal reset voltage line G3_VRL.

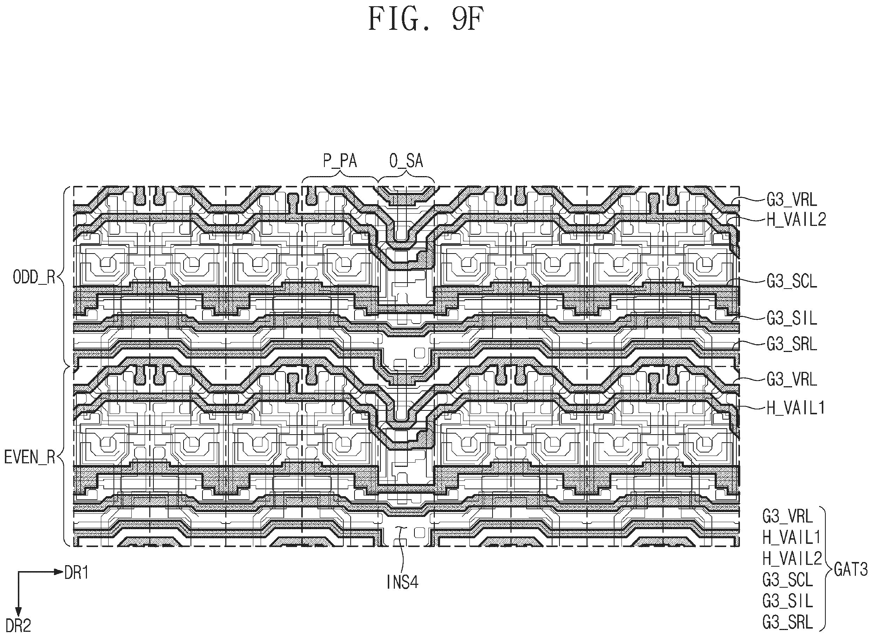

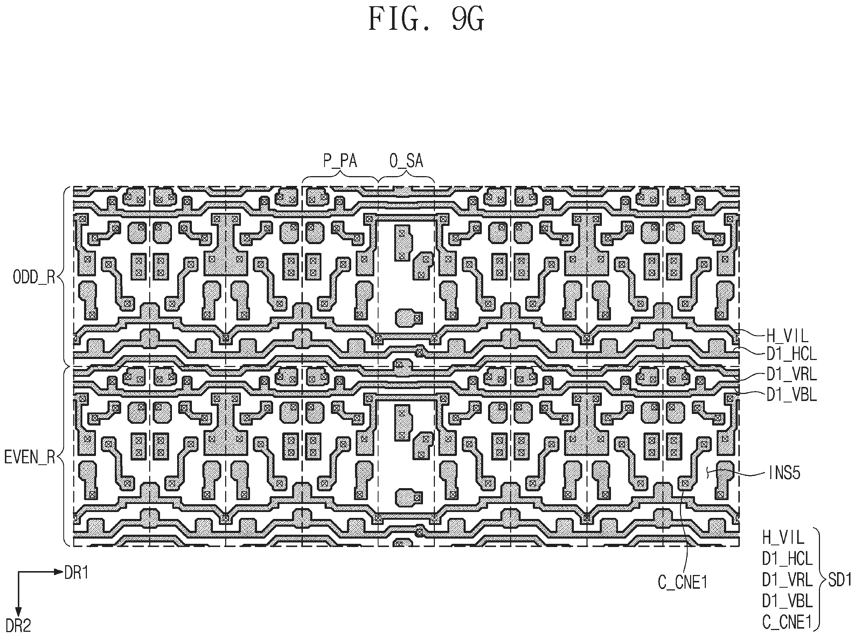

Referring to FIGS. 9F and 9G, the fifth insulating layer INS5 may cover at least a portion of the third gate pattern layer GAT3 and may be disposed on the fourth insulating layer INS4. A first data pattern layer SD1 may be disposed on the fifth insulating layer INS5. The first data pattern layer SD1 may include, for example, a metal, an alloy, a conductive metal oxide, a transparent conductive material, and/or the like. Hereinafter, for convenience of description, only some of the components included in the first data pattern layer SD1 are illustrated in FIG. 9G.

The first data pattern layer SD1 may include a second horizontal reset voltage line D1_VRL, a bias voltage line D1_VBL, a first horizontal initialization voltage line H_VIL, and a plurality of first connection electrode patterns C_CNE1.

The second horizontal reset voltage line D1_VRL, the bias voltage line D1_VBL, and the first horizontal initialization voltage line H_VIL may extend in the first direction DR1. The second horizontal reset voltage line D1_VRL, the bias voltage line D1_VBL, and the first horizontal initialization voltage line H_VIL may be spaced (e.g., spaced apart) from each other in the second direction DR2.

The second horizontal reset voltage line D1_VRL may be included in the reset voltage line VRL of FIG. 4A. The reset voltage Vrst (e.g., see FIG. 4A) may be provided to the second horizontal reset voltage line D1_VRL. The second horizontal reset voltage line D1_VRL may be electrically connected to the first horizontal reset voltage line G3_VRL. The bias voltage line D1_VBL may correspond to the bias voltage line VBL of FIG. 4A. The bias voltage Vbias (e.g., refer to FIG. 4A) may be provided to the bias voltage line D1_VBL. The bias voltage line D1_VBL may be connected to the eighth transistor T8 through a contact portion. The eighth transistor T8 may receive the bias voltage Vbias through the bias voltage line D1_VBL.

The first horizontal initialization voltage line H_VIL may be included in the first initialization voltage line VIL of FIG. 4A. The first initialization voltage Vint (e.g., refer to FIG. 4A) may be provided to the first horizontal initialization voltage line H_VIL. The first horizontal initialization voltage line H_VIL may be connected to the fourth transistor T4 through a contact portion. The fourth transistor T4 may receive the first initialization voltage Vint through the first horizontal initialization voltage line H_VIL.

The plurality of first connection electrode patterns C_CNE1 may contact one of the first to fourth semiconductor patterns P_ACT1, S_ACT1, P_ACT2, and S_ACT2. The plurality of first connection electrode patterns C_CNE1 may perform a function of electrically connecting one of the first to fourth semiconductor patterns P_ACT1, S_ACT1, P_ACT2, and S_ACT2 to other wirings or other lines. The plurality of first connection electrode patterns C_CNE1 may be connected to one of the first to fourth semiconductor patterns P_ACT1, S_ACT1, P_ACT2, and S_ACT2 through the contact portion. The plurality of first connection electrode patterns C_CNE1 may include the first and fourth circuit connection electrodes CNE1 and CNE1' shown in FIGS. 7A and 7B.

The first data pattern layer SD1 may further include a horizontal connection wiring D1_HCL. The horizontal connection wiring D1_HCL may extend in the first direction DR1. The horizontal connection wiring D1_HCL may be used as the horizontal data connection lines H_DCL shown in FIG. 8 or the horizontal connection lines H_RL shown in FIG. 8.

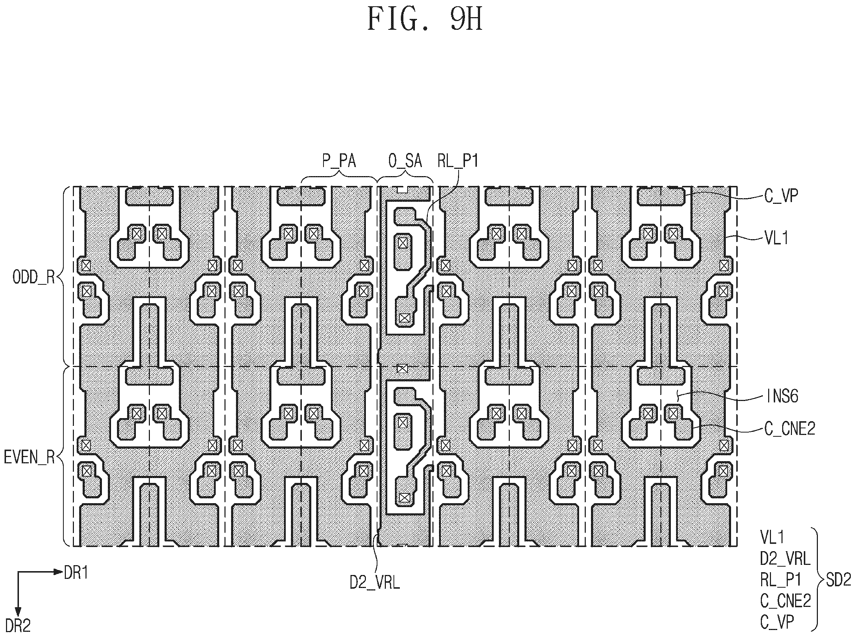

Referring to FIGS. 9G and 9H, the sixth insulating layer INS6 may cover at least a portion of the first data pattern layer SD1 and may be disposed on the fifth insulating layer INS5. A second data pattern layer SD2 may be disposed on the sixth insulating layer INS6. The second data pattern layer SD2 may include, for example, a metal, an alloy, a conductive metal oxide, a transparent conductive material, and/or the like.

The second data pattern layer SD2 includes a first read-out line portion RL_P1, first vertical reset voltage lines D2_VRL, a first driving voltage line VL1, and a plurality of voltage connection patterns C_VP.

The first read-out line portion RL_P1 extends in the second direction DR2 in each of the second circuit areas O_SA. That is, the first read-out line portion RL_P1 may overlap the corresponding one second circuit area O_SA. The first read-out line portion RL_P1 may be a portion of each of the read-out lines RL1 to RLh shown in FIG. 3. The first read-out line portion RL_P1 may be connected to the sensor driving circuit O_SD (particularly, the output transistor ST3) shown in FIG. 4A.

The first vertical reset voltage lines D2_VRL extend in the second direction DR2 and are disposed to be spaced (e.g., spaced apart) from each other in the first direction DR1. The first vertical reset voltages line D2_VRL may be included in the reset voltage line VRL of FIG. 4A. The first vertical reset voltage lines D2_VRL may be connected to the first and second horizontal reset voltage lines G3_VRL and D1_VRL. The reset voltage line VRL may have a mesh shape by coupling the first vertical reset voltage lines D2_VRL and the first and second horizontal reset voltage lines G3_VRL and D1_VRL.

The first driving voltage line VL1 may overlap the first circuit areas P_PA. The first driving voltage line VL1 may correspond to the first driving voltage line VL1 of FIG. 4A. The first driving voltage ELVDD (e.g., refer to FIG. 4A) may be provided to the first driving voltage line VL1. The first driving voltage line VL1 may be disposed in the display area DA (e.g., see FIG. 3) of the display panel DP in a mesh form. The first driving voltage line VL1 may be connected to the fifth transistor T5 and the capacitor Cst shown in FIG. 4A through a contact portion.

The plurality of voltage connection patterns C_VP may be connected to vertical voltage lines V_VL to be described later.

The second data pattern layer SD2 may further include a plurality of second connection electrode patterns C_CNE2. The plurality of second connection electrode patterns C_CNE2 may include the second and fifth circuit connection electrodes CNE2 and CNE2' shown in FIGS. 7A and 7B.

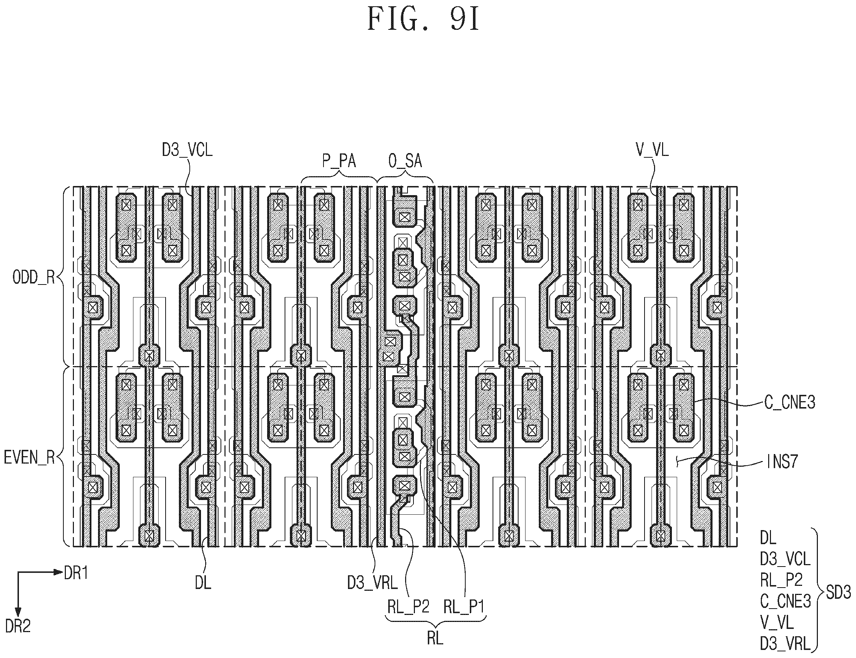

Referring to FIGS. 9H and 9I, the seventh insulating layer INS7 may cover at least a portion of the second data pattern layer SD2 and may be disposed on the sixth insulating layer INS6. A third data pattern layer SD3 may be disposed on the seventh insulating layer INS7. The third data pattern layer SD3 may include, for example, a metal, an alloy, a conductive metal oxide, a transparent conductive material, and/or the like.

The third data pattern layer SD3 may include a data wiring DL, a second read-out line portion RL_P2, a vertical connection wiring D3_VCL, a vertical voltage line V_VL, second vertical reset voltage lines D3_VRL and a plurality of third connection electrode patterns C_CNE3.

The data wiring DL, the vertical connection wiring D3_VCL, and the vertical voltage lines V_VL may extend in the second direction DR2. The data wiring DL, the vertical connection wiring D3_VCL, and the vertical voltage lines V_VL may be spaced (e.g., spaced apart) from each other in the first direction DR1.

The data wiring DL may correspond to the data lines DL1 to DLm shown in FIG. 3. The data wiring DL may be connected to the pixel driving circuit P_PD (in particular, the second transistor T2) shown in FIG. 4A. The vertical connection wiring D3_VCL may be used as the vertical data connection lines V_DCL shown in FIG. 8 or the vertical connection lines V_RL shown in FIG. 8. The vertical connection wiring D3_VCL may be electrically connected to the horizontal connection wiring D1_HCL shown in FIG. 9G.

The second read-out line portion RL_P2 may overlap two second circuit areas O_SA adjacent to each other. The second read-out line portion RL_P2 may be connected to two adjacent first read-out line portions RL_P1, respectively. Accordingly, one read-out wiring RL may include a plurality of first and second read-out line portions RL_P1 and RL_P2. The read-out wiring RL may correspond to one of the read-out lines RL1 to RLh shown in FIG. 3.

One of the vertical voltage lines V_VL may be electrically connected to the second-first horizontal initialization voltage line H_VAIL1 shown in FIG. 9F through a corresponding voltage connection pattern C_VP (e.g., see FIG. 9H), and the other of the vertical voltage lines V_VL may be electrically connected to the second-second horizontal initialization voltage line H_VAIL2 shown in FIG. 9F through a corresponding voltage connection pattern C_VP. That is, some of the vertical voltage lines V_VL may be utilized as the second initialization voltage line VAIL (e.g., see FIG. 4A). In addition, another of the vertical voltage lines V_VL may be electrically connected to the first horizontal initialization voltage line H_VIL shown in FIG. 9G through a corresponding voltage connection pattern C_VP (e.g., see FIG. 9H) to be utilized as the first initialization voltage line VIL (e.g., see FIG. 4A).

Another of the vertical voltage lines V_VL may be utilized as the second driving voltage line VL2 of FIG. 4A. As described above, the vertical voltage lines V_VL may be used as different voltage lines connected to the pixels PX (e.g., see FIG. 3) and the sensors FX (e.g., see FIG. 3), and thus, a voltage drop phenomenon of a voltage applied to each voltage line may be alleviated.

The plurality of third connection electrode patterns C_CNE3 may include the third circuit connection electrode CNE3 and the sixth circuit connection electrode CNE3' shown in FIGS. 7A and 7B.

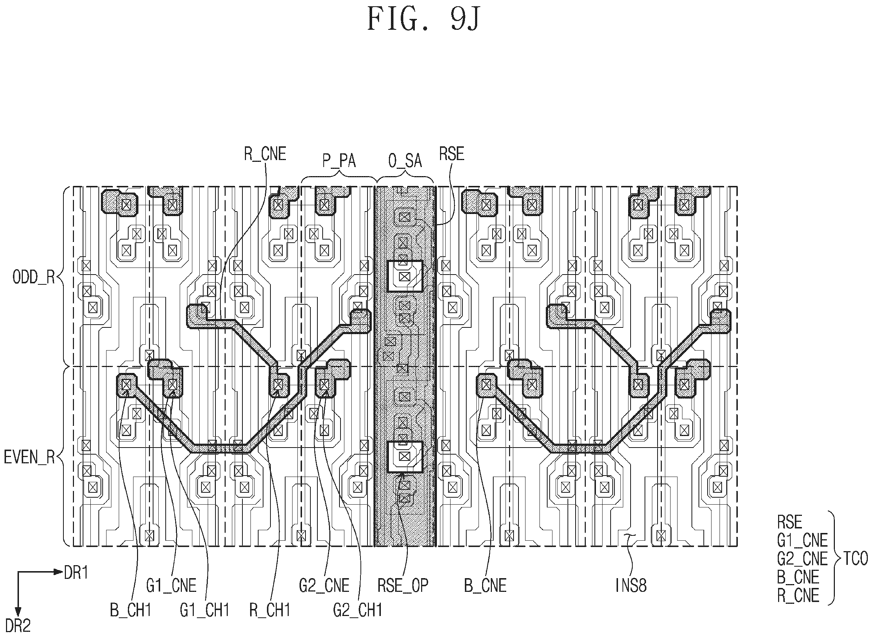

Referring to FIGS. 9I and 9J, the eighth insulating layer INS8 may cover at least a portion of the third data pattern layer SD3 and may be disposed on the seventh insulating layer INS7. A conductive pattern TCO may be disposed on the eighth insulating layer INS8. The conductive pattern TCO may include a transparent conductive oxide. Alternatively, the conductive pattern TCO may include a metal, an alloy, a conductive metal oxide, a transparent conductive material, and/or the like.

The conductive pattern TCO may include a shielding electrode RSE and a plurality of pixel connection electrodes G1_CNE, G2_CNE, R_CNE, and B_CNE. As an example, the shielding electrode RSE may extend in the second direction DR2 and may overlap the read-out wiring RL in a plan view. The shielding electrode RSE may contact the first vertical reset voltage lines D2_VRL through a contact portion. Accordingly, the reset voltage Vrst (e.g., see FIG. 4A) applied to the first vertical reset voltage lines D2_VRL may be applied to the shielding electrode RSE.

The shielding electrode RSE may be disposed to partially cover the sensor driving circuit O_SD in each of the second circuit areas O_SA. In particular, the shielding electrode RSE may be disposed to cover all or a part of the reset transistor ST1 (e.g., see FIG. 4A), the amplifying transistor ST2, and the output transistor ST3. An opening RSE_OP may be provided in the shielding electrode RSE to partially expose the sensor driving circuit O_SD.

The shielding electrode RSE may perform a function of shielding the sensing signal output from the read-out wiring RL so as not to be coupled by the data signal applied to the data wiring DL. In order to prevent or substantially prevent the shielding performance from being deteriorated, the opening RSE_OP may be provided at a position not overlapping the read-out wiring RL in a plan view.

The plurality of pixel connection electrodes G1_CNE, G2_CNE, R_CNE, and B_CNE includes first and second green pixel connection electrodes G1_CNE and G2_CNE, a red pixel connection electrode R_CNE, and a blue pixel connection electrode B_CNE.

The first green pixel connection electrode G1_CNE is connected to the first green pixel driving circuit G1_PD (e.g., see FIG. 5C) through a first-first green contact hole G1_CH1 defined in the eighth insulating layer INS8. The second green pixel connection electrode G2_CNE is connected to the second green pixel driving circuit G2_PD (e.g., see FIG. 5C) through a second-first green contact hole G2_CH1 defined in the eighth insulating layer INS8. The red pixel connection electrode R_CNE is connected to the red pixel driving circuit R_PD (e.g., see FIG. 5C) through a first red contact hole R_CH1 defined in the eighth insulating layer INS8, and the blue pixel connection electrode B_CNE is connected to the blue pixel driving circuit B_PD (e.g., see FIG. 5C) through a first blue contact hole B_CH1 defined in the eighth insulating layer INS8. The blue pixel connection electrode B_CNE may be disposed below the red pixel connection electrode R_CNE in a plan view.

The plurality of shielding electrodes RSE and the pixel connection electrodes G1_CNE, G2_CNE, R_CNE, and B_CNE may be disposed on the same layer (e.g., at the same layer) (i.e., the eighth insulating layer INS8), and may be spaced (e.g., spaced apart) from each other to be electrically separated from each other in a plan view. As an example, each of the pixel connection electrodes G1_CNE, G2_CNE, R_CNE, and B_CNE may not overlap the second circuit area O_SA in a plan view.

Referring to FIGS. 9J and 9K, the ninth insulating layer INS9 may cover at least a portion of the conductive pattern TCO and may be disposed on the eighth insulating layer INS8. An anode pattern AEP may be disposed on the ninth insulating layer INS9. The anode pattern AEP may include a metal, an alloy, a conductive metal oxide, a transparent conductive material, and/or the like.

The anode pattern AEP may include a plurality of pixel anode electrodes G1_AE, G2_AE, R_AE, and B_AE and a plurality of sensor anode electrodes O_AE1 and O_AE2. The plurality of pixel anode electrodes G1_AE, G2_AE, R_AE, and B_AE includes first and second green anode electrodes G1_AE and G2_AE, a red anode electrode R_AE, and a blue anode electrode B_AE. The plurality of sensor anode electrodes O_AE1 and O_AE2 includes a first sensor anode electrode O_AE1 disposed in a first row ODD_R and a second sensor anode electrode O_AE2 disposed in a second row EVEN_R.

The first green anode electrode G1_AE is connected to the first green pixel connection electrode G1_CNE through a first-second green contact hole G1_CH2 defined in the ninth insulating layer INS9. The second green anode electrode G2_AE is connected to the second green pixel connection electrode G2_CNE through a second-second green contact hole G2_CH2 defined in the ninth insulating layer INS9. The red anode electrode R_AE is connected to the red pixel connection electrode R_CNE through a second red contact hole R_CH2 defined in the ninth insulating layer INS9, and the blue anode electrode B_AE is connected to the blue pixel connection electrode B_CNE through a second blue contact hole B_CH2 defined in the ninth insulating layer INS9.

As such, the pixel connection electrodes G1_CNE, G2_CNE, R_CNE, and B_CNE may be disposed on a layer (e.g., the eighth insulating layer INS8) different from layer on which the pixel anode electrodes G1_AE, G2_AE, R_AE, and B_AE are disposed, and may connect the pixel anode electrodes G1_AE, G2_AE, R_AE, and B_AE to the corresponding pixel driving circuit. As a result, even if the resolution of the display device DD (e.g., refer to FIG. 3) were increased, the degree of freedom of arrangement of the pixel anode electrodes G1_AE, G2_AE, R_AE, and B_AE might be improved.

Each of the pixel connection electrodes G1_CNE, G2_CNE, R_CNE, and B_CNE is disposed at a first side (e.g., a left side) or a second side (e.g., a right side) of the read-out wiring RL (or a first read-out line). That is, each of the pixel connection electrodes G1_CNE, G2_CNE, R_CNE, and B_CNE does not cross (or overlap) the read-out wiring RL. Each of the pixel connection electrodes G1_CNE, G2_CNE, R_CNE, and B_CNE is spaced (e.g., spaced apart) from the read-out wiring RL in the first direction DR1.

Referring to FIGS. 9K and 9L, the read-out wiring RL includes the first read-out line portion RL_P1 and the second read-out line portion RL_P2. The read-out wiring RL is covered by the shielding electrode RSE. The blue pixel connection electrode B_CNE is disposed on the eighth insulating layer INS8 together with the shielding electrode RSE and spaced (e.g., spaced apart) from the shielding electrode RSE in the first direction DR1. The blue pixel connection electrode B_CNE does not cross the read-out wiring RL. Accordingly, the formation of the coupling capacitance between the blue pixel connection electrode B_CNE and the read-out wiring RL may be blocked and prevented (or substantially prevented) by the shielding electrode RSE.

As an example, the blue pixel connection electrode B_CNE may not overlap the red anode electrode R_AE and the first and second green anode electrodes G1_AE and G2_AE in a plan view.

The first sensor anode electrode O_AE1 may be disposed to overlap the sensor circuit area O_SA, and the second sensor anode electrode O_AE2 may be disposed not to overlap the sensor circuit area O_SA. The second sensor anode electrode O_AE2 may overlap the pixel circuit area P_PA. The first sensor anode electrode O_AE1 may be connected to the corresponding sensor driving circuit through a first sensor contact hole O_CH1.

As an example, the anode pattern AEP may further include a sensor connection electrode O_CNE2 and a dummy connection electrode D_CNE1. The sensor connection electrode O_CNE2 may extend from the second sensor anode electrode O_AE2 to partially overlap the sensor circuit area O_SA. The sensor connection electrode O_CNE2 may be integrally formed with the second sensor anode electrode O_AE2. The sensor connection electrode O_CNE2 may be connected to the corresponding sensor driving circuit through a second sensor contact hole O_CH2. The second sensor anode electrode O_AE2 may be electrically connected to a corresponding sensor driving circuit through a sensor connection electrode O_CNE2.

As an example, the blue pixel connection electrode B_CNE may partially overlap the sensor connection electrode O_CNE2 in a plan view.

The dummy connection electrode D_CNE1 may extend from the first sensor anode electrode O_AE1 to overlap the pixel circuit area P_PA. As an example, the dummy connection electrode D_CNE1 may have a shape similar to that of the sensor connection electrode O_CNE2. The sum of the area of the first sensor anode electrode O_AE1 and the area of the dummy connection electrode D_CNE1 may be substantially equal to the sum of the area of the second sensor anode electrode O_AE2 and the area of the sensor connection electrode O_CNE2.

When the magnitudes of the coupling capacitances acting on the first and second light receiving elements OPD1 and OPD2 (e.g., see FIG. 5C) are different from each other, the magnitudes of the noises acting on the first and second light receiving elements OPD1 and OPD2 (e.g., see FIG. 5C) may be different from each other. In this case, a deviation may occur between sensing signals for each row. However, when the dummy connection electrode D_CNE1 is designed such that the sum of the area of the first sensor anode electrode O_AE1 and the area of the dummy connection electrode D_CNE1 is substantially equal to the sum of the area of the second sensor anode electrode O_AE2 and the area of the sensor connection electrode O_CNE2, it is possible to reduce deviations between the sensing signals generated for each row, and as a result, sensing uniformity and sensing accuracy may be improved.

In addition, the number of data wirings DL and vertical connection wirings D3_VCL crossing the sensor connection electrode O_CNE2 may be substantially the same as the number of data wirings DL and vertical connection wirings D3_VCL crossing the dummy connection electrode D_CNE1. As a result, the magnitude of the coupling capacitance acting on the sensor connection electrode O_CNE2 by the data wirings DL and the vertical connection wirings D3_VCL may be the same as the magnitude of the coupling capacitance acting on the dummy connection electrode D_CNE1 by the data wirings DL and the vertical connection wirings D3_VCL. Accordingly, the difference between the coupling capacitance acting on the first light receiving element OPD1 disposed in the first row ODD_R and the coupling capacitance acting on the second light receiving element OPD2 disposed in the second row EVEN_R may be reduced.

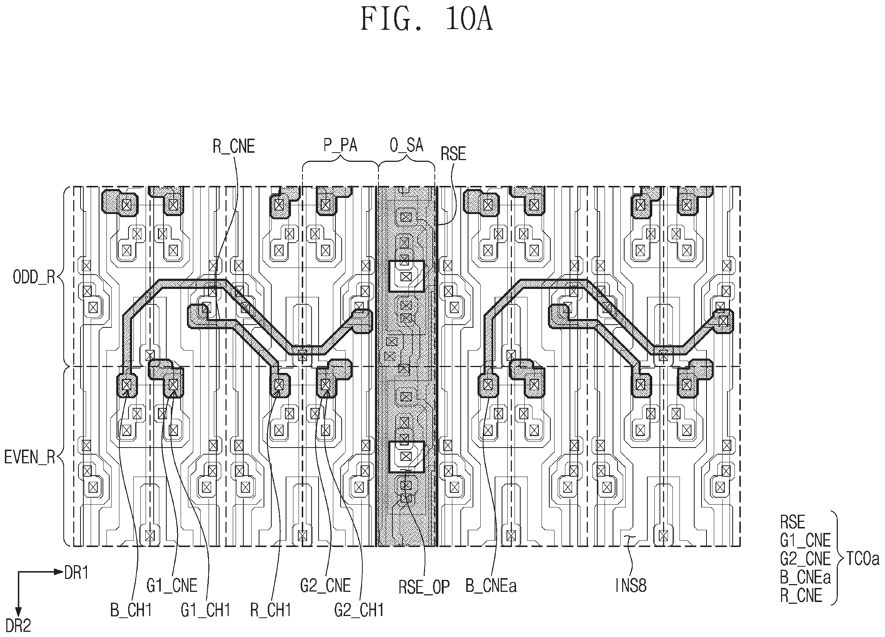

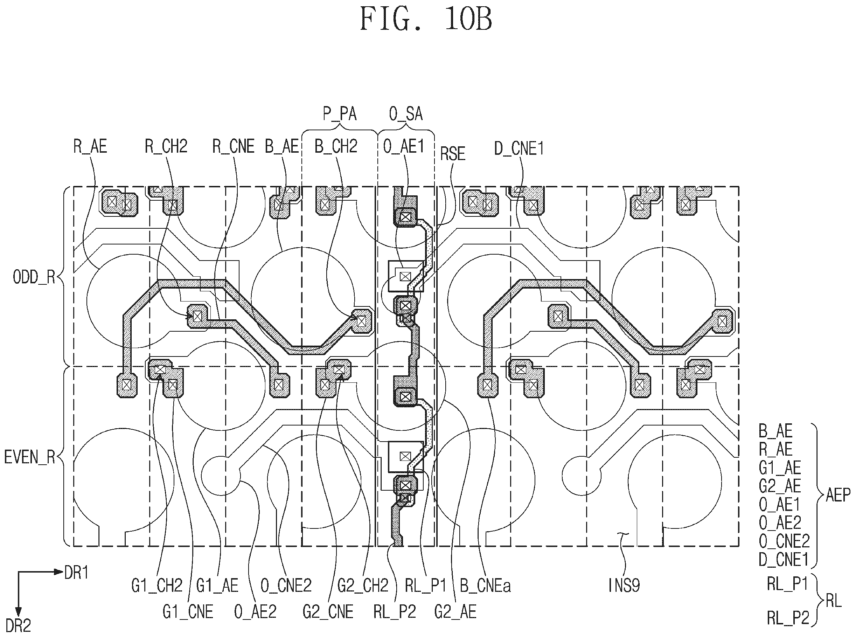

FIGS. 10A and 10B are plan views illustrating a process of stacking a circuit layer and an element layer.

Referring to FIG. 10A, a conductive pattern TCOa may include a shielding electrode RSE and a plurality of pixel connection electrodes G1_CNE, G2_CNE, R_CNE, and B_CNEa.

The plurality of pixel connection electrodes G1_CNE, G2_CNE, R_CNE, and B_CNEa includes first and second green pixel connection electrodes G1_CNE and G2_CNE, a red pixel connection electrode R_CNE, and a blue pixel connection electrode B_CNEa. In a plan view, the blue pixel connection electrode B_CNEa may be disposed above the red pixel connection electrode R_CNE.

Referring to FIGS. 10A and 10B, the ninth insulating layer INS9 may cover at least a portion of the conductive pattern TCOa, and may be disposed on the eighth insulating layer INS8. The anode pattern AEP may be disposed on the ninth insulating layer INS9.

The anode pattern AEP may include a plurality of pixel anode electrodes G1_AE, G2_AE, R_AE, and B_AE and a plurality of sensor anode electrodes O_AE1 and O_AE2.

As such, the pixel connection electrodes G1_CNE, G2_CNE, R_CNE, and B_CNEa may be disposed on a layer (e.g., the eighth insulating layer INS8) different from the pixel anode electrodes G1_AE, G2_AE, R_AE, and B_AE, and may connect the pixel anode electrodes G1_AE, G2_AE, R_AE, and B_AE to the corresponding pixel driving circuit. As a result, even if the resolution of the display device DD (e.g., see FIG. 3) were increased, the degree of freedom of arrangement of the pixel anode electrodes G1_AE, G2_AE, R_AE, and B_AE might be improved.

Each of the pixel connection electrodes G1_CNE, G2_CNE, R_CNE, and B_CNEa is disposed at a first side (e.g., a left side) or a second side (e.g., a right side) of the read-out wiring RL (or the first read-out wiring). That is, each of the pixel connection electrodes G1_CNE, G2_CNE, R_CNE, and B_CNEa does not cross (or overlap) the read-out wiring RL. Each of the pixel connection electrodes G1_CNE, G2_CNE, R_CNE, and B_CNEa is spaced (e.g., spaced apart) from the read-out wiring RL in the first direction DR1. The formation of the coupling capacitance between the pixel connection electrodes G1_CNE, G2_CNE, R_CNE, and B_CNEa and the read-out wiring RL may be blocked and prevented (or substantially prevented) by the shielding electrode RSE.

As an example, the blue pixel connection electrode B_CNEa may overlap the red anode electrode R_AE and one of the first and second green anode electrodes G1_AE and G2_AE (e.g., the red anode electrode R_AE) in a plan view. The blue pixel connection electrode B_CNEa may pass through the center point of the red anode electrode R_AE.

As an example, the blue pixel connection electrode B_CNEa may not overlap the sensor connection electrode O_CNE2 in a plan view, and may partially overlap the dummy connection electrode D_CNE1.

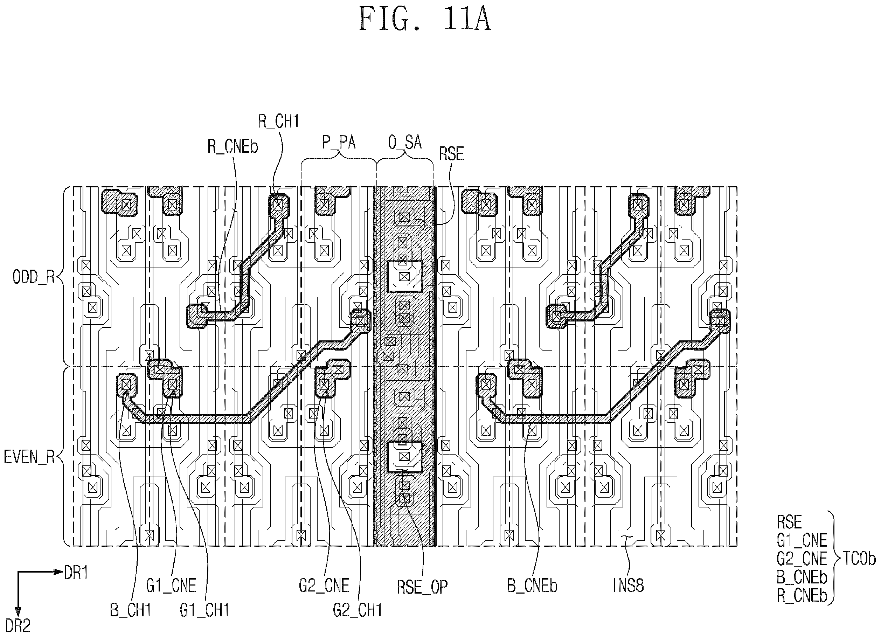

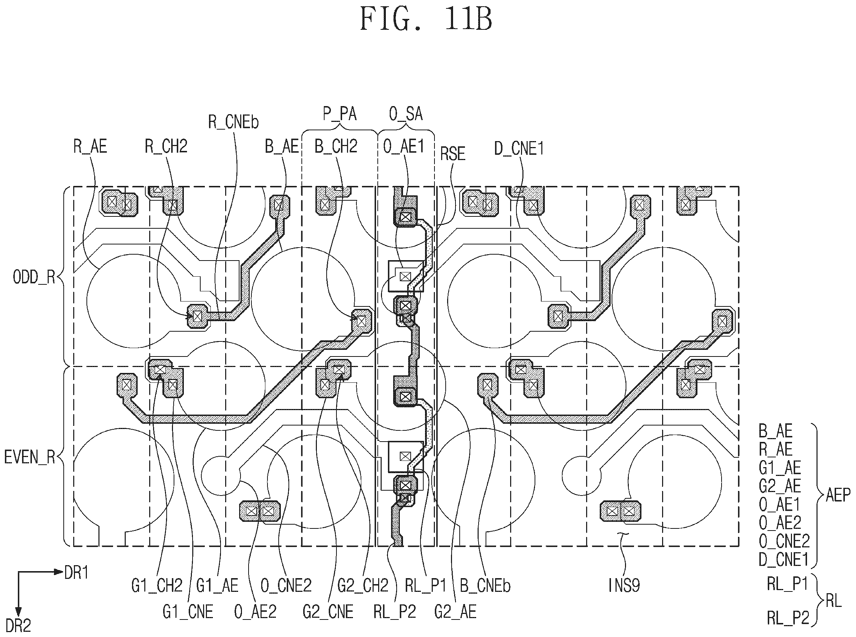

FIGS. 11A and 11B are plan views illustrating a process of stacking a circuit layer and an element layer.

Referring to FIG. 11A, a conductive pattern TCOb may include a shielding electrode RSE and a plurality of pixel connection electrodes G1_CNE, G2_CNE, R_CNEb, and B_CNEb.

The plurality of pixel connection electrodes G1_CNE, G2_CNE, R_CNEb, and B_CNEb includes first and second green pixel connection electrodes G1_CNE and G2_CNE, a red pixel connection electrode R_CNEb, and a blue pixel connection electrode B_CNEb. The blue pixel connection electrode B_CNEb may be disposed below the red pixel connection electrode R_CNEb in a plan view.

Referring to FIGS. 11A and 11B, the ninth insulating layer INS9 may cover at least a portion of the conductive pattern TCOb, and may be disposed on the eighth insulating layer INS8. The anode pattern AEP may be disposed on the ninth insulating layer INS9.

The anode pattern AEP may include a plurality of pixel anode electrodes G1_AE, G2_AE, R_AE, and B_AE and a plurality of sensor anode electrodes O_AE1 and O_AE2.

As an example, the blue pixel connection electrode B_CNEb may overlap the red anode electrode R_AE and one (e.g., the first green anode electrode G1_AE) of the first and second green anode electrodes G1_AE and G2_AE in a plan view.

As an example, the blue pixel connection electrode B_CNEb may not overlap the sensor connection electrode O_CNE2 and the dummy connection electrode D_CNE1 in a plan view. The red pixel connection electrode R_CNEb may not overlap the sensor connection electrode O_CNE2 and the dummy connection electrode D_CNE1 in a plan view.

When the blue and red pixel connection electrodes B_CNEb and R_CNEb do not overlap the dummy connection electrode D_CNE1 and the sensor connection electrode O_CNE1 in a plan view, a coupling capacitance generated between the blue and red pixel connection electrodes B_CNEb and R_CNEb and the first and second light-receiving elements OPD1 and OPD2 may be reduced. Therefore, it is possible to prevent or substantially prevent the sensing performance of the first and second light receiving elements OPD1 and OPD2 from being deteriorated by the coupling capacitance.

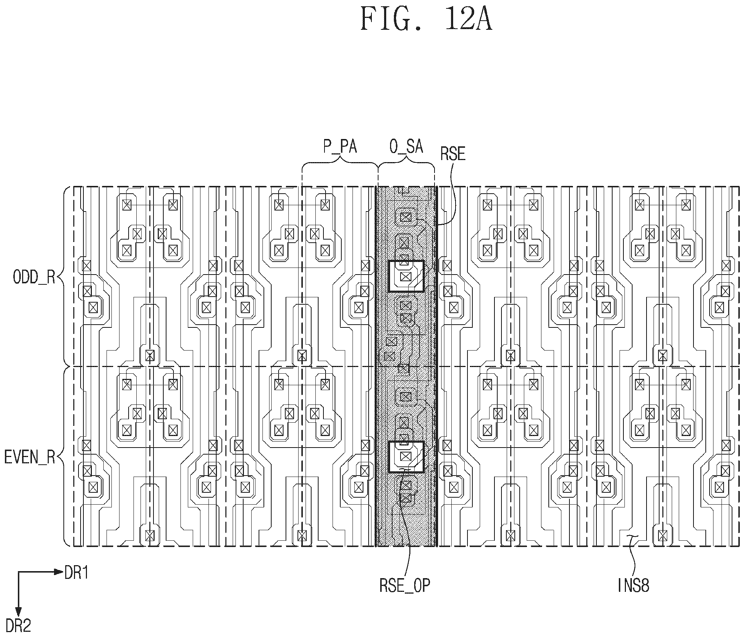

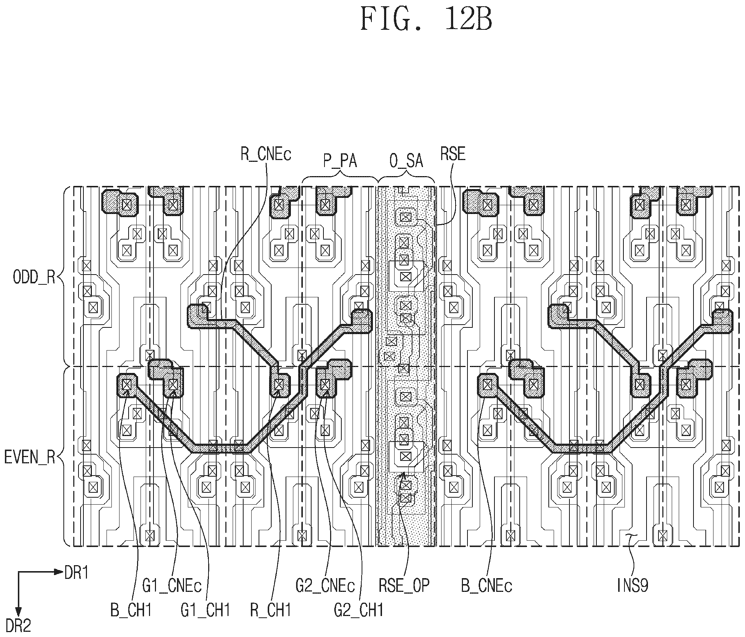

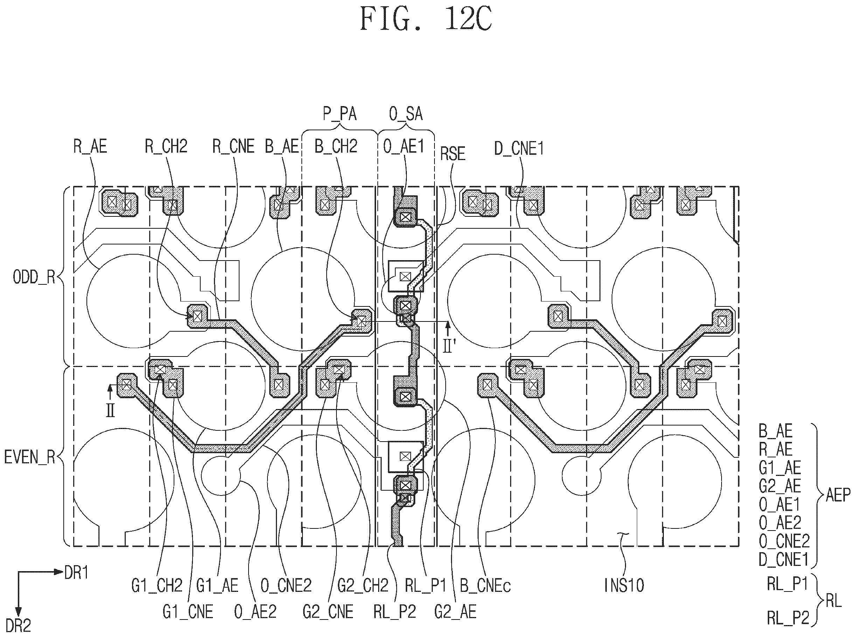

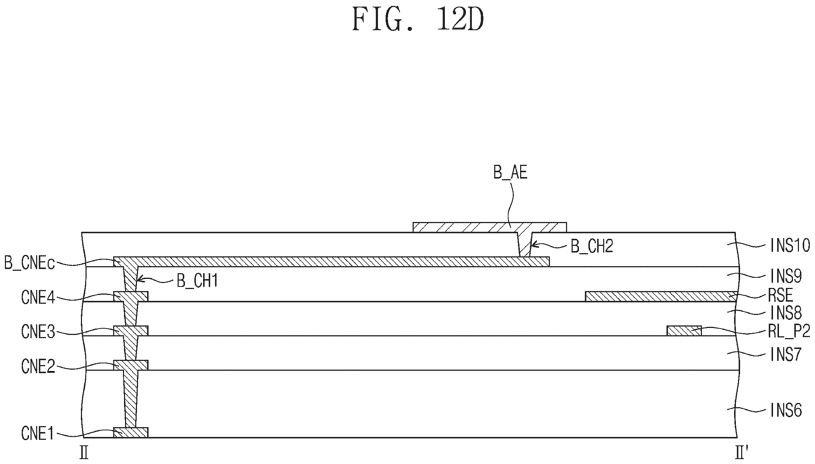

FIGS. 12A to 12C are plan views illustrating a process of stacking a circuit layer and an element layer. FIG. 12D is a cross-sectional view taken along the line II - II' illustrated in FIG. 12C.

Referring to FIGS. 12A to 12D, the shielding electrode RSE may be disposed on the eighth insulating layer INS8 (or a first intermediate insulating layer). The ninth insulating layer INS9 may cover at least a portion of the shielding electrode RSE, and may be disposed on the eighth insulating layer INS8. The plurality of pixel connection electrodes G1_CNEc, G2_CNEc, R_CNEc, and B_CNEc may be disposed on the ninth insulation layer INS9 (or a second intermediate insulation layer).

As an example, the plurality of pixel connection electrodes G1_CNEc, G2_CNEc, R_CNEc, and B_CNEc may be disposed on a layer (e.g., the ninth insulating layer INS9) different from a layer (e.g., the eighth insulating layer INS8) on which the shielding electrode RSE is formed. The blue pixel connection electrode B_CNEc is connected to the blue pixel driving circuit B_PD (e.g., see FIG. 5C) through a first blue contact hole B_CH1 defined in the ninth insulating layer INS9.

Alternatively, the plurality of pixel connection electrodes G1_CNEc, G2_CNEc, R_CNEc, and B_CNEc may be disposed on the eighth insulating layer INS8, and the shielding electrode RSE may be disposed on the ninth insulating layer INS9. In this case, the blue pixel connection electrode B_CNEc is connected to the blue pixel driving circuit B_PD (e.g., see FIG. 5C) through the first blue contact hole B_CH1 defined in the eighth insulating layer INS8.

A tenth insulating layer INS10 (or a third intermediate insulating layer) may cover at least a portion of the plurality of pixel connection electrodes G1_CNEc, G2_CNEc, R_CNEc, and B_CNEc, and may be disposed on the ninth insulating layer INS9. The anode pattern AEP may be disposed on the tenth insulating layer INS10.

The anode pattern AEP may include a plurality of pixel anode electrodes G1_AE, G2_AE, R_AE, and B_AE and a plurality of sensor anode electrodes O_AE1 and O_AE2.

The blue anode electrode B_AE is connected to the blue pixel connection electrode B_CNEc through a second blue contact hole B_CH2 defined in the tenth insulating layer INS10. Alternatively, when the plurality of pixel connection electrodes G1_CNEc, G2_CNEc, R_CNEc, and B_CNEc is disposed on the eighth insulating layer INS8, the blue anode electrode B_AE may be connected to the blue pixel connection electrode B_CNEc through the second blue contact hole B_CH2 defined in the ninth and tenth insulating layers INS9 and INS10.

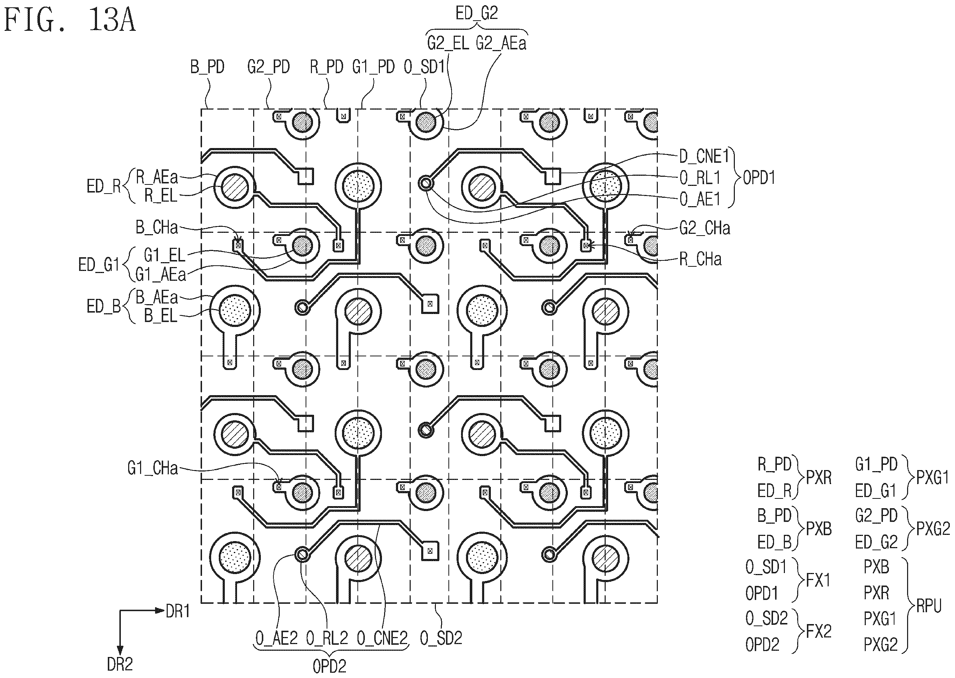

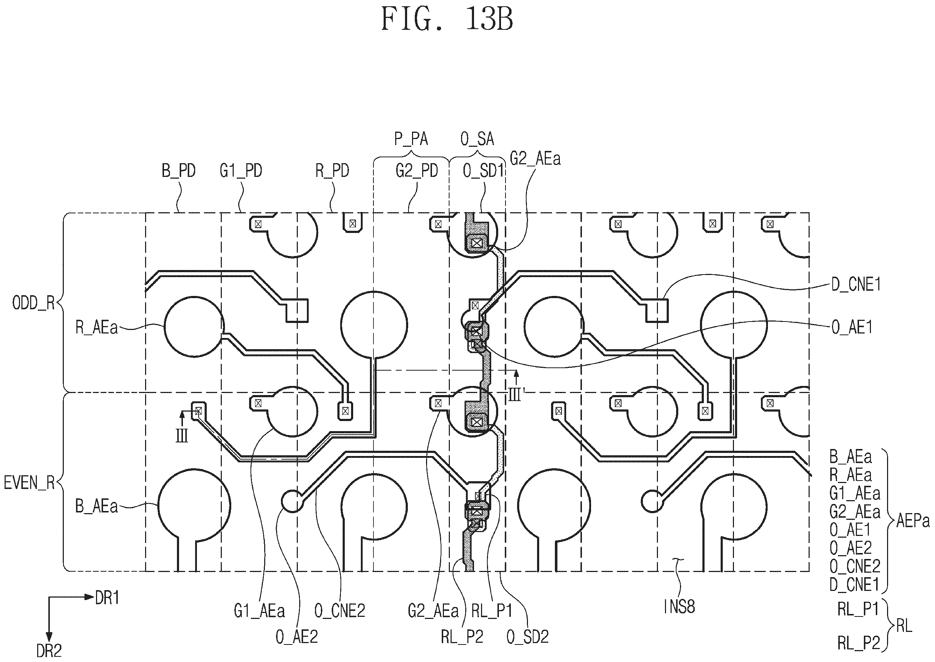

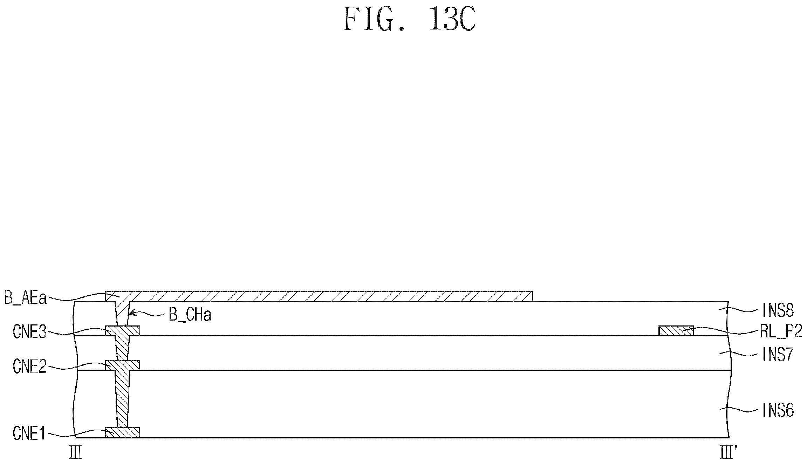

FIG. 13A is a plan view illustrating a portion of a display panel. FIG. 13B is an enlarged plan view illustrating a portion of FIG. 13A. FIG. 13C is a cross-sectional view taken along the line III-III' illustrated in FIG. 13B.

Referring to FIG. 13A, the display panel DP includes a plurality of pixels PXR, PXG1, PXG2, and PXB and a plurality of sensors FX1 and FX2.

The blue light emitting element ED_B is electrically connected to the blue pixel driving circuit B_PD (or a first pixel driving circuit). Specifically, the blue light emitting element ED_B includes a blue anode electrode B_AEa (or a first pixel anode electrode) and a blue light emitting layer B_EL, and the blue anode electrode B_AEa is electrically connected to the blue pixel driving circuit B_PD. The blue anode electrode B_AEa is connected to the blue pixel driving circuit B_PD through a blue contact hole B_CHa.

The red light emitting element ED_R is electrically connected to the red pixel driving circuit R_PD (or a second pixel driving circuit). Specifically, the red light emitting element ED_R includes a red anode electrode R_AEa (or a second pixel anode electrode) and a red light emitting layer R_EL, and is electrically connected to the red pixel driving circuit R_PD. The red anode electrode R_AEa is connected to the red pixel driving circuit R_PD through a red contact holes R_CHa.

The first green light emitting element ED_G1 is electrically connected to the first green pixel driving circuit G1_PD (or a third pixel driving circuit). For example, the first green light emitting element ED_G1 includes a first green anode electrode G1_AEa (or a third pixel anode electrode) and a first green light emitting layer G1_EL, and the first green anode electrode G1_AEa is electrically connected to the first green pixel driving circuit G1_PD. The first green anode electrode G1_AEa is connected to the first green pixel driving circuit G1_PD through a first green contact holes G1_CHa. The second green light emitting element ED_G2 is electrically connected to the second green pixel driving circuit G2_PD (or a fourth pixel driving circuit). Specifically, the second green light emitting element ED_G2 includes a second green anode electrode G2_AEa (or a fourth pixel anode electrode) and a second green light emitting layer G2_EL, and the second green anode electrode G2_AEa is electrically connected to the second green pixel driving circuit G2_PD. The second green anode electrode G2_AEa is connected to the second green pixel driving circuit G2_PD through a second green contact holes G2_CHa.

Referring to FIGS. 13B and 13C, the eighth insulating layer INS8 may cover at least a portion of the third data pattern layer SD3 (e.g., see FIG. 9I) and may be disposed on the seventh insulating layer INS7 (e.g., see FIG. 9I). An anode pattern AEPa may be disposed on the eighth insulating layer INS8.

The anode pattern AEPa may include the plurality of pixel anode electrodes G1_AEa, G2_AEa, R_AEa, and B_AEa and the plurality of sensor anode electrodes O_AE1 and O_AE2. When the resolution of the display device DD (e.g., see FIG. 3) is not high, a sufficient distance between the pixel anode electrodes G1_AEa, G2_AEa, R_AEa, and B_AEa is secured. In this case, the display device DD may not include the pixel connection electrodes shown in FIG. 5C.

Each of the pixel anode electrodes G1_AEa, G2_AEa, R_AEa, and B_AEa is disposed at a first side (e.g., a left side) or a second side (e.g., a right side) of the read-out wiring RL (or the first read-out wiring). That is, each of the pixel anode electrodes G1_AEa, G2_AEa, R_AEa, and B_AEa does not cross (or overlap) the read-out wiring RL. The pixel anode electrodes G1_AEa, G2_AEa, R_AEa, and B_AEa are spaced (e.g., spaced apart) from the read-out wiring RL in the first direction DR1.

The read-out wiring RL includes the first read-out line portion RL_P1 and the second read-out line portion RL_P2. As an example, the blue anode electrode B_AEa is disposed between the blue pixel driving circuit B_PD and the read-out wiring RL in a plan view.

The pixel anode electrodes G1_AEa, G2_AEa, R_AEa, and B_AEa and the first and second sensor anode electrodes O_AE1 and O_AE2 are disposed on the same layer (e.g., at the same layer) (i.e., the eighth insulating layer INS8). The pixel anode electrodes G1_AEa, G2_AEa, R_AEa, and B_AEa may be disposed to be spaced (e.g., spaced apart) from the first and second sensor anode electrodes O_AE1 and O_AE2, the sensor connection electrode O_CNE2, and the dummy connection electrode D_CNE1 in a plan view.

In FIGS. 13B and 13C, the shielding electrode RSE (e.g., refer to FIG. 9K) is omitted, but the arrangement is not limited thereto. The shielding electrode RSE may also be employed in FIGS. 13B and 13C. In this case, the pixel anode electrodes G1_AEa, G2_AEa, R_AEa, and B_AEa may be disposed on the ninth insulating layer INS9 covering the shielding electrode RSE.

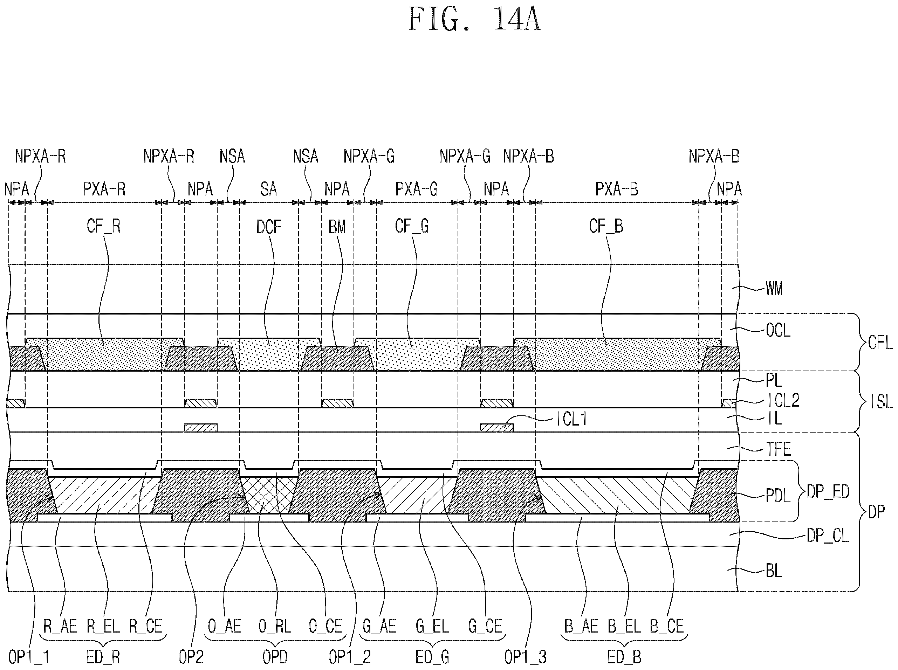

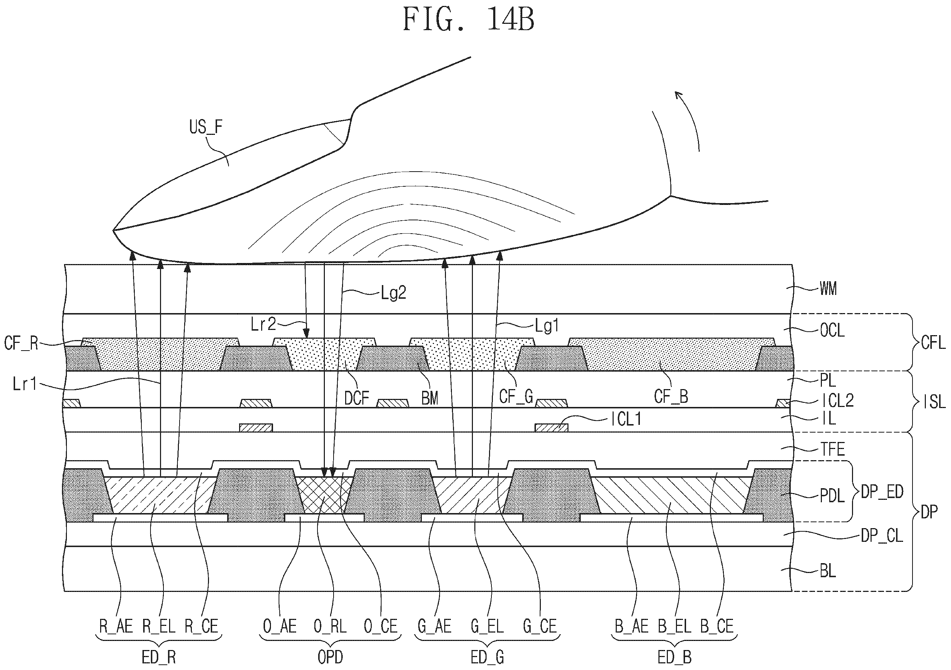

FIGS. 14A and 14B are cross-sectional views illustrating a light emitting element and a light receiving element of a display panel.

Referring to FIGS. 14A and 14B, the first electrode layer is disposed on the circuit layer DP_CL. A pixel defining layer PDL is formed on the first electrode layer. The first electrode layer may include red, green, and blue anode electrodes R_AE, G_AE, and B_AE. First to third light emitting openings OP1_1, OP1_2, and OP1_3 of the pixel defining layer PDL expose at least portions of the red, green, and blue anode electrodes R_AE, G_AE, and B_AE, respectively. The pixel defining layer PDL may further include a black material. The pixel defining layer PDL may further include a black organic dye/pigment such as carbon black or aniline black. The pixel defining layer PDL may be formed by mixing a blue organic material and a black organic material. The pixel defining layer PDL may further include a liquid-repellent organic material.

As shown in FIG. 14A, the display panel DP may include first to third light emitting areas PXA-R, PXA-G, and PXA-B and first to third non-light emitting areas NPXA-R, NPXA-G, and NPXA-B adjacent to the first to third light emitting areas PXA-R, PXA-G, and PXA-B. Each of the non-light emitting areas NPXA-R, NPXA-G, and NPXA-B may surround the corresponding light emitting area PXA-R, PXA-G, and PXA-B. The first light emitting area PXA-R is defined to correspond (e.g., corresponds) to a portion of the red anode electrode R_AE exposed by the first light emitting opening OP1_1. The second light emitting area PXA-G is defined to correspond (e.g., corresponds) to a portion of the green anode electrode G_AE exposed by the second light emitting opening OP1_2. The third light emitting area PXA-B is defined (e.g., corresponds) to correspond to a portion of the blue anode electrode B_AE exposed by the third light emitting opening OP1_3. A non-pixel area NPA may be defined (e.g., may be located) between the first to third non-light emitting areas NPXA-R, NPXA-G, and NPXA-B.

The light emitting layer may be disposed on the first electrode layer. The light emitting layer may include red, green, and blue light emitting layers R_EL, G_EL, and B_EL. The red, green, and blue light emitting layers R_EL, G_EL, and B_EL may be disposed in areas corresponding to the first to third light emitting openings OP1_1, OP1_2, and OP1_3, respectively. The red, green, and blue light emitting layers R_EL, G_EL, and B_EL may be formed separately. Each of the red, green, and blue light emitting layers R_EL, G_EL, and B_EL may include an organic material and/or an inorganic material. The red, green, and blue light emitting layers R_EL, G_EL, and B_EL may generate respective colored lights (e.g., predetermined colored lights). For example, the red light emitting layer R_EL may generate red light, the green light emitting layer G_EL may generate green light, and the blue light emitting layer B_EL may generate blue light.

Although the patterned red, green, and blue light emitting layers R_EL, G_EL, and B_EL are illustrated as an example, one light emitting layer may be commonly disposed in the first to third light emitting areas PXA-R, PXA-G, and PXA-B. In this case, the light emitting layer may generate white light or blue light. In addition, the light emitting layer may have a multi-layer structure referred to as a tandem.

Each of the red, green, and blue light emitting layers R_EL, G_EL, and B_EL may include a low molecular organic material or a high molecular organic material as a light emitting material. Alternatively, each of the red, green, and blue light emitting layers R_EL, G_EL, and B_EL may include a quantum dot material as a light emitting material. The core of the quantum dot may be selected from a group II-VI compound, a group III-V compound, a group IV-VI compound, a group IV element, a group IV compound, and a combination thereof.

A second electrode layer is disposed on the red, green, and blue light emitting layers R_EL, G_EL, and B_EL. The second electrode layer may include red, green, and blue cathode electrodes R_CE, G_CE, and B_CE. The red, green, and blue cathode electrodes R_CE, G_CE, and B_CE may be electrically connected to each other. As an example, the red, green, and blue cathode electrodes R_CE, G_CE, and B_CE may have an integral shape. In this case, the red, green, and blue cathode electrodes R_CE, G_CE, and B_CE may be commonly disposed in the first to third light emitting areas PXA-R, PXA-G, and PXA-B, the first to third non-light emitting areas NPXA-R, NPXA-G, and NPXA-B, and the non-pixel area NPA.

The element layer DP_ED may further include a light receiving element OPD. The light receiving element OPD may be a photodiode. The pixel defining layer PDL may further include a light receiving opening OP2 provided corresponding to the light receiving element OPD.

The light receiving element OPD may include a sensing anode electrode O_AE, a photoelectric conversion layer O_RL, and a sensing cathode electrode O_CE. The sensing anode electrode O_AE may be disposed on the same layer (e.g., at the same layer) as the first electrode layer. That is, the sensing anode electrode O_AE may be disposed on the circuit layer DP_CL, and may be simultaneously formed with the red, green, and blue anode electrodes R_AE, G_AE, and B_AE through the same process.

The light receiving opening OP2 of the pixel defining layer PDL exposes at least a portion of the sensing anode electrode O_AE. The photoelectric conversion layer O_RL is disposed on the sensing anode electrode O_AE exposed by the light receiving opening OP2. The photoelectric conversion layer O_RL may include an organic photo-sensing material. The sensing cathode electrode O_CE may be disposed on the photoelectric conversion layer O_RL. The sensing cathode electrode O_CE and the red, green, and blue cathode electrodes R_CE, G_CE, and B_CE may be simultaneously formed through the same process. As an example, the sensing cathode electrode O_CE may have an integral shape with the red, green, and blue cathode electrodes R_CE, G_CE, and B_CE to form a common cathode electrode.

An encapsulation layer TFE is disposed on the element layer DP_ED. The encapsulation layer TFE includes at least an inorganic layer or an organic layer. The encapsulation layer TFE may include two inorganic layers and an organic layer disposed therebetween. The encapsulation layer TFE may include a plurality of inorganic layers and a plurality of organic layers, which are alternately stacked.

The inorganic layer protects the red, green, and blue light emitting elements ED_R, ED_G, and ED_B and the light receiving element OPD from moisture/oxygen, and the organic layer protects the red, green, and blue light emitting elements ED_R, ED_G, and ED_B and the light receiving element OPD from foreign substances such as dust particles. The inorganic layer may include a silicon nitride layer, a silicon oxy nitride layer, a silicon oxide layer, a titanium oxide layer, or an aluminum oxide layer, but is not particularly limited thereto. The organic layer may include an acrylic organic layer, but is not particularly limited.

The display device DD includes an input sensing layer ISL disposed on the display panel DP and a color filter layer CFL disposed on the input sensing layer ISL.

The input sensing layer ISL may be directly disposed on the encapsulation layer TFE. The input sensing layer ISL includes a first conductive layer ICL1, an insulating layer IL, a second conductive layer ICL2, and a protective layer PL. The first conductive layer ICL1 may be disposed on the encapsulation layer TFE. FIGS. 14A and 14B illustrate a structure in which the first conductive layer ICL1 is directly disposed on the encapsulation layer TFE, but the structure is not limited thereto. The input sensing layer ISL may further include a base insulating layer disposed between the first conductive layer ICL1 and the encapsulation layer TFE. In this case, the encapsulation layer TFE may be covered by the base insulating layer, and the first conductive layer ICL1 may be disposed on the base insulating layer. As an example, the base insulating layer may include an inorganic insulating material.

The insulating layer IL may cover the first conductive layer ICL1. The second conductive layer ICL2 is disposed on the insulating layer IL. Although a structure in which the input sensing layer ISL includes the first and second conductive layers ICL1 and ICL2 is illustrated, the structure is not limited thereto. For example, the input sensing layer ISL may include only one of the first and second conductive layers ICL1 and ICL2.

The protective layer PL may be disposed on the second conductive layer ICL2. The protective layer PL may include an organic insulating material. The protective layer PL may serve to protect the first and second conductive layers ICL1 and ICL2 from moisture/oxygen and protect the first and second conductive layers ICL1 and ICL2 from foreign substances.

The color filter layer CFL may be disposed on the input sensing layer ISL. The color filter layer CFL may be disposed directly on the protective layer PL. The color filter layer CFL may include a first color filter CF_R, a second color filter CF_G, and a third color filter CF_B. The first color filter CF_R has a first color, the second color filter CF_G has a second color, and the third color filter CF_B has a third color. As an example, the first color may be a red color, the second color may be a green color, and the third color may be a blue color.

The color filter layer CFL may further include a dummy color filter DCF. As an example, when an area in which the photoelectric conversion layer O_RL is disposed is defined (or may be referred to) as a sensing area SA, and a periphery of the sensing area SA is defined (or may be referred to) as a non-sensing area NSA, the dummy color filter DCF may be disposed to correspond to the sensing area SA. The dummy color filter DCF may overlap the sensing area SA and the non-sensing area NSA. As an example, the dummy color filter DCF may have the same color as one of the first to third color filters CF_R, CF_G, and CF_B. As an example, the dummy color filter DCF may have a green color in the same manner as the second color filter CF_G.

The color filter layer CFL may further include a black matrix BM. The black matrix BM may be disposed to correspond to the non-pixel area NPA. The black matrix BM may be disposed to overlap the first and second conductive layers ICL1 and ICL2 in the non-pixel area NPA. As an example, the black matrix BM may overlap the non-pixel area NPA and the first to third non-light emitting areas NPXA-G, NPXA-B, and NPXA-R. The black matrix BM may not overlap the first to third light emitting areas PXA-R, PXR-G, and PXA-B.

The color filter layer CFL may further include an overcoating layer OCL. The overcoating layer OCL may include an organic insulating material. The overcoating layer OCL may be provided to have a thickness sufficient to remove a step between the first to third color filters CF_R, CF_G, and CF_B. The overcoating layer OCL may include any material that has a suitable thickness (e.g., a predetermined thickness) and may planarize the upper surface of the color filter layer CFL without being particularly limited, and may include, for example, an acrylate-based organic material.

Referring to FIG. 14B, when the display device DD (e.g., see FIG. 1) operates, each of the red, green, and blue light emitting elements ED_R, ED_G, and ED_B may output light. The red light emitting elements ED_R output red light of a red wavelength band, the green light emitting elements ED_G output green light of a green wavelength band, and the blue light emitting elements ED_B output blue light of a blue wavelength band.

As an example, the light receiving element OPD may receive light from specific light emitting elements (e.g., green light emitting elements ED_G) from among the red, green, and blue light emitting elements ED_R, ED_G, and ED_B. That is, the light receiving element OPD may receive a second reflected light Lg2 generated by a second light Lg1 output from the green light emitting elements ED_G being reflected by the user's fingerprint. The second light Lg1 and the second reflected light Lg2 may be green light having a green wavelength. The dummy color filter DCF is disposed on the light receiving element OPD. The dummy color filter DCF may have a green color. Accordingly, the second reflected light Lg2 may pass through the dummy color filter DCF and may be incident on the light receiving element OPD.

Meanwhile, the red light and the blue light output from the red and blue light emitting elements ED_R and ED_B may also be reflected by the user's hand US_F. For example, when a light generated by a red light Lr1 output from the red light emitting elements ED_R being reflected by the user's hand US_F is defined (or may be referred to) as a first reflected light Lr2, the first reflected light Lr2 may not pass through the dummy color filter DCF and may be absorbed. Accordingly, the first reflected light Lr2 cannot pass through the dummy color filter DCF and cannot be incident on the light receiving element OPD. Similarly, even if blue light were reflected by the user's hand US_F, it might be absorbed by the dummy color filter DCF. Accordingly, only the second reflected light Lg2 may be provided to the light receiving element OPD.

According to the above description, the pixel connection electrodes may be disposed on the same layer (e.g., at the same layer) as the shielding electrode, and may connect the pixel anode electrodes to the corresponding pixel driving circuit. As a result, even if the resolution of the display device were increased, the degree of freedom of arrangement of the pixel anode electrodes might be improved.

In addition, as the pixel connection electrodes are disposed so as not to cross the read-out wiring, the coupling capacitance acting on the read-out wiring can be reduced, and as a result, the sensing accuracy of the sensor can be improved.

According to an aspect of the invention, a display device comprises a base layer, a circuit layer on the base layer and an element layer on the circuit layer and comprising light emitting elements and light receiving elements, wherein the circuit layer comprises pixel driving circuits connected to the light emitting elements, sensor driving circuits connected to the light receiving elements, read-out wirings connected to the sensor driving circuits and a shielding electrode overlapping the read-out wirings and the sensor driving circuits in a plan view, wherein a first pixel driving circuit from among the pixel driving circuits is continuously arranged in a direction parallel to the read-out wirings and connected to a first light emitting element from among the light emitting elements, and wherein the circuit layer further comprises a first pixel connection electrode connecting the first pixel driving circuit to the first light emitting element, and the first pixel connection electrode is located at a layer different from a layer on which the shielding electrode is located.

The first pixel driving circuit may be located at a first side of a first pixel anode electrode of the first light emitting element, and a first read-out wirings adjacent to the first pixel anode electrode from among the read-out wirings may be located at a second side of the first pixel anode electrode, and wherein the first pixel connection electrode is between the first pixel driving circuit and the first read-out wirings and does not cross the first read-out wirings.

The circuit layer may further comprises data lines connected to the pixel driving circuits, wherein the shielding electrode is on a first intermediate insulating layer covering the data lines and wherein the first pixel connection electrode is on a second intermediate insulating layer covering the shielding electrode.

The first light emitting element may comprises a first pixel anode electrode electrically connected to the first pixel driving circuit, and wherein the first pixel anode electrode is on a third intermediate insulating layer covering the first pixel connection electrode.

The light receiving elements may comprise first light receiving elements in a first row and second light receiving elements in a second row, wherein each of the first light receiving elements overlaps a corresponding first sensor driving circuit from among the sensor driving circuits in a plan view, and wherein each of the second light receiving elements does not overlap a corresponding second sensor driving circuit from among the sensor driving circuits in a plan view.

Each of the second light receiving elements may comprise a second sensor anode electrode and a sensor connection electrode extending from the second sensor anode electrode to overlap the second sensor driving circuit and wherein the sensor connection electrode is on the third intermediate insulating layer.

Each of the first light receiving elements may comprise a first sensor anode electrode and a dummy connection electrode extending from the first sensor anode electrode, wherein the first sensor anode electrode overlaps the first sensor driving circuit and is connected to the second sensor driving circuit, and wherein the dummy connection electrode is on the third intermediate insulating layer.

Although some example embodiments have been described above, those skilled in the art or those skilled in the art will understand that the present disclosure may be variously modified and changed without departing from the scope of the present invention as defined by the appended claims.

## Claims

1. A display device comprising:
a base layer (BL);
a circuit layer (DP_CL) on the base layer; and
an element layer (DP_ED) on the circuit layer and comprising light emitting elements (ED) and light receiving elements (OPD),
wherein the circuit layer comprises:
pixel driving circuits (P_PD) connected to the light emitting elements;
sensor driving circuits (O_SD) connected to the light receiving elements; and
read-out wiring (RL) connected to the sensor driving circuits,
wherein a plurality of first pixel driving circuits from among the pixel driving circuits are respectively connected to a plurality of first light emitting elements that are configured to provide light of the same colour from among the light emitting elements, and the plurality of first pixel driving circuits are consecutively arranged in a direction that is parallel to the direction (DR2) in which the read-out wiring is arranged, and
wherein the circuit layer further comprises a plurality of first pixel connection electrodes respectively connecting the first pixel driving circuits to the first light emitting elements, and the first pixel connection electrodes do not cross the read-out wiring in a plan view.

2. The display device of claim 1, wherein each of the first pixel driving circuits is located at a first side of a first pixel anode electrode of a corresponding one of the first light emitting elements, and a first read-out wiring adjacent to the first pixel anode electrode from among the read-out wiring is located at a second side of the first pixel anode electrode, and
wherein a corresponding one of the first pixel connection electrodes is between the first pixel driving circuit and the first read-out wiring.

3. The display device of claim 2, wherein the circuit layer further comprises:
data lines connected to the pixel driving circuits; and
a shielding electrode on the data lines and overlapping the read-out wiring and the sensor driving circuits in a plan view, and
wherein the shielding electrode and the first pixel connection electrodes are at the same layer.

4. The display device of claim 2 or 3, wherein each of the first light emitting elements comprises:
the first pixel anode electrode,
wherein the first pixel anode electrode is connected to the first pixel driving circuit through the first pixel connection electrode, and
wherein the first pixel anode electrode and the first pixel connection electrode are at different layers.

5. The display device of any one of the preceding claims, wherein the light receiving elements comprise:
first light receiving elements in a first row; and
second light receiving elements in a second row,
wherein each of the first light receiving elements overlaps a corresponding first sensor driving circuit from among the sensor driving circuits in a plan view, and
wherein each of the second light receiving elements does not overlap a corresponding second sensor driving circuit from among the sensor driving circuits in a plan view.

6. The display device of claim 5, wherein each of the second light receiving elements comprises:
a second sensor anode electrode; and
a sensor connection electrode extending from the second sensor anode electrode to overlap the second sensor driving circuit, and
wherein the second sensor anode electrode and the sensor connection electrode are at the same layer.

7. The display device of claim 6, wherein the sensor connection electrode overlaps the first pixel connection electrode in a plan view.

8. The display device of claim 7, wherein the circuit layer further comprises:
a second pixel connection electrode connecting a second light emitting element from among the light emitting elements and a second pixel driving circuit from among the pixel driving circuits, and
wherein each of the first and second pixel connection electrodes does not overlap other light emitting elements in a plan view.

9. The display device of claim 6, 7 or 8, wherein each of the first light receiving elements comprises:
a first sensor anode electrode; and
a dummy connection electrode extending from the first sensor anode electrode, and
wherein the first sensor anode electrode overlaps the first sensor driving circuit and is connected to the second sensor driving circuit, optionally wherein
the sum of the area of the dummy connection electrode and the area of the first sensor anode electrode is substantially equal to the sum of the area of the sensor connection electrode and the area of the first sensor anode electrode.

10. The display device of claim 10, wherein
the dummy connection electrode overlaps the first pixel connection electrode in a plan view.

11. The display device of claim 10, wherein the first pixel connection electrode overlaps a second light emitting element from among the light emitting elements in a plan view, optionally wherein the first pixel connection electrode passes through a center point of the second light emitting element.

12. The display device of claim 2, wherein the circuit layer further comprises:
a second pixel connection electrode connecting a second light emitting element from among the light emitting elements and a second pixel driving circuit from among the pixel driving circuits,
wherein the second pixel connection electrode does not overlap the first light emitting element in a plan view, and
wherein the first pixel connection electrode overlaps a third light emitting element of the light emitting elements in a plan view.

13. The display device of claim 12, wherein the first and second pixel connection electrodes do not overlap the light receiving elements in a plan view.

14. The display device of claim 2, wherein the circuit layer comprises:
data lines connected to the pixel driving circuits; and
a shielding electrode overlapping the read-out wirings and the sensor driving circuits in a plan view and located on a first intermediate insulating layer covering the data lines, and
wherein the first pixel connection electrode is on a second intermediate insulating layer covering the shielding electrode.

15. The display device of claim 14, wherein the first light emitting element comprises:
the first pixel anode electrode,
wherein the first pixel anode electrode is connected to the first pixel driving circuit through the first pixel connection electrode, and
wherein the first pixel anode electrode is on a third intermediate insulating layer covering the first pixel connection electrode.
